# EUROPEAN PATENT SPECIFICATION

(11) **EP 3 331 959 B1**
(45) Date of publication and mention of the grant of the patent: **05.10.2022**
(21) Application number: 16835768.9
(22) Date of filing: 08.08.2016
(51) Int. Cl.: C09J 11/06, C09J 163/00, C09J 9/02, C09J 11/04

(54) **ANIONIC CURABLE COMPOSITIONS**
ANIONISCHE HÄRTBARE ZUSAMMENSETZUNGEN
COMPOSITIONS DURCISSABLES ANIONIQUES

(30) Priority: 08.08.2015 US 201562202823 P
(43) Date of publication of application: 13.06.2018
(73) Proprietor: Designer Molecules, Inc., San Diego, CA 92131 (US)
(72) Inventor: MIZORI, Farhad, San Diego, CA 92129 (US)
(74) Representative: Murgitroyd & Company
(86) International application number: PCT/US2016/046079
(87) International publication number: WO 2017/027482

(56) References cited:
- EP-A1- 2 412 743
- JP-A- 2011 012 124
- US-A- 4 806 608
- US-B1- 6 359 039
- US-B2- 7 309 724
- US-B2- 7 309 724
- US-B2- 7 928 245
- US-B2- 8 063 161
- US-B2- 8 063 161

## Description

### FIELD OF INVENTION

The present invention relates to thermosetting adhesive compositions and methods of application. In particular, the present invention relates to novel anionic curable, hydrophobic formulations comprising maleimides in combination with epoxy resins. These formulations are suitable for use in a variety of electronics applications as well as composites.

### BACKGROUND OF INVENTION

Adhesive compositions, particularly conductive adhesives, are used for a variety of purposes in the fabrication and assembly of semiconductor packages and microelectronic devices. Prominent uses of adhesive compositions include bonding of electronic elements, such as integrated circuit chips, to lead frames or other substrates, and bonding of circuit packages or assemblies to printed wire boards.

Adhesives useful for electronic packaging applications typically exhibit properties such as good mechanical strength, curing properties that do not affect the component or the carrier, and thixotropic properties compatible with application to microelectronic and semiconductor components (i.e., typically thixotropic index of 4-6 for die attach pastes).

The curable monomers used in adhesive compositions for electronics packaging must have very desirable properties such as: hydrophobicity (i.e., less than 1% moisture uptake after pressure cooker test); low ionic content; high thermal stability (i.e., less than 1% weight loss at 300 °C, and an onset of decomposition >400 ° C); and good mechanical strength.

Low viscosity liquids (i.e., less than 10,000 cps or less than 1,000 cps for die attach and underfill) are typically desired as a base for adhesive formulations because they afford the ability to add other components and maintain a final formulation that is workable and can be easily applied to surfaces. These formulations can then be used with appropriate fillers as needed, such as particulates, to bring about the type of properties that are required for a specific application. For conductive pastes, fillers such as silver, copper and nickel, and nanoparticles coated with these metals are appropriate. For nonconductive pastes, fillers such as silica, graphite, boron nitride, and TEFLON^{™} (polytetrafluoroethylene or PTFE) and the like may be appropriate.

Often in electronics applications a clear, non-filled conformal coating is the appropriate material to protect or encapsulate an electronic component. In this type of application, the coating must protect delicate wiring that can easily be damaged by shock, and/or circuitry that is susceptible to damage or corrosion.

During certain phases in the assembly of electronics components, such as solder reflow, high temperatures may be encountered. Similarly, during the operation of the electronics component, heat may be generated. Thus, adhesives and coatings are required to have high temperature resistance, to at least the temperatures that may be encountered during assembly and use of electronic components.

The materials that are used as adhesives and coatings in electronics components are also required to be very hydrophobic. Moisture is the biggest enemy of electronics components. Moisture along with ionic impurities that may be found in condensation can cause severe damage to electronics components due to corrosion.

In certain applications, such as underfilling, a material is required that has very high glass transition temperature (T_{g}) (less than 120 °C) along with a very low coefficient of thermal expansion (CTE) (i.e., around 50 ppm or less). In other applications, a softer material is required with a low T_{g} (around room temperature or below). Such soft materials are generally more useful than harder materials as conformal coatings, because they withstand shock and retain flexibility even at very cold temperatures.

Electronics adhesives may also be prepared in the form of thin film. These films forms require a high degree of hydrophobicity, toughness, and strong adhesion to a variety of surfaces. Specific requirements for adhesive films can vary, but in general they must be flexible, have very good chemical resistance, low dielectric constant and low dielectric dissipation factor, and high temperature resistance. There are many applications for these films, including use as adhesive layer in copper clad laminates; heat sink bonding; lid sealing; stress absorption; electromagnetic interference (EMI) and radio-frequency interference (RFI) shielding; and structural bonding.

### Resins for Electronics Adhesives

A wide variety of adhesive polymers, resins and composites have been used in the electronics industry. For example, US 7,309,724, EP 2,412,743 and US 6, 359,039 disclose curable adhesives comprising epoxy resins. However, US 7,309,724 is directed to an adhesive composition comprising bisisomeleimide and neither EP 2,412,743 and US 6, 359,039 disclose the manner in which the bismaleimide was synthesized. Many varieties of maleimide terminated polyimides have been previously invented by Designer Molecules, Inc.. These materials have high temperature stability, are very hydrophobic, and have great chemical resistance; unfortunately, they lack adhesion on some surfaces. In contrast, epoxy resins have tremendous adhesion on a wide variety of substrates, including most metals. Unfortunately, epoxy resins are not very hydrophobic, and they may completely lose adhesion at high temperatures, especially after exposure to humid conditions, such as encountered in standard pressure-cook tests (PCT) for electronics.

There is a continuing need for improved adhesive compositions, particularly those that combine the beneficial properties of maleimide-terminated polyimides and epoxies.

### SUMMARY OF THE INVENTION

The present invention provides curable adhesives composition, comprising: a maleimide component comprising at least one maleimide which is a maleimide terminated polyimide that is the condensation product of contacting a diamine with a dianhydride; an epoxy component comprising at least one epoxy; and at least one anionic curing catalyst, with the proviso that no free-radical initiator is added to formulation. In certain embodiments, the compositions can include at least one filler, at least one reactive diluent, or a combination thereof. In certain embodiments of the invention, the maleimide component is a liquid at ambient temperature.

The maleimide component includes maleimides having the structure: 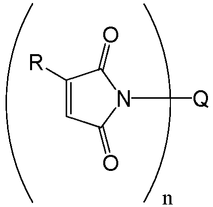 where Q is selected from the group consisting of a substituted or unsubstituted alkyl, cycloalkyl, aryl, polycyclic, heterocyclic, alkenyl, alkylene, oxyalkyl, ester, polyester, amide, polyamide, polyimide, polyether, polyurethane or siloxane; R is selected from the group consisting of H, or methyl, and n is an integer having a value from 1 to about 10.

The maleimide component can include a bismaleimide of unsaturated or unsaturated dimer diamine alone or in combination with other maleimides and/or bismaleimides.

In certain aspects, the maleimide component includes a compound having a structure selected from the group consisting of:

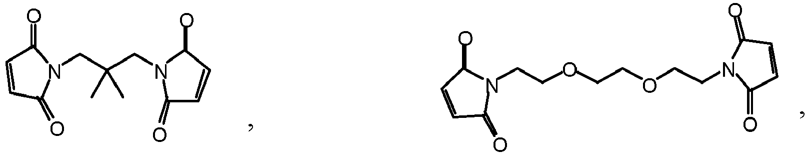

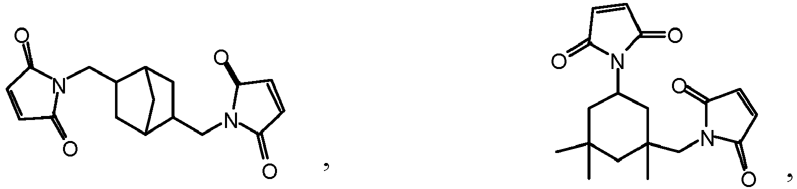

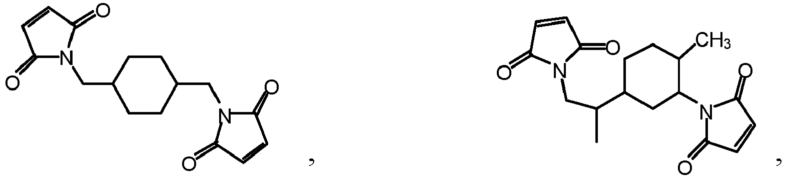

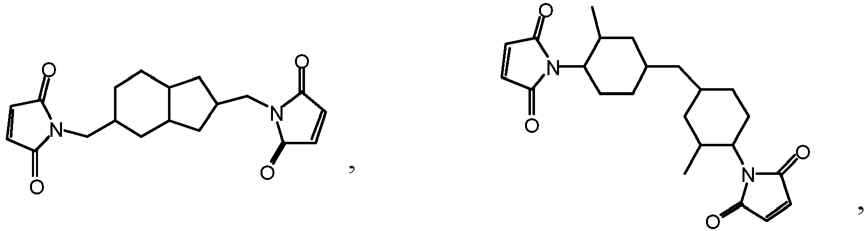

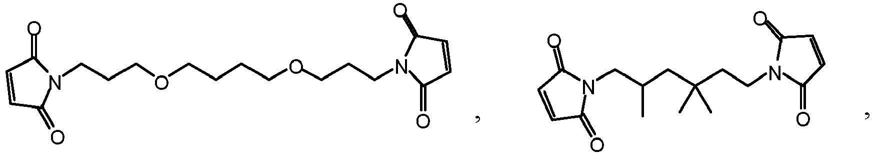

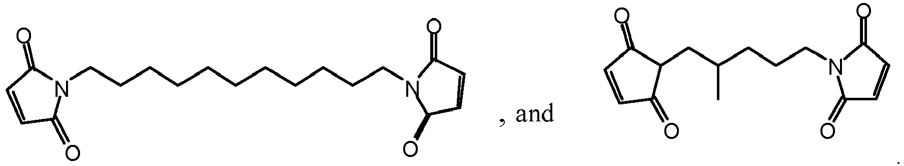

In yet further embodiments, the maleimide component comprises a maleimide terminated polyimide that is the condensation product of contacting a diamine, with a dianhydride, such as compound have the structural formula: 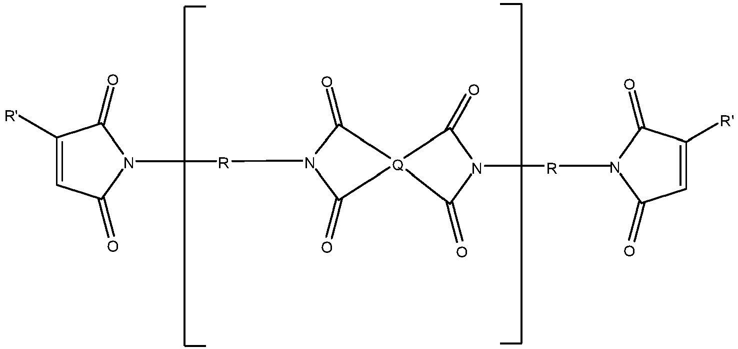 where R' is selected from the group consisting of H or methyl; R and Q are each independently substituted or unsubstituted aliphatic, cycloaliphatic, aromatic, heteroaromatic, polyether, or siloxane moieties, and n is 1 to about 10.

In certain embodiments, R and Q are each independently substituted or unsubstituted aliphatic, cycloaliphatic, polyether, or siloxane. In yet further embodiments, at least one of R and Q is aliphatic, cycloaliphatic.

The maleimide-terminated polyimide can have a structure selected from the group consisting of:

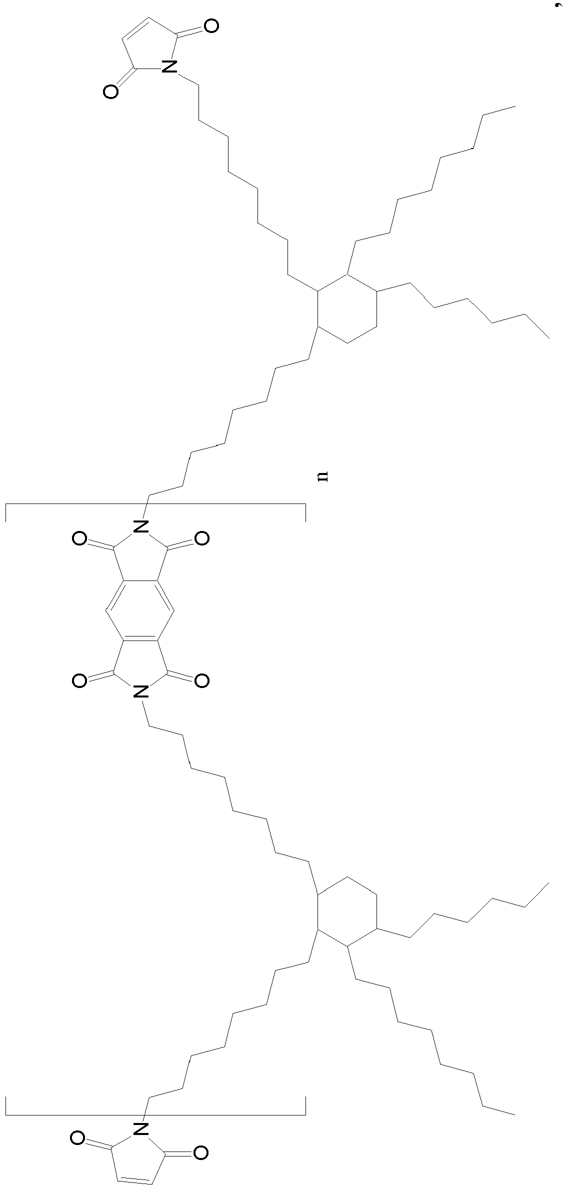

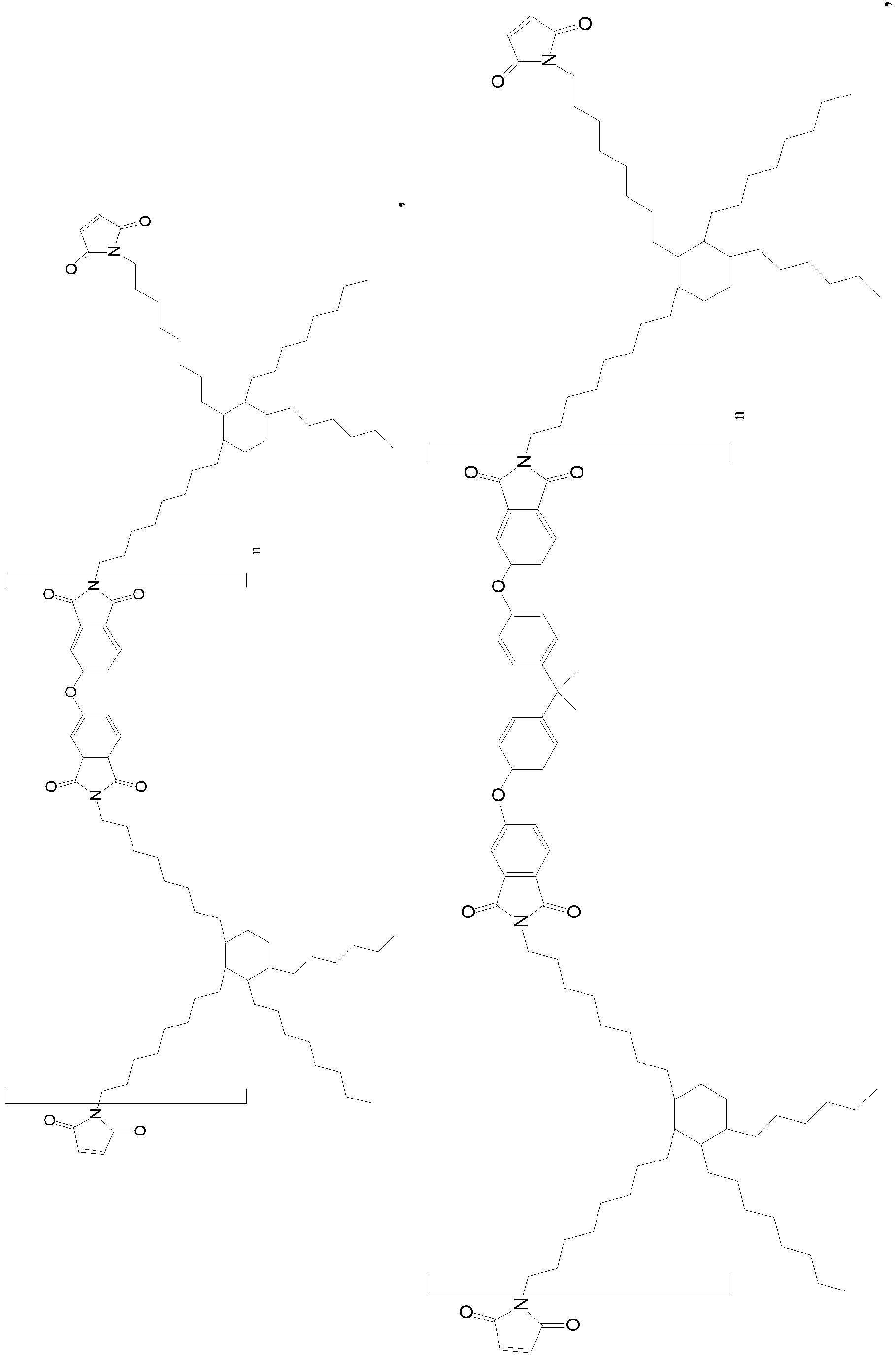

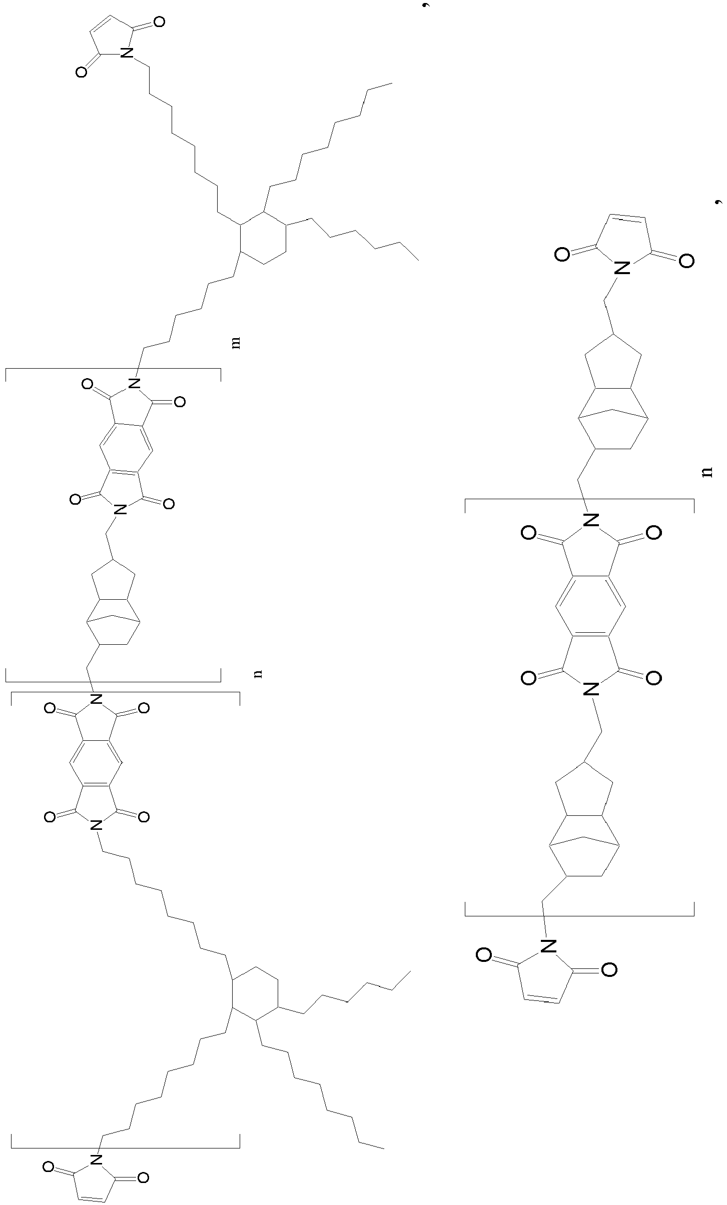

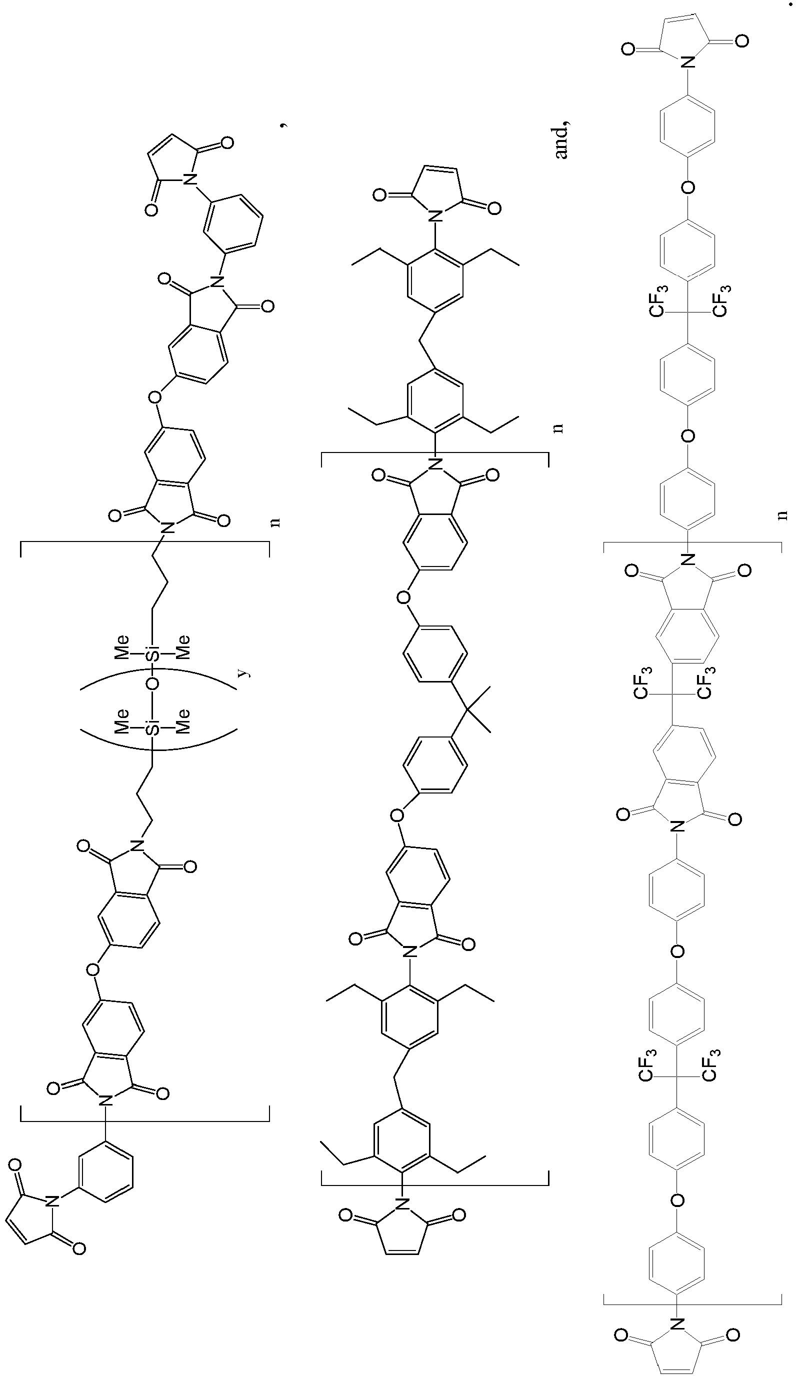

The epoxy component can be selected from the group consisting of a phenyl glycidyl ether; a cresyl glycidyl ether; a nonylphenyl glycidyl ether; a p-tert-butylphenyl glycidyl ether; a diglycidyl or polyglycidyl ether of any of: bisphenol A, bisphenol F, ethylidenebisphenol, dihydroxydiphenyl ether, bis(4-hydroxyphenyl)sulfone, bis(hydroxyphenyl)sulfide, 1,1-bis(hydroxyphenyl)cyclohexane, 9,19-bis(4-hydroxyphenyl)fluorene, 1,1,1-tris(hydroxyphenyl)ethane, tetrakis(4-hydroxyphenyl)ethane, trihydroxytritylmethane, 4,4'-(1-alpha-methylbenzylidene)bisphenol, 4,4'-dihydroxybenzophenone, dihydroxy naphthalene, 2,2'-dihydroxy-6,6'-dinaphthyl disulfide, a 1,8,9-trihydroxyanthracene, resorcinol, catechol and tetrahydroxydiphenyl sulfide; triglycidyl-p-aminophenol; N,N,N',N'-tetraglycidyl-4,4'-diphenylmethane; triglycidyl isocyanurate; a glycidyl ether of a cresol formaldehyde condensate; a glycidyl ether of a phenol formaldehyde condensate; a glycidyl ether of a cresol dicyclopentadiene addition compound; a glycidyl ether of a phenol dicyclopentadiene addition compound; a diglycidyl ether of 1,4 butanediol; a diglycidyl ether of diethylene glycol; a diglycidyl ether of neopentyl glycol; a diglycidyl ether of cyclohexane dimethanol; a diglycidyl ether of tricyclodecane dimethanol; a trimethyolethane triglycidyl ether; a trimethylolpropane triglycidyl ether; a glycidyl ether of a polyglycol; a polyglycidyl ether of castor oil; a polyoxypropylene diglycidyl ether and a glycidyl derivative of an aromatic amine.

In certain aspects, the epoxy component is selected from the group consisting of epoxy-terminated polydimethylsiloxanes, and epoxy functionalized cyclosiloxanes. Typically, the epoxy component comprises about 1 to about 90 weight%, about 5 to about 50 weight%, or about 10 to about 25 weight%, based on the total weight of the resin composition.

The anionic curing catalyst can include one or more compounds selected from the group consisting of: imidazole; 1-benzyl-2-phenylimidazole (1B2PZ); 1-benzyl-2-methylimidazole (1B2MZ); 2-phenyl-4-methylimidazole (2P4MZ); 2-phenylimidazole (2PZ); 2-ethyl-4-methylimidazole (2E4MZ); 1,2-dimethylimidazole (1.2DMZ); 2-heptadecylimidazole (C17Z); 2-undecylimidazole (C11Z); 2-methylimidazole (2MZ); imidazole (SIZ); 1-cyanoethyl-2-methylimidazole (2MZ-CN); 1-cyanoethyl-2-undecylimidazole (C11Z-CN); 1-cyanoethyl-2-ethyl-4-methylimidazole (2E4MZ-CN); 1-cyanoethyl-2-phenylimidazole (2PZ-CN); 1-cyanoethyl-2-phenylimidazolium-trimellitate (2PZCNS-PW); 1-cyanoethyl-2-undecylimidazolium-trimellitate (Cl 1Z-CNS); 2,4-diamino-6-[2'-ethyl-4'-methylimidazolyl-(1')]-ethyl-s-triazine (2E4MZ-A); 2,4-diamino-6-[2'-undecylimidazolyl-(1')]-ethyl-s-triazine (C11Z-A); 2,4-diamino-6-[2'-methylimidazolyl-(1')]-ethyl-s-triazine (2MZA-PW); 2,4-diamino-6-[2'-methylimidazolyl-(1')]-ethyl-s-triazine (2MZ-A); 2-phenylimidazoleisocyanuric acid adduct (2PZ-OK); 2,4-diamino-6-[2'-methylimidazolyl-(1')]-ethyl-s-triazineisocyanuric acid adduct dehydrate (2MA-OK); 2-phenyl-4-methyl-5-hydroxymethylimidazole (2P4MHZ-PW); 2-phenyl-4,5-dihydroxymethylimidazole (2PHZ-PW); 1-dodecyl-2-methyl-3-benzylimidazolium chloride (SFZ); 2,3-dihydro-1H-pyrrolo[1,2-a]benzimidazole (TBZ); 2-phenylimidazoline (2PZL-T); 2,4-diamino-6-methacryloyloxyethyl-1,3,5-triazine (MAVT); 2,4-diamino-6-vinyl-1,3,5-triazineisocyanuric acid adduct (OK); 2,4-diamino-6-vinyl-1,3,5-triazine (VT); Imidazole-4-carboxaldehyde (4FZ); 2-Phenylimidazole-4-carboxaldehyde (2P4FZ); Imidazole-2 carboxaldehyde (2FZ); Imidazole-4-carbonitrile (4CNZ); 2-Phenylimidazole-4-carbonitrile (2P4CNZ); 4-Hydroxymethylimidazolehydrochloride (4HZ-HCL); 2-Hydroxymethylimidazolehydrochloride (2HZ-HCL); Imidazole-4-carboxylic acid (4GZ); Imidazole-4-dithiocarboxylic acid (4SZ); Imidazole-4-thiocarboxamide (4TZ); 2-Bromoimidazole (2BZ); 2-Mercaptoimidazole (2SHZ); 1,2,4-Triazole-1-carboxamidinehydrochloride (TZA); (t-Butoxycarbonylimino-[1,2,4]triazol-1-yl-Methyl)-carbamic acid t-butyl ester (TZA-BOC); Thiazole-2-carboxaldehyde (2FTZ); Thiazole-4-carboxaldehyde (4FTZ); Thiazole-5-carboxaldehyde (5FTZ); Oxazole-2-carboxaldehyde (2FOZ); Oxazole-4-carboxaldehyde (4FOZ); Oxazole-5-carboxaldehyde (5FOZ); Pyrazole-4-carboxaldehyde (4FPZ); Pyrazole-3-carboxaldehyde (3FPZ); 1-azabicyclo[2.2.2]octane (ABCO); 1,4-diazabicyclo[2.2.2]octane (DABCO); 1,5-diazabicyclo[4.3.0]non-5-ene (DBN); 1,8-diazabicyclo[5.4.0]undec-7-ene (DBU); 1,5,7-triazabicyclo[4.4.0]dec-5-ene(TBD); 7-methyl-1,5,7-triazabicyclo[4.4.0]dec-5-ene (MTBD); 1,2,2,6,6-pentamethylpiperidine (PMP); and 4-(dimethylamino)-1,2,2,6,6-pentamethylpiperidine.

Typically, the anionic curing catalyst component comprises about 0.1 to about 10 weight% or 0.5 to about 5 weight% based on the total weight of the resin composition.

The reactive diluent, when present can be selected from the group consisting of acrylates, methacrylate, styrenics, isopropenylbenzene derivatives, acrylamides, methacrylamides, maleates, cinnamates, vinyl pyridine; aldehydes; episulfides, cyclosiloxanes, oxetanes, lactones, acrylonitrile, cyanoacrylates, vinyl ketones, acrolein, vinyl sulfones, vinyl sulfoxides, vinyl silanes, glycidol, isocyanates and combinations thereof.

The reactive diluent can comprises about 0 to 30 weight% based on the total weight of the resin composition.

The filler, when present can be, for example silica, perfluorocarbons, mica, carbon, silver, silver alloys, copper alloys, metal alloys, boron nitride, polyhedral oligomeric silsesquioxanes, calcium carbonate or a combination thereof.

The filler can comprises about 0 to 90 weight% based on the total weight of the composition.

In certain embodiments, the adhesive composition is a die-attach paste suitable for bonding a silicon die to a lead frame, such as a composition in which a cured aliquot of the composition can have, for example, a shear strength of at least about 5.2 Kg-force at 260°C.

In other embodiments, the adhesive composition is an adhesive suitable for bonding copper foil together to form a low dielectric flexible copper clad laminate, in such as a composition in which a cured aliquot of the composition has, for example, a dielectric constant below about 3.9, a T_{g} of at least about 150°C, and a CTE less than about 60 ppm/°C. In this embodiment, the adhesive composition is an electrically insulating adhesive comprising an insulating filler such as polysiloxanes, fumed silica, fumed alumina, fumed titanium dioxide, calcium carbonate, poly perfluorocarbons, silica, graphite, boron nitride, polytetrafluoroethylene and mixtures thereof

In other embodiments, the adhesive composition is underfill suitable for use in preparing a flip chip where a cured aliquot of the composition has a T_{g} of at least about 120 and a CTE of at least about 60 ppm below the T_{g}.

In yet further embodiments, the adhesive composition is a flexible conformal coating suitable for protecting microelectronics assemblies, where a cured aliquot of the composition has a T_{g} below about 50°C or is an adhesive suitable for joining metal parts together, where the composition comprises about 10% to about 20% weight of the epoxy component.

Also provided by the invention are compositions comprising an anionically cured aliquot of an adhesive composition disclosed herein.

The present invention also provides methods for increasing the adhesion of a maleimide-containing composition comprising the steps of adding an epoxy to the maleimide-containing composition defined in claim 1; replacing any free-radical initiators in the composition with at least one anionic cure catalyst, thereby increasing the adhesion of a maleimide-containing composition comprising.

In yet further embodiments, the invention provides an electrically conductive die attach adhesive composition, comprising: (a) a bismaleimide component comprising at least one bismaleimide defined in claim 1; (b) at least one epoxy resin; (c) at least one anionic curing catalyst; (d) at least one acrylic reactive diluent; (e) a silver filler; and (f) at least one silane coupling agent.

In certain aspects, the bismaleimide component can be, for example, the bismaleimide of saturated dimer diamine or unsaturated dimer diamine. In other aspects, the epoxy resin component can be, for example, N,N-diglycidyl-4-glycidyloxyaniline. In yet further aspects, the anionic curing catalyst can be, for example, 2-phenylimidazole. In still other aspects of the invention, the acrylic reactive diluent can be tricyclodecane dimethanol diacrylate, and the silver filler component can be about 85 percent by weight based on the total weight of the composition. In additional aspects, the silane coupling agent is selected from the group consisting of aminopropyltrimethoxysilane, acryloxypropyltrimethoxysilane, methacryloxypropyltrimethoxysilane, glycidoxypropyltrimethoxysilane, (3,4-epoxycyclohexyl)ethyltrimethoxysilane, and N-phenylaminopropyltrimethoxysilane.

### BRIEF DECRIPTION OF THE DRAWINGS

**FIG. 1** is a dynamic TGA trace (10°C/min) of a sample of 90 wt% BMI-689 resin and 10 wt% EPON^{™}-863 epoxy resin, cured with 4-wt% 1-benzyl-2-methylimidazole for one hour at 180 °C.
**FIG. 2** shows a DSC analysis trace (10°C/min) and cure profile for a solution of BMI-689 with 4-wt% 1-benzyl-2-methylimidazole.
**FIG. 3** shows a DSC analysis trace (10°C/min) and cure profile for a solution of 4 equivalents of BMI-689 and 1 equivalents of EPON^{™}-863 epoxy resin with 4-wt% 1-benzyl-2-methylimidazole.
**FIG. 4** shows a DSC analysis trace (10°C/min) and cure profile for a solution of 3 equivalents of BMI-689 and 1 equivalents of EPON-863 epoxy resin with 4-wt% 1-benzyl-2-methylimidazole.
**FIG. 5** shows a DSC analysis trace (10°C/min) and cure profile for a solution of 2 equivalents of BMI-689 and 1 equivalents of EPON^{™}-863 epoxy resin with 4-wt% 1-benzyl-2-methylimidazole.
**FIG. 6** shows a DSC analysis trace (10°C/min) and cure profile for a solution of 1 equivalents of BMI-689 and 1 equivalents of EPON^{™} -863 epoxy resin with 4-wt% 1-benzyl-2-methylimidazole.
**FIG. 7** shows a DSC analysis trace (10°C/min) and cure profile for a solution of 1 equivalents of BMI-689 and 2 equivalents of EPON^{™} -863 epoxy resin with 4-wt% 1-benzyl-2-methylimidazole.
**FIG. 8** shows a DSC analysis trace (10°C/min) and cure profile for a solution of 1 equivalents of BMI-689 and 3 equivalents of EPON^{™} -863 epoxy resin with 4-wt% 1-benzyl-2-methylimidazole.
**FIG. 9** shows a DSC analysis trace (10°C/min) and cure profile for a solution EPON^{™} -863 epoxy resin with 4-wt% 1-benzyl-2-methylimidazole.

### DETAILED DESCRIPTION

It is to be understood that both the foregoing general description and the following detailed description are exemplary and explanatory only and are not restrictive of the invention claimed. As used herein, the use of the singular includes the plural unless specifically stated otherwise. As used herein, "or" means "and/or" unless stated otherwise. Furthermore, use of the term "including" as well as other forms, such as "includes," and "included," is not limiting.

The section headings used herein are for organizational purposes only and are not to be construed as limiting the subject matter described.

Unless specific definitions are provided, the nomenclatures utilized in connection with, and the laboratory procedures and techniques of analytical chemistry, synthetic organic and inorganic chemistry described herein are those known in the art, such as those set forth in "IUPAC Compendium of Chemical Terminology: IUPAC Recommendations (The Gold Book)" (McNaught ed.; International Union of Pure and Applied Chemistry, 2nd Ed., 1997) and "Compendium of Polymer Terminology and Nomenclature: IUPAC Recommendations 2008" (Jones et al., eds; International Union of Pure and Applied Chemistry, 2009). Standard chemical symbols are used interchangeably with the full names represented by such symbols. Thus, for example, the terms "hydrogen" and "H" are understood to have identical meaning. Standard techniques may be used for chemical syntheses, chemical analyses, and formulation.

### Definitions

**"About"** as used herein means that a number referred to as "about" comprises the recited number plus or minus 1-10% of that recited number. For example, "about" 100 degrees can mean 95-105 degrees or as few as 99-101 degrees depending on the situation. Whenever it appears herein, a numerical range such as "1 to 20" refers to each integer in the given range; e.g., "1 to 20 carbon atoms" means that an alkyl group can contain only 1 carbon atom, 2 carbon atoms, 3 carbon atoms, etc., up to and including 20 carbon atoms (although the term "alkyl" also includes instances where no numerical range of carbon atoms is designated). Where a range described herein includes decimal values, such as "1.2% to 10.5%", the range refers to each decimal value of the smallest increment indicated in the given range; *e.g.* "1.2% to 10.5%" means that the percentage can be 1.2%, 1.3%, 1.4%, 1.5%, etc. up to and including 10.5%; while "1.20% to 10.50%" means that the percentage can be 1.20%, 1.21%, 1.22%, 1.23%, etc. up to and including 10.50%.

As used herein, the term **"substantially"** refers to a great extent or degree. For example, **"substantially all"** typically refers to at least about 90%, frequently at least about 95%, often at least 99%, and more often at least about 99.9%.

**"Adhesive"** or **"adhesive compound"** as used herein, refers to any substance that can adhere or bond two items together. Implicit in the definition of an **"adhesive composition"** or **"adhesive formulation"** is the fact that the composition or formulation is a combination or mixture of more than one species, component or compound, which can include adhesive monomers, oligomers, and/or polymers along with other materials, whereas an **"adhesive compound"** refers to a single species, such as an adhesive polymer or oligomer.

More specifically, adhesive composition refers to un-cured mixtures in which the individual components in the mixture retain the chemical and physical characteristics of the original individual components of which the mixture is made. Adhesive compositions are typically malleable and may be liquids, paste, gel or another form that can be applied to an item so that it can be bonded to another item.

**"Composite"** as used herein, refers to an adhesive or other material made from two or more different constituent materials, often with significantly different physical or chemical properties.

**"Cured adhesive", "cured adhesive composition"** or **"cured adhesive compound"** refers to adhesives components and mixtures obtained from reactive curable original compound(s) or mixture(s) thereof, which have undergone chemical and/or physical changes such that the original compound(s) or mixture(s) is (are) transformed into a solid, substantially non-flowing material. A typical curing process may involve crosslinking.

**"Curable"** means that an original compound(s) or composition material(s) can be transformed into a solid, substantially non-flowing material by means of chemical reaction, crosslinking, radiation crosslinking, or the like. Thus, adhesive compositions of the invention are curable, but unless otherwise specified, the original compound(s) or composition material(s) is (are) not cured.

**"Thermoplastic,"** as used herein, refers to the ability of a compound, composition or other material (e.g. a plastic) to dissolve in a suitable solvent or to melt to a liquid when heated and freeze to a solid, often brittle and glassy, state when cooled sufficiently.

**"Thermoset,"** as used herein, refers to the ability of a compound, composition or other material to irreversibly "cure" resulting in a single three-dimensional network that has greater strength and less solubility compared to the non-cured product. Thermoset materials are typically polymers that may be cured, for example, through heat (e.g. above 200° Celsius), via a chemical reaction (e.g. epoxy ring-opening, free-radical polymerization, etc or through irradiation (e.g. visible light, UV light, electron beam radiation, ion-beam radiation, or X-ray irradiation).

Thermoset materials, such as thermoset polymers or resins, are typically liquid or malleable forms prior to curing, and therefore may be molded or shaped into their final form, and/or used as adhesives. Curing transforms the thermoset resin into a rigid infusible and insoluble solid or rubber by a cross-linking process. Thus, energy and/or catalysts are typically added that cause the molecular chains to react at chemically active sites (unsaturated or epoxy sites, for example), linking the polymer chains into a rigid, 3-D structure. The cross-linking process forms molecules with a higher molecular weight and resultant higher melting point. During the reaction, when the molecular weight of the polymer has increased to a point such that the melting point is higher than the surrounding ambient temperature, the polymer becomes a solid material.

**"Cross-linking,"** as used herein, refers to the attachment of two or more oligomer or longer polymer chains by bridges of an element, a molecular group, a compound, or another oligomer or polymer. Crosslinking may take place upon heating or exposure to light; some crosslinking processes may also occur at room temperature or a lower temperature. As cross-linking density is increased, the properties of a material can be changed from thermoplastic to thermosetting.

A **"die"** or **"semiconductor die"** as used herein, refers to a small block of semiconducting material, on which a functional circuit is fabricated.

A **"flip-chip"** semiconductor device is one in which a semiconductor die is directly mounted to a wiring substrate, such as a ceramic or an organic printed circuit board. Conductive terminals on the semiconductor die, usually in the form of solder bumps, are directly physically and electrically connected to the wiring pattern on the substrate without use of wire bonds, tape-automated bonding (TAB), or the like. Because the conductive solder bumps making connections to the substrate are on the active surface of the die or chip, the die is mounted in a face-down manner, thus the name "flip-chip."

**"Underfill," "underfill composition"** and **"underfill material"** are used interchangeably to refer to a material, typically polymeric compositions, used to fill gaps between a semiconductor component, such as a semiconductor die, and a substrate. **"Underfilling"** refers to the process of applying an underfill composition to a semiconductor component-substrate interface, thereby filling the gaps between the component and the substrate.

The term **"monomer"** refers to a molecule that can undergo polymerization or copolymerization thereby contributing constitutional units to the essential structure of a macromolecule (a polymer).

The term **"pre-polymer"** refers to a monomer or combination of monomers that have been reacted to a molecular mass state intermediate between that of the monomer and higher molecular weight polymers. Pre-polymers are capable of further polymerization via reactive groups they contain, to a fully cured high molecular weight state. Mixtures of reactive polymers with un-reacted monomers may also be referred to a **"resin",** as used herein, refers to a substance containing pre-polymers, typically with reactive groups. In general, resins are pre-polymers of a single type or class, such as epoxy resins and bismaleimide resins.

**"Polymer"** and **"polymer compound"** are used interchangeably herein, to refer generally to the combined the products of a single chemical polymerization reaction. Polymers are produced by combining monomer subunits into a covalently bonded chain. Polymers that contain only a single type of monomer are known as **"homopolymers,"** while polymers containing a mixture of monomers are known as **"copolymers."**

The term **"copolymers"** is inclusive of products that are obtained by copolymerization of two monomer species, those obtained from three monomers species (terpolymers), those obtained from four monomers species (quaterpolymers), etc. It is well known in the art that copolymers synthesized by chemical methods include, but are not limited to, molecules with the following types of monomer arrangements:

Furthermore, the length of a polymer chain according to the present invention will typically vary over a range or average size produced by a particular reaction. The skilled artisan will be aware, for example, of methods for controlling the average length of a polymer chain produced in a given reaction and also of methods for size-selecting polymers after they have been synthesized.

Unless a more restrictive term is used, polymer is intended to encompass homopolymers, and copolymers having any arrangement of monomer subunits as well as copolymers containing individual molecules having more than one arrangement. With respect to length, unless otherwise indicated, any length limitations recited for the polymers described herein are to be considered averages of the lengths of the individual molecules in polymer.

**"Thermoplastic elastomer"** or **"TPE",** as used herein refers to a class of copolymers that consist of materials with both thermoplastic and elastomeric properties.

**"Hard blocks"** or **"hard segments"** as used herein refer to a block of a copolymer (typically a thermoplastic elastomer) that is hard at room temperature by virtue of a high melting point (Tₘ) or T_{g}. By contrast, **"soft blocks"** or **"soft segments"** have a T_{g} below room temperature.

As used herein, **"oligomer"** or **"oligomeric"** refers to a polymer having a finite and moderate number of repeating monomers structural units. Oligomers of the invention typically have 2 to about 100 repeating monomer units; frequently 2 to about 30 repeating monomer units; and often 2 to about 10repeating monomer units; and usually have a molecular weight up to about 3,000.

As used herein, **"aliphatic"** refers to any alkyl, alkenyl, cycloalkyl, or cycloalkenyl moiety.

**"Aromatic hydrocarbon"** or **"aromatic"** as used herein, refers to compounds having one or more benzene rings.

**"Alkane,"** as used herein, refers to saturated straight-chain, branched or cyclic hydrocarbons having only single bonds. Alkanes have general formula CₙH₂ₙ₊₂.

**"Cycloalkane,"** refers to an alkane having one or more rings in its structure.

As used herein, **"alkyl"** refers to straight or branched chain hydrocarbyl groups having from 1 up to about 500 carbon atoms. **"Lower alkyl"** refers generally to alkyl groups having 1 to 6 carbon atoms. The terms "alkyl" and "substituted alkyl" include, respectively, substituted and unsubstituted C₁-C₅₀₀ straight chain saturated aliphatic hydrocarbon groups, substituted and unsubstituted C₂-C₂₀₀ straight chain unsaturated aliphatic hydrocarbon groups, substituted and unsubstituted C₄-C₁₀₀ branched saturated aliphatic hydrocarbon groups, substituted and unsubstituted C₁-C₅₀₀ branched unsaturated aliphatic hydrocarbon groups.

For example, the definition of "alkyl" includes but is not limited to: methyl (Me), ethyl (Et), propyl (Pr), butyl (Bu), pentyl, hexyl, heptyl, octyl, nonyl, decyl, undecyl, ethenyl, propenyl, butenyl, penentyl, hexenyl, heptenyl, octenyl, nonenyl, decenyl, undecenyl, isopropyl (i-Pr), isobutyl (i-Bu), *tert-*butyl (t-Bu), *sec*-butyl (s-Bu), isopentyl, neopentyl, cyclopropyl, cyclobutyl, cyclopentyl, cyclohexyl, cycloheptyl, cyclooctyl, cyclopentenyl, cyclohexenyl, cycloheptenyl, cyclooctenyl, methylcyclopropyl, ethylcyclohexenyl, butenylcyclopentyl, tricyclodecyl, adamantyl, norbornyl and the like.

**"Substituted alkyl"** refers to alkyl moieties bearing substituents that include but are not limited to alkyl, alkenyl, alkynyl, hydroxy, oxo, alkoxy, mercapto, cycloalkyl, substituted cycloalkyl, heterocyclic, substituted heterocyclic, aryl, substituted aryl (e.g., arylC₁₋₁₀alkyl or arylC₁₋₁₀alkyloxy), heteroaryl, substituted heteroaryl (e.g., heteroarylC₁₋₁₀alkyl), aryloxy, substituted aryloxy, halogen, haloalkyl (e.g. trihalomethyl), cyano, nitro, nitrone, amino, amido, carbamoyl, =O, =CH-, -C(O)H, -C(O)O-, -C(O)-, -S-, -S(O)₂, -OC(O)-O-, -NR-C(O), -NR-C(O)-NR, -OC(O)-NR where R is H or lower alkyl, acyl, oxyacyl, carboxyl, carbamate, sulfonyl, sulfonamide, sulfuryl, C₁₋₁₀ alkylthio, arylC₁₋₁₀ alkylthio, C₁₋₁₀ alkylamino, arylC₁₋₁₀alkylamino, N-aryl-N-C₁₋₁₀alkylamino, C₁₋₁₀alkyl carbonyl, arylC₁₋₁₀ alkylcarbonyl, C₁₋₁₀alkylcarboxy, aryl C₁₋₁₀ alkylcarboxy, C₁₋₁₀alkyl carbonylamino, aryl C₁₋₁₀ alkylcarbonylamino, tetrahydrofuryl, morpholinyl, piperazinyl, and hydroxypyronyl.

In addition, as used herein "**C₃₆**" refers to all possible structural isomers of a 36 carbon aliphatic moiety, including branched isomers and cyclic isomers with up to three carbon-carbon double bonds in the backbone. One non-limiting example of a moiety that the definition of "**C₃₆**" refers to is the moiety comprising a cyclohexane-based core and four long "arms" attached to the core, as demonstrated by the following structure:

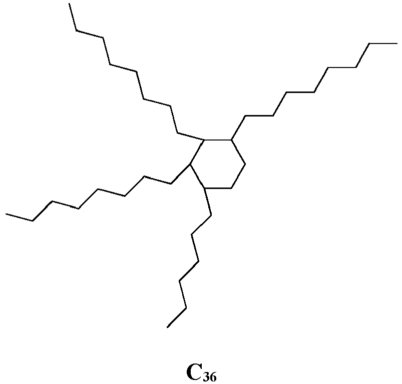

As used herein, **"cycloalkyl"** refers to cyclic ring-containing groups containing in the range of about 3 up to about 20 carbon atoms, typically 3 to about 15 carbon atoms. In certain embodiments, cycloalkyl groups have in the range of about 4 up to about 12 carbon atoms, and in yet further embodiments, cycloalkyl groups have in the range of about 5 up to about 8 carbon atoms. and **"substituted cycloalkyl"** refers to cycloalkyl groups further bearing one or more substituents as set forth below.

As used herein, the term **"aryl"** represents an unsubstituted, mono-, di- or trisubstituted monocyclic, polycyclic, biaryl aromatic groups covalently attached at any ring position capable of forming a stable covalent bond, certain preferred points of attachment being apparent to those skilled in the art (e.g., 3-phenyl, 4-naphtyl and the like). The aryl substituents are independently selected from the group consisting of halo, -OH, -SH, -CN, -NO₂, trihalomethyl, hydroxypyronyl, C₁₋₁₀alkyl, arylC₁₋₁₀alkyl, C₁₋₁₀alkyloxyC₁₋₁₀alkyl, arylC₁₋₁₀alkyloxyC₁₋₁₀alkyl, C₁₋₁₀alkylthioC₁₋₁₀alkyl, arylC₁₋₁₀alkylthioC₁₋₁₀alkyl, C₁₋₁₀alkylaminoC₁₋₁₀alkyl, arylC₁₋₁₀alkylaminoC₁₋₁₀alkyl, N-aryl-N-C₁₋₁₀alkylaminoC₁₋₁₀alkyl, C₁₋₁₀alkylcarbonylC₁₋₁₀alkyl, aryl C₁₋₁₀alkylcarbonyl C₁₋₁₀alkyl, C₁₋₁₀alkylcarboxyC₁₋₁₀alkyl, arylC₁₋₁₀alkylcarboxyC₁₋₁₀alkyl, C₁₋₁₀alkylcarbonylaminoC₁₋₁₀alkyl, and arylC₁₋₁₀alkylcarbonylaminoC₁₋₁₀alkyl.

Some specific examples of moieties encompassed by the definition of "aryl" include but are not limited to phenyl, biphenyl, naphthyl, dihydronaphthyl, tetrahydronaphthyl, indenyl, indanyl, azulenyl, anthryl, phenanthryl, fluorenyl, pyrenyl and the like. **"Substituted aryl"** refers to aryl groups further bearing one or more substituents as set forth below.

As used herein, **"arylene"** refers to a divalent aryl moiety. **"Substituted arylene"** refers to arylene moieties bearing one or more substituents as set forth above.

As used herein, **"alkylaryl"** refers to alkyl-substituted aryl groups and **"substituted alkylaryl"** refers to alkylaryl groups further bearing one or more substituents as set forth below.

As used herein, **"arylalkyl"** refers to aryl-substituted alkyl groups and **"substituted arylalkyl"** refers to arylalkyl groups further bearing one or more substituents as set forth below. Some examples of included but are not limited to (4-hydroxyphenyl)ethyl, or (2-aminonaphthyl) hexenyl.

As used herein, **"arylalkenyl"** refers to aryl-substituted alkenyl groups and **"substituted arylalkenyl"** refers to arylalkenyl groups further bearing one or more substituents as set forth below.

As used herein, **"arylalkynyl"** refers to aryl-substituted alkynyl groups and **"substituted arylalkynyl"** refers to arylalkynyl groups further bearing one or more substituents as set forth below.

As used herein, **"aroyl"** refers to aryl-carbonyl species such as benzoyl and "substituted aroyl" refers to aroyl groups further bearing one or more substituents as set forth below.

As used herein, **"hetero"** refers to groups or moieties containing one or more heteroatoms such as N, O, Si and S. Thus, for example **"heterocyclic"** refers to cyclic (i.e., ring-containing) groups having e.g. N, O, Si or S as part of the ring structure, and having in the range of 3 up to 14 carbon atoms. **"Heteroaryl"** and **"heteroalkyl"** moieties are aryl and alkyl groups, respectively, containing e.g. N, O, Si or S as part of their structure. The terms "heteroaryl", "heterocycle" or "heterocyclic" refer to a monovalent unsaturated group having a single ring or multiple condensed rings, from 1 to 8 carbon atoms and from 1 to 4 hetero atoms selected from nitrogen, sulfur or oxygen within the ring.

The definition of heteroaryl includes but is not limited to thienyl, benzothienyl, isobenzothienyl, 2,3-dihydrobenzothienyl, furyl, pyranyl, benzofuranyl, isobenzofuranyl, 2,3-dihydrobenzofuranyl, pyrrolyl, pyrrolyl-2,5-dione, 3-pyrrolinyl, indolyl, isoindolyl, 3H-indolyl, indolinyl, indolizinyl, indazolyl, phthalimidyl (or isoindoly-1,3-dione), imidazolyl, 2H-imidazolinyl, benzimidazolyl, pyridyl, pyrazinyl, pyradazinyl, pyrimidinyl, triazinyl, quinolyl, isoquinolyl, 4H-quinolizinyl, cinnolinyl, phthalazinyl, quinazolinyl, quinoxalinyl, 1,8-naphthyridinyl, pteridinyl, carbazolyl, acridinyl, phenazinyl, phenothiazinyl, phenoxazinyl, chromanyl, benzodioxolyl, piperonyl, purinyl, pyrazolyl, triazolyl, tetrazolyl, thiazolyl, isothiazolyl, benzthiazolyl, oxazolyl, isoxazolyl, benzoxazolyl, oxadiazolyl, thiadiazolyl, pyrrolidinyl-2,5-dione, imidazolidinyl-2,4-dione, 2-thioxo-imidazolidinyl-4-one, imidazolidinyl-2,4-dithione, thiazolidinyl-2,4-dione, 4-thioxo-thiazolidinyl-2-one, piperazinyl-2,5-dione, tetrahydro-pyridazinyl-3,6-dione, 1,2-dihydro-[1,2,4,5]tetrazinyl-3,6-dione, [1,2,4,5]tetrazinanyl-3,6-dione, dihydro-pyrimidinyl-2,4-dione, pyrimidinyl-2,4,6-trione, 1H-pyrimidinyl-2,4-dione, 5-iodo-1H-pyrimidinyl-2,4-dione, 5-chloro-1H-pyrimidinyl-2,4-dione, 5-methyl-1H-pyrimidinyl-2,4-dione, 5-isopropyl-1H-pyrimidinyl-2,4-dione, 5-propynyl-1H-pyrimidinyl-2,4-dione, 5-trifluoromethyl-1H-pyrimidinyl-2,4-dione, 6-amino-9H-purinyl, 2-amino-9H-purinyl, 4-amino-1H-pyrimidinyl-2-one, 4-amino-5-fluoro-1H-pyrimidinyl-2-one, 4-amino-5-methyl-1H-pyrimidinyl-2-one, 2-amino-1,9-dihydro-purinyl-6-one, 1,9-dihydro-purinyl-6-one, 1H-[1,2,4]triazolyl-3-carboxylic acid amide, 2,6-diamino-N.sub.6-cyclopropyl-9H-purinyl, 2-amino-6-(4-methoxyphenylsulfanyl)-9H-purinyl, 5,6-dichloro-1H-benzoimidazolyl, 2-isopropylamino-5,6-dichloro-1H-benzoimidazolyl, 2-bromo-5,6-dichloro-1H-benzoimidazolyl, and the like. Furthermore, the term "saturated heterocyclic" represents an unsubstituted, mono-, di- or trisubstituted monocyclic, polycyclic saturated heterocyclic group covalently attached at any ring position capable of forming a stable covalent bond, certain preferred points of attachment being apparent to those skilled in the art (e.g., 1-piperidinyl, 4-piperazinyl and the like).

Hetero-containing groups may also be substituted. For example, "substituted heterocyclic" refers to a ring-containing group having in the range of 3 up to 14 carbon atoms that contains one or more heteroatoms and also bears one or more substituents, as set forth above. Examples of substituents include, but are not limited to halo, -OH, -SH, -CN, -NO₂, trihalomethyl, hydroxypyronyl, C₁₋₁₀alkyl, arylC₁₋₁₀alkyl, C₁₋₁₀alkyloxyC₁₋₁₀alkyl, arylC₁₋₁₀alkyloxy C₁₋₁₀alkyl, C₁₋₁₀alkylthioC₁₋₁₀alkyl, arylC₁₋₁₀alkylthioC₁₋₁₀alkyl, C₁₋₁₀alkylaminoC₁₋₁₀alkyl, arylC₁₋₁₀alkylamino C₁₋₁₀alkyl, N-aryl-N- C₁₋₁₀alkylaminoC₁₋₁₀alkyl, C₁₋₁₀alkylcarbonylC₁₋₁₀alkyl, arylC₁₋₁₀alkylcarbonyl C₁₋₁₀alkyl, C₁₋₁₀alkylcarboxyC₁₋₁₀alkyl, arylC₁₋₁₀alkylcarboxyC₁₋₁₀alkyl C₁₋₁₀alkylcarbonylaminoC₁₋₁₀alkyl, and arylC₁₋₁₀alkylcarbonylamino C₁₋₁₀alkyl.

As used herein, the term **"phenol"** includes compounds having one or more phenolic functions per molecule. The terms aliphatic, cycloaliphatic and aromatic, when used to describe phenols, refers to phenols to which aliphatic, cycloaliphatic and aromatic residues or combinations of these backbones are attached by direct bonding or ring fusion.

As used herein, **"alkenyl," "alkene"** or **"olefin"** refers to straight or branched chain unsaturated hydrocarbyl groups having at least one carbon-carbon double bond, and having in the range of about 2 up to 500 carbon atoms. In certain embodiments, **alkenyl** groups have in the range of about 5 up to about 250 carbon atoms, 5 up to about 100 carbon atoms, 5 up to about 50 carbon atoms or 5 up to about 25 carbon atoms. In other embodiments, **alkenyl** groups have in the range of about 6 up to about 500 carbon atoms, 8 up to about 500 carbon atoms, 10 up to about 500 carbon atoms or 20 up to about 500 carbon atoms or 50 up to about 500 carbon atoms. In yet further embodiments, alkenyl groups have in the range of about 6 up to about 100 carbon atoms, 10 up to about 100 carbon atoms, 20 up to about 100 carbon atoms or 50 up to about 100 carbon atoms, while in other embodiments, alkenyl groups have in the range of about 6 up to about 50 carbon atoms, 6 up to about 25 carbon atoms, 10 up to about 50 carbon atoms, or 10 up to about 25 carbon atoms. **"Substituted alkenyl"** refers to alkenyl groups further bearing one or more substituents as set forth above.

As used herein, **"alkylene"** refers to a divalent alkyl moiety, and **"oxyalkylene"** refers to an alkylene moiety containing at least one oxygen atom instead of a methylene (CH₂) unit. **"Substituted alkylene"** and **"substituted oxyalkylene"** refer to alkylene and oxyalkylene groups further bearing one or more substituents as set forth above.

As used herein, **"alkynyl"** refers to straight or branched chain hydrocarbyl groups having at least one carbon-carbon triple bond, and having in the range of 2 up to about 100 carbon atoms, typically about 4 to about 50 carbon atoms, and frequently about 8 to about 25 carbon atoms. **"Substituted alkynyl"** refers to alkynyl groups further bearing one or more substituents as set forth below.

As used herein, **"arylene"** refers to a divalent aryl moiety. **"Substituted arylene"** refers to arylene moieties bearing one or more substituents as set forth above.

**"Imidazole"** as used herein, refers to a moiety having general formula:

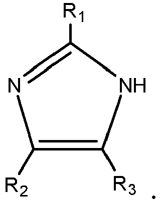

**"Imide"** as used herein, refers to a functional group having two carbonyl groups bound to a primary amine or ammonia. The general formula of an imide of the invention is:

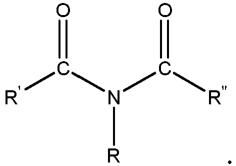

**"Polyimides"** are polymers of imide-containing monomers. Polyimides are typically linear or cyclic. Non-limiting examples of linear and cyclic (e.g. an aromatic heterocyclic polyimide) polyimides are shown below for illustrative purposes.

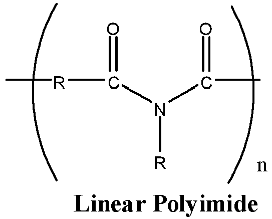

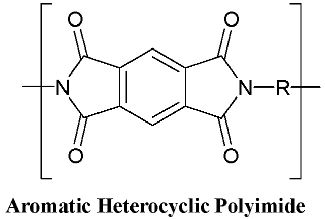

**"Maleimide,"** as used herein, refers to an N-substituted maleimide having the formula as shown below: 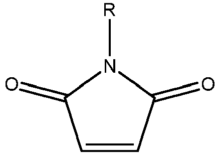 where R is an aromatic, heteroaromatic, aliphatic, or polymeric moiety.

**"Bismaleimide"** or "**BMI**", as used herein, refers to compound in which two imide moieties are linked by a bridge, i.e. a compound a polyimide having the general structure shown below:

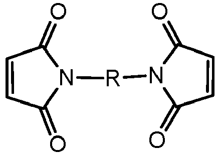

As used herein, **"oxiranylene"** or **"epoxy"** refers to divalent moieties having the structure:

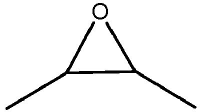

The term **"epoxy"** also refers to thermosetting epoxide polymers that cure by polymerization and crosslinking when mixed with a catalyzing agent or **"hardener,"** also referred to as a **"curing agent"** or **"curative."** Epoxies of the present invention include, but are not limited to aliphatic, cycloaliphatic, glycidyl ether, glycidyl ester, glycidyl amine epoxies, and the like, and combinations thereof.

As used herein, the term **"oxetane"** refers to a compound bearing at least one moiety having the structure:

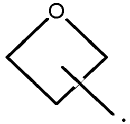

As used herein, the terms **"halogen," "halide,"** or **"halo"** include fluorine, chlorine, bromine, and iodine.

As used herein, **"norbornyl"** refers to a compound bearing at least one moiety having the structure:

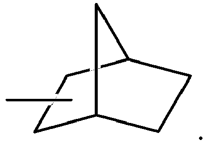

As used herein, the term **"free radical initiator"** refers to any chemical species which, upon exposure to sufficient energy (e.g., light, heat, or the like), decomposes into parts, which are uncharged, but every one of such part possesses at least one unpaired electron.

As used herein, the term **"coupling agent"** refers to chemical species that are capable of bonding to a mineral surface and which also contain polymerizably reactive functional group(s) so as to enable interaction with the adhesive composition. Coupling agents thus facilitate linkage of the die-attach paste to the substrate to which it is applied.

**"Glass transition temperature"** or "**T_{g}**": is used herein to refer to the temperature at which an amorphous solid, such as a polymer, becomes brittle on cooling, or soft on heating. More specifically, it defines a pseudo second order phase transition in which a supercooled melt yields, on cooling, a glassy structure and properties similar to those of crystalline materials e.g. of an isotropic solid material.

**"Low glass transition temperature"** or **"Low T_{g}**" as used herein, refers to a T_{g} at or below about 50°C. **"High glass transition temperature"** or **"High T_{g}**" as used herein, refers to a T_{g} of at least about 60°C, at least about 70 °C, at least about 80°C, at least about 100°C. **"Very high glass transition temperature"** and **"very high T_{g}**" as used herein, refers to a T_{g} of at least about 150°C, at least about 175°C, at least about 200°C, at least about 220°C or higher. Compositions of the invention typically have a T_{g} in the range of about 70 °C to about 300°C.

**"Modulus"** or **"Young's modulus"** as used herein, is a measure of the stiffness of a material. Within the limits of elasticity, modulus is the ratio of the linear stress to the linear strain, which can be determined from the slope of a stress-strain curve created during tensile testing.

The **"Coefficient of Thermal Expansion"** or **"CTE"** is a term of art describing a thermodynamic property of a substance. The CTE relates a change in temperature to the change in a material's linear dimensions. As used herein "**α₁ CTE"** or "**α_{1"}**-refers to the CTE before the T_{g}, while "**α₂** CTE" refers to the CTE after the T_{g}.

**"Low Coefficient of Thermal Expansion"** or **"Low CTE"** as used herein, refers to an **CTE** of less than about 50 ppm/°C.

**"Viscosity"** refers to resistance to gradual deformation by shear stress or tensile stress. Viscosity of liquids can be understood informally as the "thickness". **"Low viscosity"** as used herein, is exemplified by water (0.894 centipoise (cP)) and typically refers to a viscosity at 25°C less than about 10,000 cP, often less than about 1,000 cP, typically less than about 100 cP and often less than about 10 cP. **"High viscosity"** fluids have a viscosity at 25°C greater than about 20,000 cP, typically greater than about 50,000 cP and often greater than about 100,000 cP. Generally, for easy handling and processing, the viscosity of a composition of the present invention should be in the range of about 10 to about 12,000 cP, typically about 10 to about 2,000 cP, and often about 10 to about 1,000 cP.

**"Thixotropy"** as used herein, refers to the property of a material which enables it to stiffen or thicken in a relatively short time upon standing, but upon agitation or manipulation to change to low-viscosity fluid; the longer the fluid undergoes shear stress, the lower its viscosity. Thixotropic materials are therefore gel-like at rest but fluid when agitated and have high static shear strength and low dynamic shear strength, at the same time.

**"Thermogravimetric analysis"** or **"TGA"** refers to a method of testing and analyzing a material to determine changes in weight of a sample that is being heated in relation to change in temperature. **"Decomposition onset"** refers to a temperature when the loss of weight in response to the increase of the temperature indicates that the sample is beginning to degrade.

As used herein the term **"85/85"** is used to describe a highly accelerated stress test (HAST) performed on electronics components. In this test, the electronics parts are exposed to 85°C and 85% relative humidity for hundreds to thousands of hours. The parts are then checked for adhesion and/or electrical performance.

As used herein the term **"PCT"** or **"pressure-cook test"** is used to describe a HAST test performed on electronics components. In this case the electronics parts are placed in a pressure cooker and exposed to 121°C with 100% relative humidity for up to 96 hours. The parts are then checked for adhesion or electrical performance. This is typically the highest reliability test performed on electronics components.

As used herein the term **"dielectric constant"** or **"relative permittivity"** (Dk) is the ratio of the permittivity (a measure of electrical resistance) of a substance to the permittivity of free space (which is given a value of 1). In simple terms, the lower the Dk of a material, the better it will act as an insulator. As used herein, **"low dielectric constant"** refers to a materials with a Dk less than that of silicon dioxide, which has Dk of 3.9. Thus, **"low dielectric constant refers"** to a Dk of less than 3.9, typically, less than about 3.5, and most often less than about 3.0.

As used herein the term **"dissipation dielectric factor", "dissipation dielectric factor",** and abbreviation "**Df**" are used herein to refer to a measure of loss-rate of energy in a thermodynamically open, dissipative system. In simple terms, Df is a measure of how inefficient the insulating material of a capacitor is. It typically measures the heat that is lost when an insulator such as a dielectric is exposed to an alternating field of electricity. The lower the Df of a material, the better its efficiency. "Low **dissipation dielectric factor"** typically refers to a Df of less than about 0.01 at 1-GHz frequency, frequently less than about 0.005 at 1-GHz frequency, and most often 0.001 or lower at 1-GHz frequency.

### Description and Embodiments of the Invention

The present invention is based on the observation that maleimide compounds can be cured under purely anionic conditions previously found suitable for cutting epoxies, in the absence of free radical initiators. This observation can be exploited for the formulation of compositions containing both maleimide and epoxy resins where both utilize the same anionic curing chemistry and the two resins co-cure to form materials that have excellent adhesion to a variety of surfaces while at the same time, have excellent performance under hot, wet conditions.

Not wishing to be held to any particular theory, the basic premise of the invention is that since BMI's and epoxies can both undergo anionic polymerization, then the combination of the two could obtain the benefit of desirable characteristics of both, while avoiding undesirable characteristics when cured anionically. Surprisingly, the results of the experiments described herein exceeded the expectations put forth.

The present invention thus provides compositions that include: 1) a maleimide component that includes at least one maleimide as defined in claim 1; 2) an epoxy component that includes at least one epoxy; and 3) and least one anionic curing catalyst, with the proviso that the composition does not contain any free-radical initiator. In certain embodiments of the compositions of the invention also include at least one filler, at least one reactive diluent or a combination thereof.

The compositions of the invention may be adhesives (i.e., uncured adhesives). Also provided are cured adhesives and other compositions containing the combinations of epoxies, maleimides and anionic cure catalysts described herein.

Evidence exists that co-polymerization is taking place, and it is not just an interpenetrating network, even though some homopolymerization will also be occurring.

### Curing Mechanisms

***Epoxy Cure Mechanisms.*** A wide variety of curing mechanisms are known for epoxies. Curing may be achieved by reacting an epoxy with itself (homopolymerization) or by forming a copolymer with polyfunctional curatives or hardeners. In principle, any molecule containing a reactive hydrogen can react with the epoxide groups of an epoxy resin. Common classes of hardeners for epoxy resins include amines, acids, acid anhydrides, phenols, alcohols and thiols.

Epoxy resins are known for undergoing anionic as well as cationic polymerization. Epoxy resins be homopolymerized in the presence of an anionic catalyst (a Lewis base such as tertiary amines or an imidazole), or a cationic catalyst (a Lewis acid such as a boron trifluoride complex). This process, known as catalytic homopolymerization, has led to a variety of materials use in throughout many industries. The resulting homopolymers contains only ether bridges, and exhibit high thermal and chemical resistance, but are brittle and often require elevated temperature to effect curing.

***Maleimide and Bismaleimide Curing Mechanisms.*** The free-radical reaction and cure of bismaleimides is well-known and results in compositions that are in useful for electronics and other applications.

A disadvantage of free-radical polymerization of bismaleimide resins (as well as acrylic resins) is that a large amount of cure shrinkage occurs (up to 10 %). Shrinkage can reduce adhesion, lead to delamination and has the potential to produce void sites between adhered materials into which moisture can creep in and cause corrosion

Another significant disadvantage of free-radical cure of bismaleimides and acrylics is that oxygen acts as an inhibitor of the reaction. When exposed to air during free-radical curing, the surface of the bismaleimide-containing compositions can remain tacky because it has not fully cured. Such oxygen surface inhibition with free-radical cure that can sometimes be overcome by the use of higher cure temperature or anoxic conditions.

Bismaleimides, however, also can also be cured using anionic polymerization. The addition of an amine, particularly a secondary, tertiary or an imidazole type amine will also lead to the polymerization of the maleimides moiety, although the reaction is very sluggish and does not produce a sharp cure peak on the DSC. See **EXAMPLE 3,** below. Since maleimide double bonds are very electron poor, they react very rapidly with amines via a Michael addition.

Advantageously, anionic cure is not affected by oxygen. Thus, BMI compositions of the invention that are cured via anionic polymerization obviate this issue; even when cured at lower temperatures (100 °C or below), the cured surfaces are tack free.

Maleimides are typically cured under free-radical conditions, some hybrid type material have been reported where free-radical initiators in combination with anionic curing initiators are mixed to conduct a dual cure. In composites, bismaleimides are often cured via Diels-Alder or Alder-ene reaction to form very high T_{g} materials. The maleimide double bond is very electron poor and is very reactive toward bases including many catalysts that are used to cure epoxy resins.

### Anionic Cure of Maleimide-Epoxy Mixtures

In one embodiment of the invention, the anionic cure of bismaleimides is contemplated for use in the practice of the invention.

The present invention discloses that simultaneous anionically curing a mixture of BMI's and epoxies can give some very advantageous properties that cannot be obtained with either one alone. This is very different than hybrid chemistries that have been reported that combine peroxide initiators to cure the ethylenically unsaturated compound followed by the anionic cure of the epoxy, they may even have some type of bridging compound that can cure with both species.

Since epoxy resins undergo ring-opening polymerization, they generally do not shrink as much as BMIs. Therefore, in some embodiments, epoxy/BMI combination may also have lower shrinkage than the BMI alone.

The anionic cure of similar formulations with epoxy added and cured anionically produce very tough thermosets that can be bent and do not break.

Another benefit is that epoxies have tremendous adhesion to a wide variety of substrates. Most substrates (e.g. metals, minerals, glass, and ceramics) have high surface energies due to the inherent polarity of the substrate material and the potential for oxides to form a layer on the surface; this is a potential bonding site for epoxy resins. Bismaleimides used in this invention have much lower surface energy than epoxy resins and bond much better to low surface energy substrates. The combination of epoxy resins with the bismaleimide resins gives optimum adhesion to a wider variety of surfaces by combining the high strength polar forces of epoxy resins with the Van der Waals forces of bismaleimide resins.

Without wishing to by bound by a particular theory, some evidence indicates that the anionic curing initiators, such as imidazoles, may form complexes with maleimide moieties, which may be a zwitterionic species that acts as a catalyst for the epoxy reaction. This is supported by the fact that DSC analysis shows the lowering of the exothermic peak. Curing the BMI alone with an imidazole produces one or two very broad low energy bumps on the DSC. The addition of a small amount of epoxy resin produces a high-energy sharp exothermic peak on the DSC, this temperature of the cure peak is lower than that of the imidazole with epoxy alone. Analysis of the cured thermoset shows no signs of phase separation, which indicates that the two materials cure together. Also, analysis of the cured thermoset using TGA shows very high temperature stability with virtually no weight loss below 300°C, if uncured resin were present it would show up as weight loss on the TGA.

### Maleimide Component

The maleimide component can include any one or more compounds according to the following general structure: 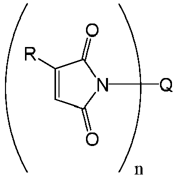 wherein:
Q is selected from the group consisting of a substituted or unsubstituted alkyl, cycloalkyl, aryl, polycyclic, heterocyclic, alkenyl, alkylene, oxyalkyl, ester, polyester, amide, polyamide, polyimide, polyether, polyurethane or siloxane;
R is selected from the group consisting of H, or methyl, and
n is an integer having a value from 1 to about 10.

In certain embodiments of the invention, the maleimide component is a low viscosity (i.e., liquid at room temperature), which can readily be mixed with epoxies. Aliphatic bismaleimides, such as those of the formula above in which Q is aliphatic, are typically liquids.

Maleimide-terminated polyimides are described in U.S. Patent Nos. 7,157,587 and 7,208,566 (Designer Molecules, Inc., San Diego, CA). These compounds are synthesized by reacting an excess of diamine with a dianhydride followed by a condensation reaction to remove the water and produce the amine-terminated polyimide. The terminal amino groups are then reacted with maleic anhydride followed by a second condensation reaction to produce the final product after workup.

There are many other aliphatic bismaleimides that one can make in the laboratory such as those based on: tricyclodecane-diamine; bis-methylnorbornyl diamine; isophorone diamine; bis-aminomethyl cyclohexane; 1,6-diaminohexane; 1,12-diaminododecane; 1,5 diaminopentane; 1,5-diamino-2-methylpentane; 1,9-diaminononane; 2,2'-(ethylenedioxy)bis(ethylamine); 2,2-bis(aminoethoxy)propane; 2,2-dimethyl-1,3-propanediamine; 4,4'-methylenebis(cyclohexylamine); 4,4'-methylenebis(2-methylcyclohexylamine); 2,2,4(2,4,4)-trimethyl-1,6-hexanediamine; 4,7,10-trioxa-1,13-tridecanediamine; 4,9-dioxa-1,12-dodecanediamine, and like primary amines. All of these materials are liquids, low melting solids or glassy solids at room temperature, and they are substantially miscible with the bismaleimide (BMI) of dimer diamine as well as many epoxy resins. This gives an avenue to change the T_{g} and the CTE of the composition.

Aromatic and aliphatic monomaleimides are also contemplated for use in the practice of the invention. These compounds can be used as additives to reduce viscosity, lower modulus and as adhesion promoters. A specific example is oleylmaleimide, which is a very low melting solid at room temperature, however, dissolves readily in many resins and lowers the viscosity tremendously.

The T_{g} of the BMI of dimer diamine is very low and in certain embodiments of the invention, may be close to room temperature. However, other aliphatic BMI's have much higher T_{g} and much lower CTE.

Also some low melting or high melting aromatic bismaleimides are commercially available. Some of these materials can be blended in and increase the T_{g} and lower the CTE even further.

The bismaleimide of dimer diamine is a very hydrophobic resin, absorbing less than 1% moisture after 72 hours in the pressure cooker test. The dimer diamine BMI also has low viscosity (1000-1500 centipoise @25 °C) and also has very good high temperature stability (onset of decomposition about 420 °C on dynamic TGA). This material has very low T_{g} (20-30°C) and very high CTE (180-200 ppm). These properties may be sufficient for some applications; however, new technologies continue to demand much better properties.

The present invention can take advantage of the hydrophobicity and low viscosity of the bismaleimide of dimer diamine. The following is an illustration of one of many isomers of the material.

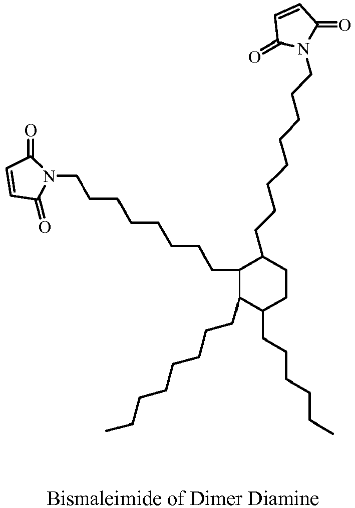

Several grades of dimer diamine are commercially available, including an unsaturated versions (PRIAMINE^{®}-1071, PRIAMINE-1074^{®}, Croda; VERSAMINE^{®}-551, BASF) and a more saturated versions (PRIAMINE^{®}-1075, Croda; VERSAMINE^{®}-552, BASF). The bismaleimides of these dimer diamines are contemplated for use in the practice of the invention.

Smaller aliphatic and aromatic BMI's that have very high T_{g} (>150°C) and low CTE (about 50 ppm). The homo-cure of many of these materials leads to very hydrophilic composites that are also very brittle. These materials are generally low melting solids (Tₘ 40-120 °C) that are fairly soluble with the BMI of dimer diamine as well as most epoxy resins. The BMI's of cycloaliphatic, alkyl, polyether, and other diamines are contemplated for use in the practice of the invention. Non-limiting examples include: BMI of TCD-diamine, BMI of cyclohexyl diamine, BMI of hexane diamine, BMI of limonene diamine, BMI of Jeffamines, and the BMI's of other various diamines are contemplated for use in the practice of the invention. The following structures represent non-limiting compounds contemplated for use in the practice of the invention.

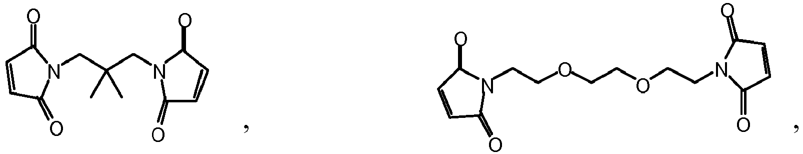

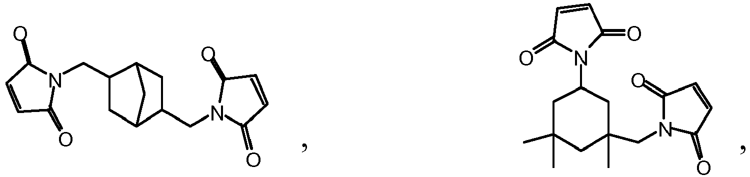

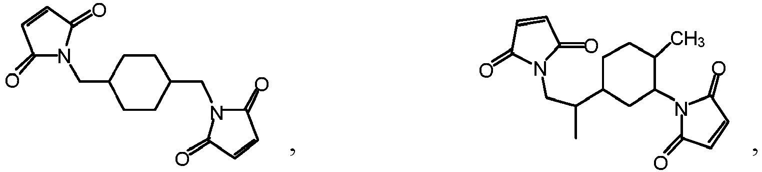

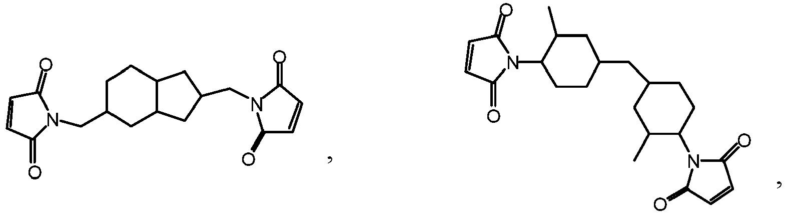

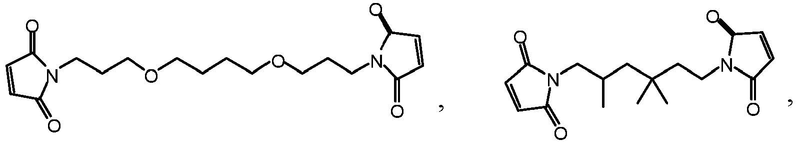

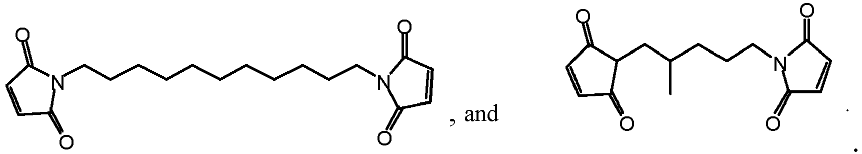

Maleimide resins include compounds that contain at least one maleimide monomer such as N-phenyl-maleimide; N-phenyl-methylmaleimide; N-phenyl-chloromaleimide; N-(napthyl)maleimide; N-(2,3 xylyl)maleimide; N-(2,4-difluorophenyl)maleimide; N-(3-trifluoromethylphenyl)maleimide; N-(bis-3,5-triflouromethyl)maleimide; N-(2,4-xylyl)maleimide; N-(2,6-xylyl)maleimide; N-(2,6-diethylphenyl)maleimide; N-(2-methyl,6-ethylphenyl)maleimide; N-p-chlorophenyl-maleimide; N-p-methoxyphenyl-maleimide; N-p-methylphenyl-maleimide; N-p-nitrophenyl-maleimide; N-p-phenoxyphenyl-maleimide; N-p-phenylaminophenyl-maleimide; N-p-phenoxycarbonylphenyl-maleimide; 1-maleimido-4-acetoxysuccinimido-benzene; 4-maleimido-4'-acetoxysuccinimido-diphenylmethane; 4-maleimido-4'-acetoxysuccinimido-diphenyl ether; 4-maleimido-4'-acetamido-diphenyl ether; 2-maleimido-6-acetamido-pyridine; 4-maleimido-4'-acetamido-diphenylmethane and N-p-phenylcarbonylphenyl-maleimide; N-ethylmaleimide, N-2.6-xylylmaleimide, N-cyclohexylmaleimide, and combinations thereof.

Non-limiting examples of bismaleimide monomers that can be included in embodiments of the invention include N,N'-ethylene-bis-maleimide; N,N'-hexamethylene-bis-maleimide; N,N'-meta-phenylene-bis-maleimide; N,N'-para-phenylene-bis-maleimide; N,N'-4,4'-biphenylene-bis-maleimide; N,N'-4,4'-diphenylmethane-bis-maleimide; N,N'-4,4'-(diphenyl ether)-bis-maleimide; N,N'-4,4'-(diphenyl sulfide)-bis-maleimide; N,N'-m-phenylenebismaleimide, 4,4'-diphenylmethanebismaleimide, N,N'-(4-methyl-m-phenylene)-bismaleimide, polyphenylmethanebismaleimide; N,N'-4,4'-diphenylsulfone-bis-maleimide; N,N'-4,4'-dicyclohexylmethane-bis-maleimide; N,N'-α,α'-4,4'-dimethylenecyclohexane-bis-maleimide; N,N'-meta-xylylene-bis-maleimide; N,N'-para-xylylene-bis-maleimide; N,N'-4,4'-(1,1-diphenylcyclohexane)-bis-maleimide; N,N'-4,4'-diphenylmethane-bis-chloromaleimide; N,N'-4,4'-(1,1-diphenylpropane)-bis-maleimide; N,N'-4,4'-(1,1,1 -triphenylethane)-bis-maleimide; N,N'-4,4'-triphenylmethane-bis-maleimide; N,N'-3,5-triazole-1,2,4-bis-maleimide; N,N'-dodecamethylene-bis-maleimide; N,N'-(2,2,4-trimethylhexamethylene)-bis-maleimide; N,N'-4,4'-diphenylmethane-bis-citraconimide; 1,2-bis-(2-maleimidoethoxy)-ethane; 1,3-bis-(3-maleimidopropoxy)-propane; N,N'-4,4'-benzophenone-bis-maleimide; N,N'-pyridine-2,6-diyl-bis-maleimide; N,N'-naphthylene-1,5-bis-maleimide; N,N'-cyclohexylene-1,4-bis-maleimide; N,N'-5-methylphenylene-1,3-bis-maleimide or N,N'-5-methoxyphenylene-1,3 -bis-maleimide.

Maleimide-functionalized polyesters, polyethers, polyurethanes, siloxanes as well as others maleimide functionalized compounds are also suitable for use in the practice of the present invention. Tri-, tetra-, as well as polyfunctional maleimide resins can also be sued in the practice of the invention.

In another embodiment of the invention, maleimidocarboxylic acids and maleimidophenolics are used as additives to increase adhesion to certain substrates. These compounds can also be used to form salts with the amine catalysts to prevent premature curing, to increase work-life of a formulation, or to give more latency to the cure. The following are non-limiting examples of such compounds that can be used in the practice of the invention.

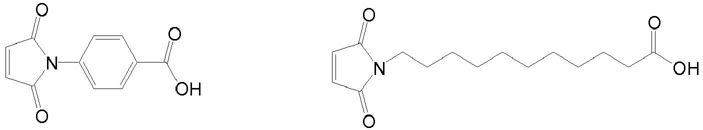

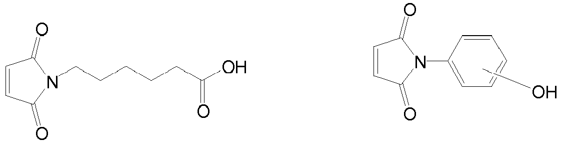

The addition of the BMI of dimer diamine can help to control the brittleness and also make the material much more hydrophobic. The addition of imide-extended maleimides resins (Designer Molecules, Inc., San Diego, California) of the general formula: 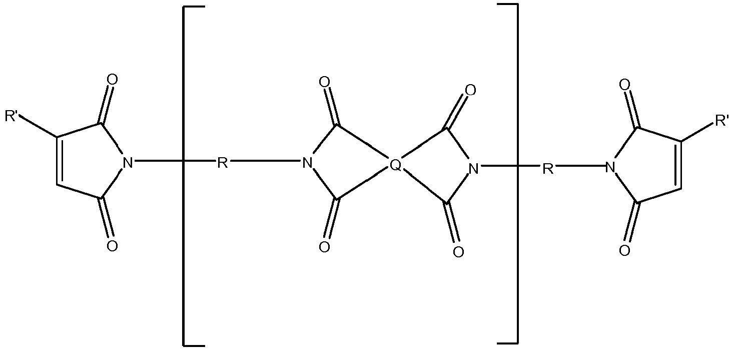 wherein, R and Q are each independently substituted or unsubstituted aliphatic, cycloaliphatic, aromatic, heteroaromatic, polyether, or siloxane moiety;
R' is H or methyl; and n is 1 to about 10.
can lead to even more hydrophobic composites, which are much more flexible than the BMI of dimer diamine.

In certain embodiments, R and Q are each independently substituted or unsubstituted aliphatic, cycloaliphatic, polyether, or siloxane. In yet further embodiments, at least one of R and Q is aliphatic or cycloaliphatic.

In certain aspects, R and Q are each independently selected from substituted or unsubstituted aliphatic, alkenyl and siloxane moieties. In yet further embodiments, at least one of R and Q is aliphatic.

The maleimide-terminated polyimides above range from very viscous liquids at 25°C to amorphous powders. These materials also have glass transition temperatures that range from low T_{g} (under 50°C) to very high T_{g} (over 200°C) thermosets. The maleimide-terminated polyimides shown below have some of the lowest dielectric constants of known thermoset adhesives. The Dk of these materials has been measured at about 2.2 to about 2.6, while most commercially available polyimides that are unfunctionalized have Dk values of about 3.4. This is why these materials are of significant interest for today's high frequency electronics environments. The following Table 1 shows the average Dk (Permittivity) and average Df (Loss Tangent) for some of the BMI's that are contemplated for use in the compositions of the present invention.

**Table 1. BMI and Maleimide Terminated Polyimides Average Dk (Permittivity) and Average Df (Loss Tangent) at 1.5 GHz Frequency**

| **Resin** | **Avg. Dk** | **Avg. Df** |
|---|---|---|
| BMI-689 | 2.44 | 0.005 |
| BMI-1400 | 2.52 | 0.004 |
| BMI-1500 | 2.50 | 0.005 |
| BMI-1700 | 2.52 | 0.004 |
| BMI-3000 | 2.21 | 0.001 |
| BMI-FM30-120 | 2.27 | 0.001 |
| BMI-FM30-131 | 2.60 | 0.011 |
| BMI-FM30-133 | 2.72 | 0.005 |
| BMI-FM30-194 | 2.70 | 0.003 |
| BMI-FM30-183 | 2.58 | 0.009 |

The skilled artisan would recognize very few thermoset resins have dielectric properties that could match the Dk and Df of the materials listed in **Table 1.** The resins represent derivatives of the chemical structures shown below, which are non-limiting examples of the maleimide-terminated polyimides contemplated for use in the practice of the invention: 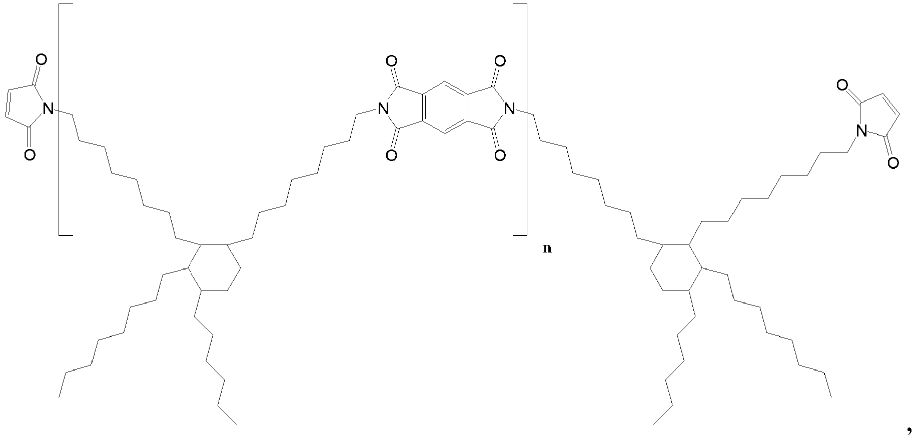 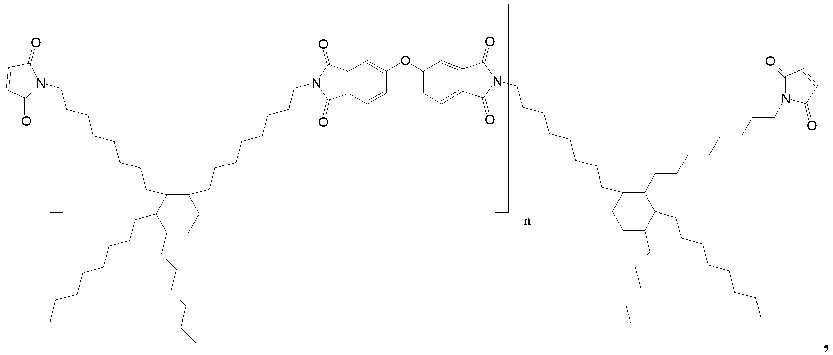 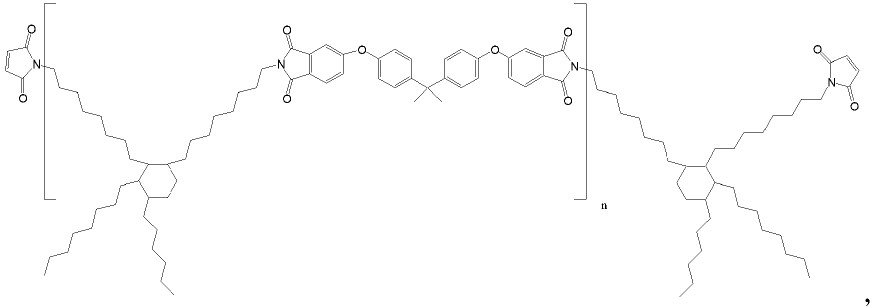 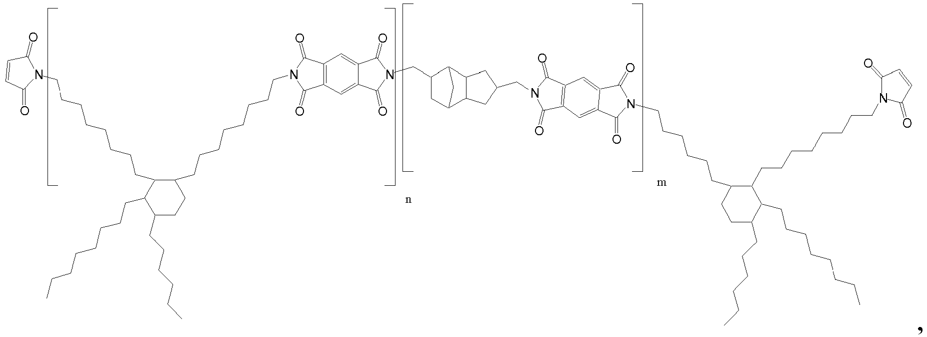 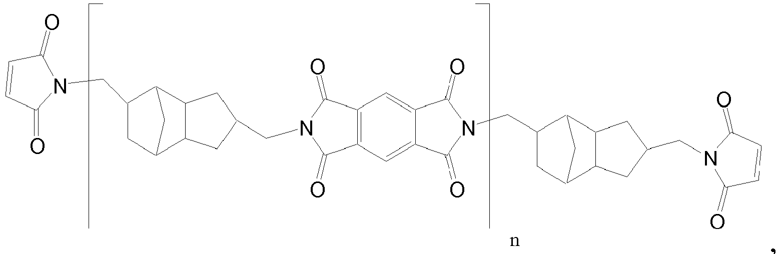 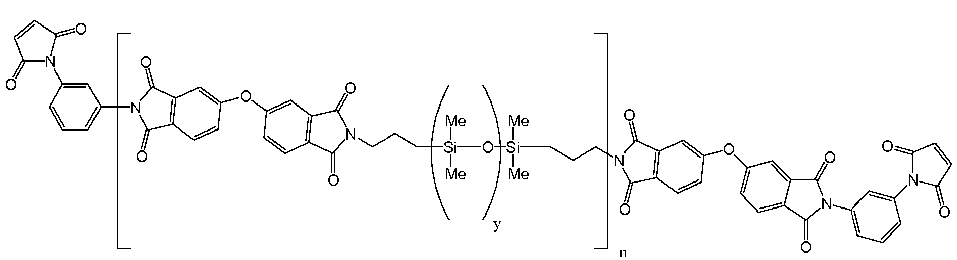 ,and 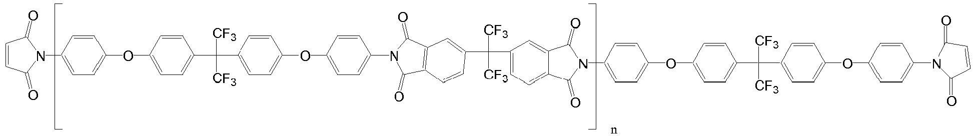 where n and m are integers from 1-10 and y is from 0-100.

The itaconimide and citraconimide derivatives of all of the maleimide compounds described herein are also contemplated for use in the practice of the invention.

According to certain embodiments of the invention, the amount of the maleimide component can vary from about 1% to about 90%, based on the total weight of the composition.

### Epoxy Component

Epoxy Resins include compounds containing at least one oxirane group per molecule. The most useful of this class of compounds are those that contain at least two oxirane groups. Important compounds relative to class of materials include glycidyl ethers of alcohols or phenols. These compounds may be prepared by reacting an epihalohydrin with a phenol or alcohol.

Commercially available epoxies have wide range of viscosities from low to high and many of the solids are low melting materials that are very compatible with the BMI resins, particularly with aliphatic BMI resins, as well as the maleimide-terminated polyimides.

The epoxy resins contemplated for use in the practice of the invention include all classes of epoxide monomers, including: glycidyl ethers; glycidyl esters; aliphatic oxiranes; cycloaliphatic epoxides; oxetanes; glycidyl amines; epoxy functionalized siloxanes and cyclosiloxanes, and polyhedral oligomeric silsesquioxanes (POSS^{®} Hybrid Plastics).

The epoxide moiety is readily converted to episulfide moiety via the reaction with thiocyanate or thiourea. The episulfide analogs are also contemplated for use in the practice of the invention.

Examples of epoxy resins include: the glycidyl ethers of bis(4-hydroxyphenyl)sulfide, bis(4-hydroxyphenyl)ether, bis(4-hydroxyphenyl)sulfone, bis(4-hydroxyphenyl)sulfoxide, 4,4'-(phenylphosphinyl)diphenol, 5-cyano-1,3-dihydroxybenzene, 4-cyano-1,3-dihydroxybenzene, 2-cyano-1,4-dihydroxybenzene, 2-methoxyhydroquinone, 2,2'-dimethylbiphenol, 2,2',6,6'-tetramethylbiphenol, 2,2',3,3',6,6'-hexamethylbiphenol, 3,3',5,5'-tetrabromo-2,2',6,6'-tetramethylbiphenol, 2,2-bis(4-hydroxyphenyl)hexafluoropropane, 4,4'-(3,3,5-trimethylcyclohexylidene)diphenol, 1,1-bis(4-hydroxy-3-methylphenyl)cyclohexane, 4,4-bis(4-hydroxyphenyl)heptane, 2,4'-dihydroxydiphenylmethane, bis(2-hydroxyphenyl)methane, bis(4-hydroxyphenyl)methane, bis(4-hydroxy-5-nitrophenyl)methane, bis(4-hydroxy-2,6-dimethyl-3-methoxyphenyl)methane, 1,1-bis(4-hydroxyphenyl)ethane, 1,2-bis(4-hydroxyphenyl)ethane, 1,1-bis(4-hydroxy-2-chlorophenyl)ethane, 2,2-bis(3-phenyl-4-hydroxyphenyl)propane, 2,2-bis(4-hydroxy-3-methylphenyl)propane, 2,2-bis(4-hydroxy-3-ethylphenyl)propane, 2,2-bis(4-hydroxy-3-isopropylphenyl)propane, 2,2-bis(4-hydroxy-3,5-dimethylphenyl)propane, 3,5,3',5'-tetrachloro-4,4'-dihydroxyphenyl)propane, bis(4-hydroxyphenyl)cyclohexylmethane, 2,2-bis(4-hydroxyphenyl)-1-phenylpropane, 2,4'-dihydroxyphenyl sulfone, 2,2-bis(4-hydroxyphenyl)butane, 2,2-bis(4-hydroxyphenyl)-2-methylbutane, 1,1-bis(4-hydroxyphenyl)cyclohexane, 2-(3-methyl-4-hydroxyphenyl-2-(4-hydroxyphenyl)propane, 2-(3,5-dimethyl-4-hydroxyphenyl)-2-(4-hydroxyphenyl)propane, 2-(3-methyl-4-hydroxyphenyl)-2-(3,5-dimethyl-4-hydroxyphenyl)propane, bis(3,5-dimethylphenyl-4-hydroxyphenyl)methane, 1,1-bis(3,5-dimethylphenyl-4-hydroxyphenyl)ethane, 2,2-bis(3,5-dimethylphenyl-4-hydroxyphenyl)propane, 2,4-bis(3,5-dimethylphenyl-4-hydroxyphenyl)-2-methylbutane, 3,3-bis(3,5-dimethylphenyl-4-hydroxyphenyl)pentane, 1,1-bis(3,5-dimethylphenyl-4-hydroxyphenyl)cyclopentane, 1,1-bis(3,5-dimethylphenyl-4-hydroxyphenyl)cyclohexane, bis(3,5-dimethyl-4-hydroxyphenyl)sulfoxide, bis(3,5-dimethyl-4-hydroxyphenyl)sulfone, bis(3,5-dimethylphenyl-4-hydroxyphenyl)sulfide, 2-carbamoylhydroquinone, 2,3-dicarbamoylhydroquinone, 2,2-bis(4-hydroxyphenyl)propane (bisphenol-A), resorcinol, catechol, hydroquinone, 2,6-dihydroxy naphthalene, 2,7-dihydroxynapthalene, 2,4'-dihydroxyphenyl sulfoxide, 2-diphenylphosphinylhydroquinone, bis(2,6-dimethylphenol) 2,2'-biphenol, 4,4'-biphenol, 4,4'-bis(3,5-dimethyl)biphenol, 4,4'-bis(2,3,5-trimethyl)biphenol, 4,4'-bis(2,3,5,6-tetramethyl)biphenol, 4,4'-bis(3-bromo-2,6-dimethyl)biphenol, 4,4'-isopropylidenebis(2,6-dibromophenol) (tetrabromobisphenol A), 4,4'-isopropylidenebis(2,6-dimethylphenol) (tetramethylbisphenol A), 4,4'-isopropylidenebis(2-methylphenol), 4,4'-isopropylidenebis(2-allylphenol), 4,4'-isopropylidenebis(2-allyl-6-methylphenol), 4,4'-isopropylidene-bis(2-phenylphenol), 4,4'(1,3-phenylenediisopropylidene)bisphenol (bisphenol M), 4,4'-(1,4-phenylenediisoproylidene)bisphenol (bisphenol P), 4,4'-sufonylbis(2,6-dimethylphenol), 4,4'-hexafluoroisoproylidene)bisphenol (Bisphenol AF), 4,4'-hexafluoroisopropylidene) bis(2,6-dimethylphenol), 4,4'(1-phenylethylidene)bisphenol (Bisphenol AP), 4,4'-(1-phenylethylidene)bis(2,6-dimethylphenol), 3,3-(4-hydroxyphenyl)pentane, bis(4-hydroxyphenyl)-2,2-dichloroethylene (Bisphenol C), bis(2,6-dimethyl-4-hydroxyphenyl)methane, 4,4'-(cyclopentylidene)diphenol, 4,4'-(cyclohexylidene)bis(2-methylphenol), 4,4'-bis(4-hydroxyphenyl)diphenyl ether, 9,9-bis(3-methyl-4-hydroxyphenyl)fluorene, N-phenyl-3,3-bis-(4-hydroxyphenyl)phthalimide, 4,4'-(cyclododecylidene)diphenol, 4,4'-(bicyclo[2.2.1]heptylidene)diphenol, 4,4'-(9H-fluorene-9,9-diyl)diphenol, 3,3-bis(4-hydroxyphenyl)isobenzofuran-1 (3H)-one, 1-(4-hydroxyphenyl)-3,3-dimethyl-2,3-dihydro-1H-inden-5-ol, 1-(4-hydroxy-3,5-dimethylphenyl)-1,3,3,4,6-pentamethyl-2,3-dihydro-1H-ind- en-5-ol, 3,3,3',3'-tetramethyl-2,2',3,3'-tetrahydro-1,1'-spirobi[indene]-5-,6'-diol (Spirobiindane), dihydroxybenzophenone (bisphenol K), tris(4-hydroxyphenyl)methane, tris(4-hydroxyphenyl)ethane, tris(4-hydroxyphenyl)propane, tris(4-hydroxyphenyl)butane, tris(3-methyl-4-hydroxyphenyl)methane, tris(3,5-dimethyl-4-hydroxyphenyl)methane, tetrakis(4-hydroxyphenyl)ethane, tetrakis(3,5-dimethyl-4-hydroxyphenyl)ethane, bis(4-hydroxyphenyl)phenylphosphine oxide, dicyclopentadienylbis(2,6-dimethyl phenol), dicyclopentadienyl bis(2-methylphenol) or dicyclopentadienyl bisphenol. Phenol-formaldehyde resins, bisphenol-formaldehyde resins, 1,1,1-tris(4-hydroxyphenyl)ethane, and1,1,2,2-tetra(4-hydroxyphenyl)ethane, naphthalene glycidyl ether. Included on this list are the products that are listed under trade names such as EPON^{®} resins (Hexion Corporation), ARALDITE^{®} resins (Huntsman Corporation), D.E.R^{™} resins (Dow Chemical), and EPICLON^{®} resins (DIC Corporation).

Various cycloaliphatic epoxy resins, glycidyl amines, glycidyl esters, oxetanes, silicone epoxies, epoxycyclosiloxane, functionalized polyhedral oligomeric silsesquioxanes (POSS^{®}, Hybrid Plastics, Hattiesburg, MS) are also contemplated for use in the practice of the invention. The epoxy compounds are readily converted to episulfide resins via the reaction with thiocyanate or thiourea. The episulfide analogs are also contemplated for use in the practice of the invention.

The following are non-limiting examples of other epoxy resins contemplated for use in the practice of the invention.

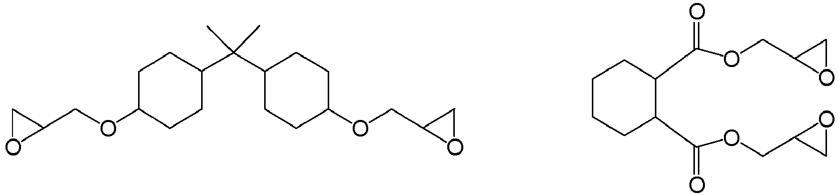

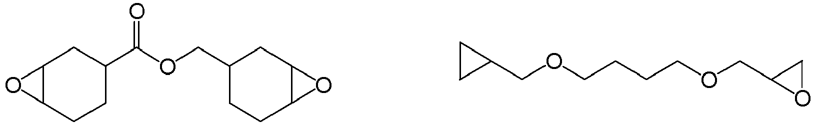

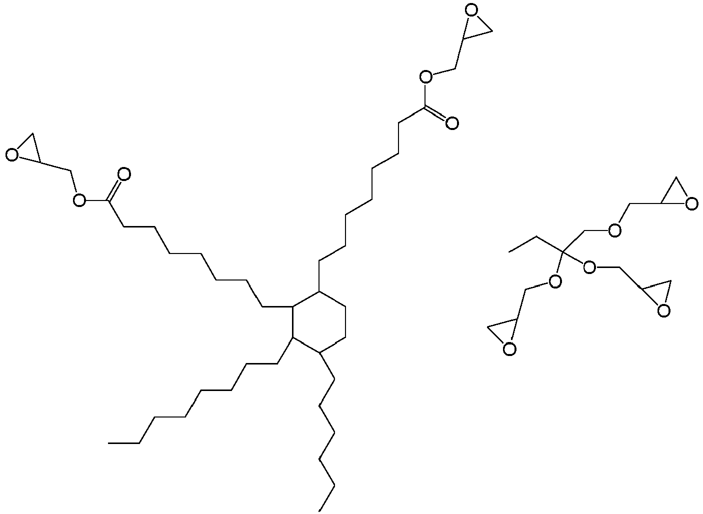

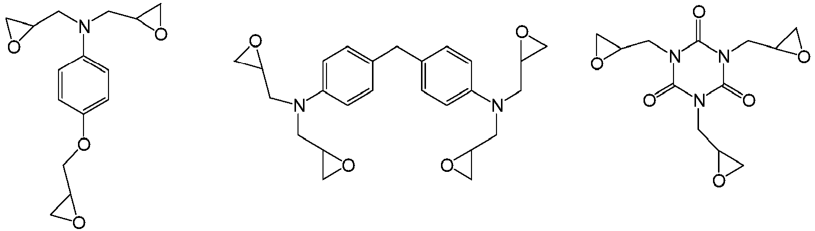

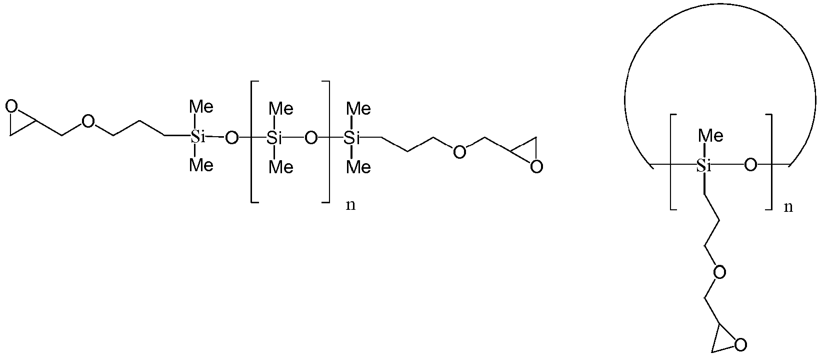

The compositions of the invention can include about 1% to about 90% of the epoxy component based on the total weight of the composition. In certain embodiments, the epoxy component will be present at about 5 to about 50 weight %, frequently at about 10 to about 25 weight %, and often at about 15 to about 20 weight %.

### Anionic Curing Catalysts

The cure catalysts and accelerators suitable for use in the practice of the invention include: tertiary amines; imidazole derivatives; other heterocyclic nitrogen compounds; pyridine derivatives; nucleic acids; aromatic amines; polyfunctional amines; phosphines, phosphazenes; amides, metal amides; metal alkoxides, metal hydroxides, metal cyanides, and certain other metal salts. In certain embodiment of the invention the catalyst is present from about 0.1% to about 10% by weight, based on the total weight of the resin mixture.

***Imidazole Derivatives.*** Catalysts useful for the epoxy-maleimide thermal cure include imidazole derivatives. A variety of imidazole derivative catalysts are commercially available under the trade name CUREZOL^{®} (Shikoku Chemical Corporation, Japan). The following are the non-limiting examples of CUREZOL^{®} imidazole derivatives used as catalysts in the practice of the invention, with the trade name indicated in parentheses: 1-benzyl-2-phenylimidazole (1B2PZ); 1-benzyl-2-methylimidazole (1B2MZ); 2-phenyl-4-methylimidazole (2P4MZ); 2-phenylimidazole (2PZ); 2-ethyl-4-methylimidazole (2E4MZ); 1,2-dimethylimidazole (1.2DMZ); 2-heptadecylimidazole (C17Z); 2-undecylimidazole (C11Z); 2-methylimidazole (2MZ); imidazole (SIZ); 1-cyanoethyl-2-methylimidazole (2MZ-CN); 1-cyanoethyl-2-undecylimidazole (C11Z-CN); 1-cyanoethyl-2-ethyl-4-methylimidazole (2E4MZ-CN); 1-cyanoethyl-2-phenylimidazole (2PZ-CN); 1-cyanoethyl-2-phenylimidazolium-trimellitate (2PZCNS-PW); 1-cyanoethyl-2-undecylimidazolium-trimellitate (C11Z-CNS); 2,4-diamino-6-[2'-ethyl-4'-methylimidazolyl-(1')]-ethyl-s-triazine (2E4MZ-A); 2,4-diamino-6-[2'-undecylimidazolyl-(1')]-ethyl-s-triazine (C11Z-A); 2,4-diamino-6-[2'-methylimidazolyl-(1')]-ethyl-s-triazine (2MZA-PW); 2,4-diamino-6-[2'-methylimidazolyl-(1')]-ethyl-s-triazine (2MZ-A); 2-phenylimidazoleisocyanuric acid adduct (2PZ-OK); 2,4-diamino-6-[2'-methylimidazolyl-(1')]-ethyl-s-triazineisocyanuric acid adduct dehydrate (2MA-OK); 2-phenyl-4-methyl-5-hydroxymethylimidazole (2P4MHZ-PW); 2-phenyl-4,5-dihydroxymethylimidazole (2PHZ-PW); 1-dodecyl-2-methyl-3-benzylimidazolium chloride (SFZ); 2,3-dihydro-1H-pynolo[1,2-a]benzimidazole (TBZ); 2-phenylimidazoline (2PZL-T); 2,4-diamino-6-methacryloyloxyethyl-1,3,5-triazine (MAVT); 2,4-diamino-6-vinyl-1,3,5-triazineisocyanuric acid adduct (OK); 2,4-diamino-6-vinyl-1,3,5-triazine (VT); Imidazole-4-carboxaldehyde (4FZ); 2-Phenylimidazole-4-carboxaldehyde (2P4FZ); Imidazole-2-carboxaldehyde (2FZ); Imidazole-4-carbonitrile (4CNZ); 2-Phenylimidazole-4-carbonitrile (2P4CNZ); 4-Hydroxymethylimidazole hydrochloride (4HZ-HCL); 2-Hydroxymethylimidazole hydrochloride (2HZ-HCL); Imidazole-4-carboxylic acid (4GZ); Imidazole-4-dithiocarboxylic acid (4SZ); Imidazole-4-thiocarboxamide (4TZ); 2-Bromoimidazole (2BZ); 2-Mercaptoimidazole (2SHZ); 1,2,4-Triazole-1-carboxamidine hydrochloride (TZA); (t-Butoxycarbonylimino-[1,2,4]triazol-1-yl-Methyl)-carbamic acid t-butyl ester (TZA-BOC); Thiazole-2-carboxaldehyde (2FTZ); Thiazole-4-carboxaldehyde (4FTZ); Thiazole-5-carboxaldehyde (5FTZ); Oxazole-2-carboxaldehyde (2FOZ); Oxazole-4-carboxaldehyde (4FOZ); Oxazole-5-carboxaldehyde (5FOZ); Pyrazole-4-carboxaldehyde (4FPZ); Pyrazole-3-carboxaldehyde (3FPZ).

***Amines.*** Cyclic tertiary amines are very reactive toward the maleimide moiety as well as the epoxy moiety. Advantageously, the reactivity of tertiary amines can be exploited for producing fast cure rates. The following are some of the non-limiting examples of cyclic tertiary amines contemplated for use as catalysts in the practice of the invention: 1-azabicyclo[2.2.2]octane (ABCO); 1,4-diazabicyclo[2.2.2]octane (DABCO); 1,5-diazabicyclo[4.3.0]non-5-ene (DBN); 1,8-diazabicyclo[5.4.0]undec-7-ene (DBU); 1,5,7-triazabicyclo[4.4.0]dec-5-ene (TBD); 7-methyl-1,5,7-triazabicyclo[4.4.0]dec-5-ene (MTBD); 1,2,2,6,6-pentamethylpiperidine (PMP); 4-(dimethylamino)-1,2,2,6,6-pentamethylpiperidine, and the like.

In another embodiment of the invention the curing catalyst is 2-cyanoquanidiene (DICY) the dimer of cyanamide, which has a very high melting point and is often used as a catalyst for latent cures, typically an accelerator is added to the formulation to aid the cure. Other latent catalysts contemplated for use are ECAT resins (Designer Molecules, Inc). Some of the highly reactive tertiary amines and imidazole catalysts can also be microencapsulated in order to provide latency, these capsules will melt at a specific temperature and release the catalyst to start the curing process.

Other anionic catalysts are also contemplated for use in the practice of the invention, including, but not limited to: phosphines; phosphazenes; metal carbonates; metal hydrides; metal hydroxides; metal alkoxides; metal cyanides, and the like.

In an oven cure system, an anionic initiator is required to allow for the curing or polymerization of the resin mixture. Many nitrogen-based catalysts are commercially available from various sources. These include primary, secondary, and tertiary amines, as well as cyclic nitrogen compounds, such as imidazoles, or ECAT catalysts (Designer Molecules, Inc., San Diego, CA). For certain applications, the amine may be transformed into a stable salt with the addition of a carboxylic acid type of moiety to allow certain pot-life to the resin mixture. Other anionic catalysts contemplated for use in the practice of the invention are those based on phosphines, amides, alkoxides, hydroxides, cyanides, and certain metal salts. Those skilled in the art will appreciate that in curing of epoxy resins several different types of reactive compounds may be used together to give the cured product optimum properties. These reactive compounds can be classified as catalysts, accelerators, initiators, promoters, and driers.

Non-limiting examples of accelerators include: tris(dimethylaminomethyl)phenol (DMP-30); 2(dimethylaminomethyl)phenol (DMP-10); benzyldimethylamine (BDMA); triethanolamine; amino-n-propyldiethanolamine; N,N-dimethyldipropylenetriamine, and the like. The accelerator is something that would be added in combination with an imidazole or tertiary amine catalyst to help speed up the cure.

***Reactive Diluents.*** To control the T_{g}, modulus, viscosity, tensile strength, percent elongation and other requirements, many diluents can be included in the compositions of the invention. For certain embodiments of the invention, the diluents should possess characteristics such as hydrophobicity, low volatility and fast cure speed. The diluents can be anionically curable materials such as epoxies or maleimides. Other anionically curable diluents may also be added those include, but are not limited to: styrenics; isopropenylbenzene derivatives; various dienes; acrylates; methacrylates; vinyl pyridine; aldehydes; episulfides; cyclosiloxanes; oxetanes; lactones; acrylonitrile; cyanoacrylates; vinyl ketones; acrolein; vinyl sulfones; vinyl sulfoxides; vinyl silanes; isocyanates; cinnamates; maleates, and such.

***Fillers.*** In some embodiments, fillers are contemplated for use in the practice of the present invention, which can be electrically conductive and/or thermally conductive, and/or fillers, which act primarily to modify the rheology of the resulting composition. Examples of suitable electrically conductive fillers that can be employed in the practice of the present invention include silver, nickel, copper, aluminum, palladium, gold, graphite, metal-coated graphite (e.g., nickel-coated graphite, copper-coated graphite, and the like), copper alloys and the like. Examples of suitable thermally conductive fillers that can be employed in the practice of the present invention include graphite, aluminum nitride, silicon carbide, boron nitride, diamond dust, zinc oxide, alumina, mica and the like. Compounds which act primarily to modify rheology include polysiloxanes (such as polydimethyl siloxanes), silica, fumed silica, fumed alumina, fumed titanium dioxide, calcium carbonate, poly perfluorocarbons and the like. Fillers are generally employed within the range of 0 to about 90 weight% based on the total weight of the composition.

***Adhesion Promoters.*** Adhesion promoters and silane coupling agents may also be used in the invention formulations. Exemplary adhesion promoters and coupling agents include but are not limited to organotitanates; metal acrylates; silicate esters; triazoles derivatives and the like. When present, adhesion promoters and coupling agents are generally employed with the range of 0.1 to about 3% by weight based on the total weight of the composition.

Aromatic and aliphatic monomaleimides, while not contemplated for use as a primary maleimide resin in compositions of the invention, can be used as additives to reduce viscosity, lower modulus and as adhesion promoters.

***Fire Retardants.*** Also contemplated for use in the practice of the invention is the addition of fire retardants. In certain applications such a laminates for composites used in electronics and aerospace applications fire retardants are a must. All fire retardants are contemplated for use in the practice of the invention. I n certain electronics applications, home goods, and the aerospace industry, the inclusion of fire retardants is a must. All fire retardants used in adhesives and composites are contemplated for use in the practice of the invention, including organophosphorus (Exolit^{®} brand Clarient) and phosphazenes as well as inorganic metal hydroxides.

***Flexible Additives.*** Often flexible materials can be added to these compositions if they are too brittle. Flexible materials contemplated for use include but are not limited to maleated ricon derivatives, polybutadiene derivatives, ABS rubbers and especially, the maleimide-terminated polyimides (Designer Molecules, inc., San Diego, California).

***Additional Hardeners and Curing Accelerators.*** Other hardeners and accelerators , which may increase the curing in combination with a curing initiator or catalyst, may also be added to the invention formulations. Other hardeners that are contemplated for use in the practice of the invention include, but are not limited by compounds such as: carboxylic acid derivatives; various anhydrides; maleimidoacids; maleimidophenols; thiol derivatives; various alcohols; and combination thereof. Non-limiting examples are as follows of accelerators suitable for use in the present invention are:
tris(dimethylaminomethyl)phenol (DMP-30); 2(dimethylaminomethyl)phenol (DMP-10);
benzyldimethylamine (BDMA); triethanolamine; amino-n-propyldiethanolamine; N,N-dimethyldipropylenetriamine, and the like.

### Properties of Maleimide-Epoxy Compositions

The most useful compositions of the invention are compositions that are liquids or very low melting solids. These materials will also have very low viscosity especially at processing temperatures. This is especially useful for making underfill, die-attach adhesives or composites where low viscosity materials are required.

***High Temperature Stability.*** Typically, compositions of the invention remain stable, adhered to their substrates and show little to no decomposition or deterioration following repeated exposure to temperatures of at least about 40°C, at least about 50°C, at least about 60°C, at least about 100°C, at least about 150°C, at least about 200°C and in certain aspects, at least about 250°C. In certain embodiments, compositions of the invention can withstand brief exposure to temperatures between of 90°C to 450°C that may be experienced, for example 260°C, during solder reflow, without decomposition or deterioration.

### Uses of Compositions of the Invention

The compositions of the invention can find a wide variety of uses in the electronics packaging industry; examples include high temperature adhesives, underfills, die-attach adhesives, conformal coatings, potting compounds, high temperature solder resist, EMI-shielding coating, composite for filament winding, interposer, and thermal interface materials. Many of the compositions have very low (Dk (between 2.1 and 3.0 at 1-1.5 GHz) and Df (less than 0.01 at 1-1.5 GHz )and therefore are useful in the fabrication of printed wiring boards, or in flexible copper claim laminate (FCCL) applications for making copper clad laminates. Said compositions can also be used as general adhesives in the automotive, aerospace, and sporting goods industries.

In die attach adhesive applications, the BMI/epoxy formulation of EXAMPLE 8 particularly demonstrates the usefulness of the compositions of the invention. The formulation of EXAMPLE 8 is the only die attach paste that has significant adhesion on bare copper lead frames (about 5-6 Kg-force) at 260 °C, while being able to pass the pressure cooker test (PCT). The typical BMI or acrylic die attach pastes have no adhesion at 260 °C to bare copper lead frames. Commercial epoxy die attach pastes are only rated to 250 °C for adhesion, and are only rated for 85/85 testing. Such materials completely fall apart after PCT testing due to lack of hydrophobicity.

In another embodiment of the invention the invention formulations can be used in bulk molding or sheet molding to be processed with fiberglass or carbon fibers to be injection molding or compression molding. These materials can be used in demanding electrical applications, automotive, transit and corrosion resistance applications.

In semiconductor packaging, epoxy molding compound is used to encapsulate entire packages to provide protection from the elements. In another embodiment the invention compositions can also be used in semiconductor molding compound replacement to provide much better hydrophobicity and better toughness than traditional molding compound while marinating good (>180 °C) and CTE (< 50 ppm).

The addition of phenolic compounds is also contemplated for use in the practice of the invention. Since the chemistry of phenol/epoxy cure systems give some very good properties then the addition is expected to do the same here. These phenolic compounds may be capped as phenyl esters (Designer Molecules, Inc., San Diego, CA).

### EXAMPLES

### EXAMPLE 1: Evaluation of Anionic Curing Catalysts in a BMI-Epoxy Composition

Several commercially available imidazole type curing agents were evaluated for curing a BMI/epoxy mixture. BMI-689 (Designer Molecules, Inc.), which has the following structure 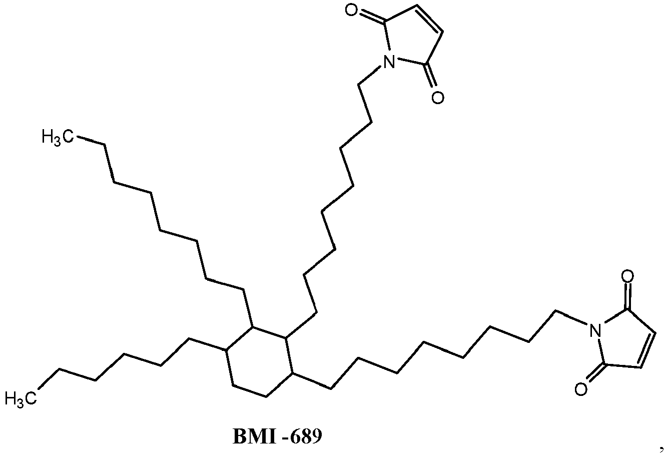 was used as the base resin with 20% by weight of bisphenol-A diglycidyl ether (DGEBPA) as the epoxy resin. To the BMI/epoxy mix was added 4% by weight of various epoxy-curing catalysts, and the materials were then tested for cure profile using DSC. The mixtures were also tested for room temperature pot-life, determined by the appearance of a dark color that signifies anionic cure of the BMI. The materials were also placed in molds and cured at 175°C for 1 hour to observe the physical properties of the cured material. The data is shown in **Table 2.**

**Table 2. Anionic Cure of BMI-689 with DGEBPA**

| **CUREZOL**^{®} **Catalyst** | **Pot Life (hrs) Room Temp** | **DSC Onset (°C)** | **DSC Peak Max (°C)** | **Physical Properties** |
|---|---|---|---|---|
| 1-B2MZ | < 24 | 100 | 125 Sharp | Hard, flexible, uniform cure |
| 2MA-OK | > 96 | 171 | 187 Sharp | Non-uniform cure, bumpy surface |
| 2PZ | > 72 | 150 | 163 Moderate | Hard, flexible, uniform cure |
| 2MZ-AZINE | > 288 | 159 | 168 Broad | Hard, flexible, uniform cure |
| C11Z-A | > 96 | 155 | 181 Broad | Hard, flexible, uniform cure |

It is clear from the data that the choice of catalyst played an important role in cure temperature. The use of CUREZOL^{®} 1-B2MZ cured fast at low temperature, while CUREZOL^{®} C 11Z-A and CUREZOL^{®} 2MZ-AZINE provided a more latent cure with very good pot-life. The DSC profile of CUREZOL^{®} 2MA-OK gave a very sharp cure peak, however, the cured sample was non-uniform. Based on this data, the ideal catalyst for most applications may be CUREZOL^{®} 2PZ with a cure of 150-160°C, and very good pot-life.

### EXAMPLE 2: Comparison of Cure Catalyst and Percent Epoxy in a BMI-Epoxy Composition

Maleimide terminated polyimide R1191 (BMI1700; Designer Molecules, Inc., San Diego, CA), which has the following structure 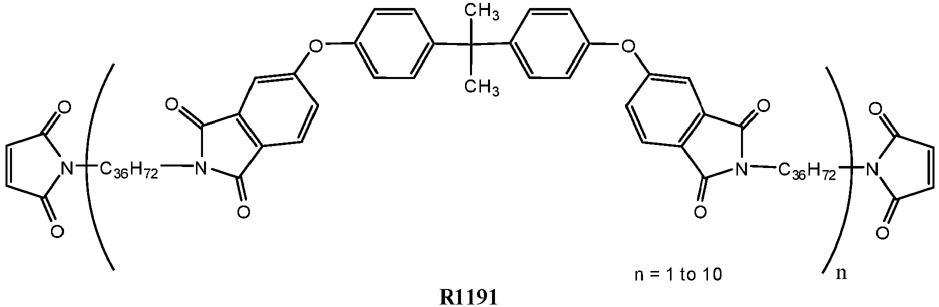 was used as a base resin to examine the effects of amine cure and various epoxy concentrations on adhesion to various substrates in a stud pull test. In the initial Control, **A,** 2% by weight of dicumyl peroxide was dissolved in R1191 to test adhesion using a traditional free-radical cure system. In Control **B,** 4% CUREZOL^{®} 1-B2MZ was dissolved in R1191 to test the adhesion of the BMI resin using anionic cure without the addition of epoxy. Invention Mix **C** included 85% by weight R1191 and 15% by weight of ARALDITE^{®} MY-510 epoxy (Huntsman Corporation: The Woodlands, TX). Invention Mix **D** included 75% by weight R1191 25% ARALDITE^{®} MY-510; and Invention Mix **E** included 65% by weight R1191 and 35% ARALDITE^{®} MY-510. The invention mixes also contained an additional 4% by weight of CUREZOL^{®} 1-B2MZ.

These mixtures were tested for tensile adhesion on four types of substrates (ceramic, aluminum, stainless steel and copper). Each mixture was used to bond ten aluminum studs to freshly cleaned substrates. The parts were cured in the oven for 1 hour at 175°C. Tensile adhesion was then measured on all the parts using a Sebastian III stud pull instrument (Quad Group; Spokane, WA) giving a measurement in pounds force. The test results are shown in **Table 3.**

Invention Mix C with 15% epoxy had the highest adhesion. The free-radically cured BMI performed fairly well, and the anionically cured BMI gave the worst adhesion. Surprisingly, the Invention Mixes with the highest percentages of epoxy showed less adhesion than those with lower percentages on substrates epoxy alone adheres well to. This data demonstrated that the BMI and epoxy cure anionically very well together, but the ratio of epoxy to BMI must be optimized to obtain maximum adhesion.

**Table 3. Average Adhesion R1191/Epoxy Mixtures Pounds Force**

| | **Control A** | **Control B** | **Invention Mix C** | **Invention Mix D** | **Invention Mix E** |
|---|---|---|---|---|---|
| | R1191 | R1191 | R1191 | R1191 | R1191 |
| | No Epoxy | No Epoxy | 15% Epoxy | 25% Epoxy | 35% Epoxy |
| **Substrate** | 2% DCP | 4% 1-B2MZ | 4% 1-B2MZ | 4% 1-B2MZ | 4% 1-B2MZ |
| Ceramic | 109 | 67 | >230 | >230 | 211 |
| Stainless Steel | 162 | 75 | >230 | >230 | >230 |
| Aluminum | 149 | 56 | >230 | 215 | 207 |
| Copper | 81 | 41 | 130 | 108 | 105 |

The BMI-1700 resin used as Control A and Control B homo-cured free-radically and anionically, respectively, as an adhesive on various surfaces. The anionic homo-cure of the BMI-1700 did not perform well. As discussed above, homo-cured BMI's do not have very good tensile strength, which could account for the poor adhesion results seen in this EXAMPLE. The peroxide homo-cured BMI-1700 does well on stainless steel and aluminum, but poorly on ceramic and copper. The addition of epoxy resin to the BMI-1700 significantly improves adhesion at 15% (Invention Mix C), to the maximum value on the tensile tester. Higher amount of epoxy resin (Invention Mixes D and E) appeared to result in lower adhesion than Invention Mix C with 15% epoxy. The surface on which the compositions performed the was copper, which is primarily due to the antioxidant benzotriazole that is coated onto copper surface to prevent oxidation. One advantage of including epoxy resin in the composition is that benzotriazole is a heterocyclic nitrogen compound that can react with epoxy resins and increase adhesion, however, high adhesion was difficult to achieve due to very weak surface layer.

### EXAMPLE 3: Comparison of Compositions Containing Various Rations of BMI to Epoxy

Bismaleimide BMI-689 was combined in various ratios with an Epoxy (EPON^{™}-863, (a low viscosity, difunctional epoxy resin produced from bisphenol-F (BPF) and epichlorohydrin; Hexion, Houston, TX), and the anionic curing catalyst 1-benzyl-2-methylimidazole according to **Table 4** below.

**Table 4: Compositions of BMI-Epoxy**

| | BMI (BMI-689) Wt% of resin | Epoxy (EPON^{™}-863) Wt% of resin | Tensile Strength (Psi) | DSC Exotherms (°C) | TGA (°C) |
|---|---|---|---|---|---|
| No. | Cure Catalyst | | | | |
| | 4% 1-benzyl-2-methylimidazole | | | | |
| | Cured at 185°C. | | | | |
| 1 | 100 | 0 | 260 psi | 156 | N/A |
| 2 | 90 | 10 | 3000 psi | 152 | 438 |
| | | | | 178 | |
| 3 | 75 | 25 | N/A | 149.2 | N/A |
| | | | | 175. | |
| 4 | 66.6 | 33.3 | N/A | 145.50 | N/A |
| | | | | 193.43 | |
| 5 | 50 | 50 | N/A | 131.33 | N/A |
| | | | | 158.41 | |
| 6 | 33.3 | 66.3 | N/A | 119.27 | N/A |
| | | | | 160.83 | |
| 7 | 25 | 75 | N/A | 114.43 | N/A |
| | | | | 157.32 | |
| 8 | 0 | 100 | N/A | 122.2 | N/A |
| | | | | 143. | |

| | | | | | |
|---|---|---|---|---|---|
| N/A = Not Analyzed | | | | | |

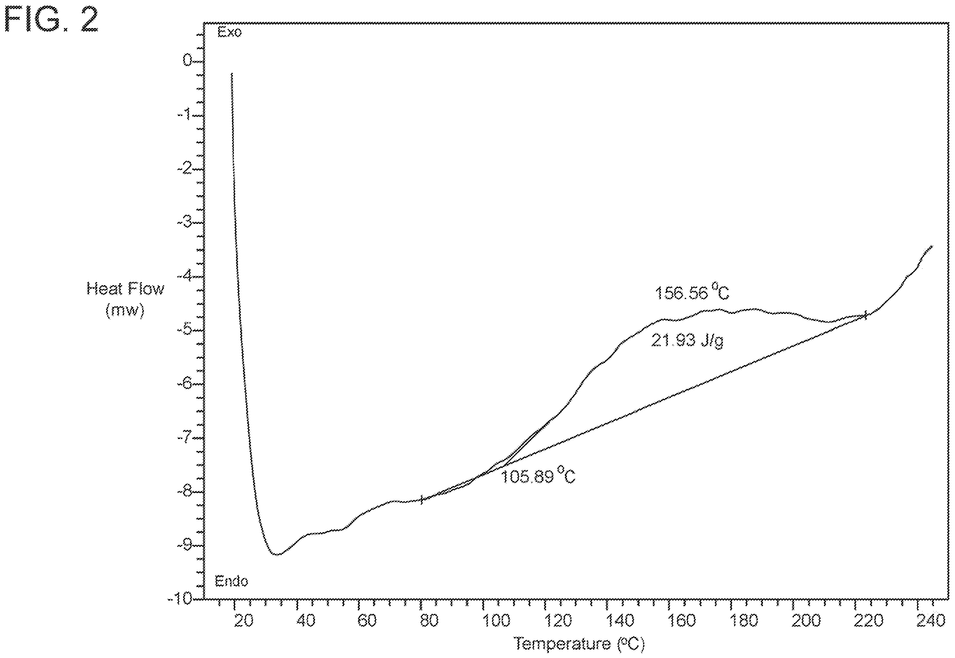

**FIG. 2** shows the DSC cure profile of BMI-689 with 4-wt% 1-benzyl-2-methylimidazole (composition 1). a very low energy broad exotherm is observed at about 156 °C. A sample of composition 1 was cured in an oven at 185 °C for one hour. The sample did not have any surface tackiness, but was soft and pliable. The sample was subjected to a tension test and was determined to have a tensile strength of about 260 psi.

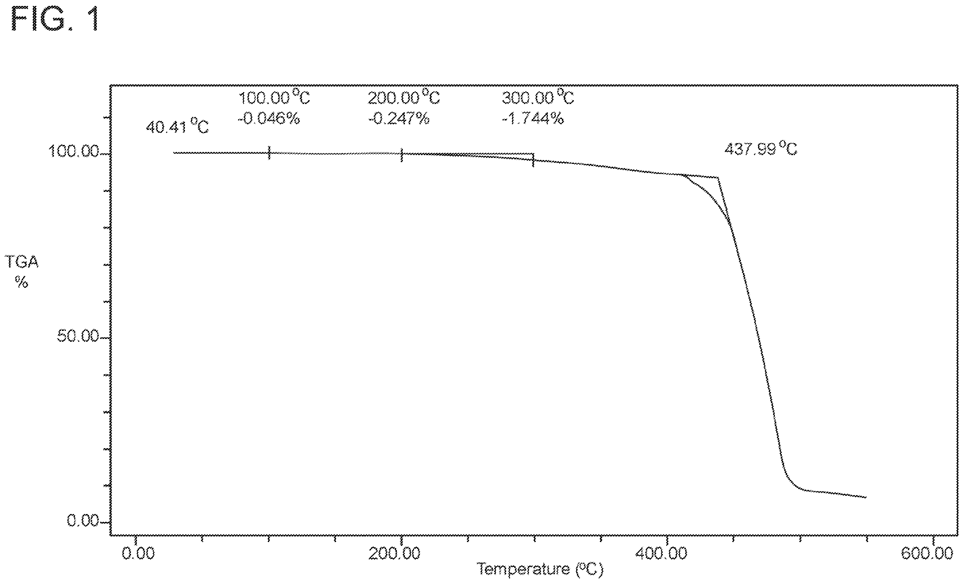

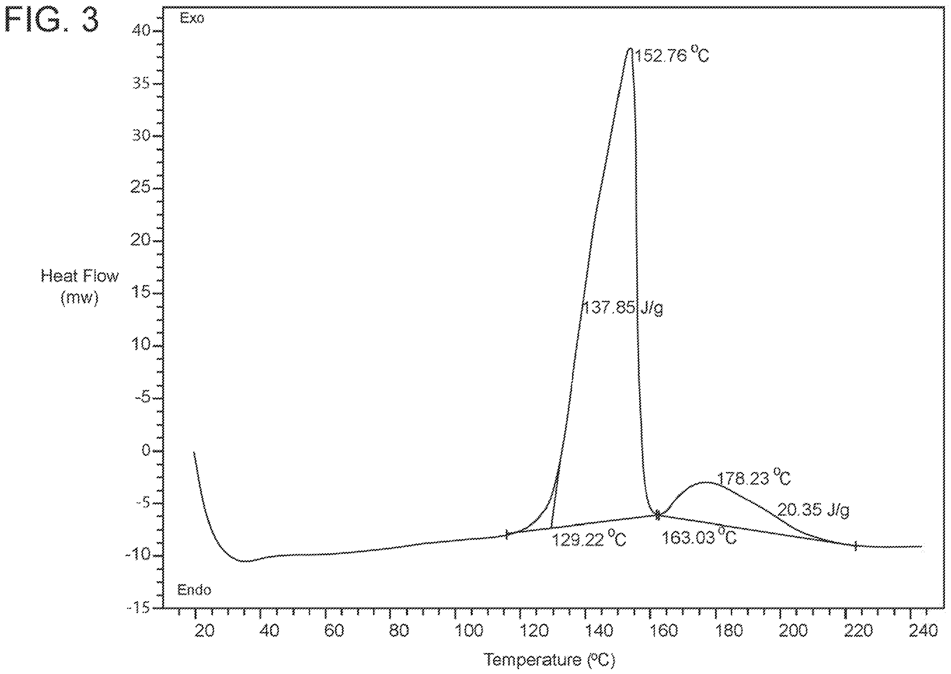

The anionic cure of 90-wt% BMI-689 and 10-wt% EPON-863 epoxy resin with 4-wt% 1-benzyl-2-imidazole (composition 2) leads to a very different cure profile. **FIG. 3** shows the DSC trace of a sample of composition 2, a very sharp, high energy exotherm was observed at about 152 °C, with a small secondary bump at about 178 °C. This material was also cured in the oven at 185 °C for one hour. The sample was very hard, yet was bendable and was determined to have a tensile strength of about 3,000 psi. With just 10% epoxy resin added to the BMI-689 the tensile strength was increased more than tenfold. The sample was subjected to TGA analysis to determine the thermal stability of the thermoset. The TGA analysis of composition 2 in **FIG. 1** shows that the material is very thermally stable with an onset of decomposition at about 438°C.

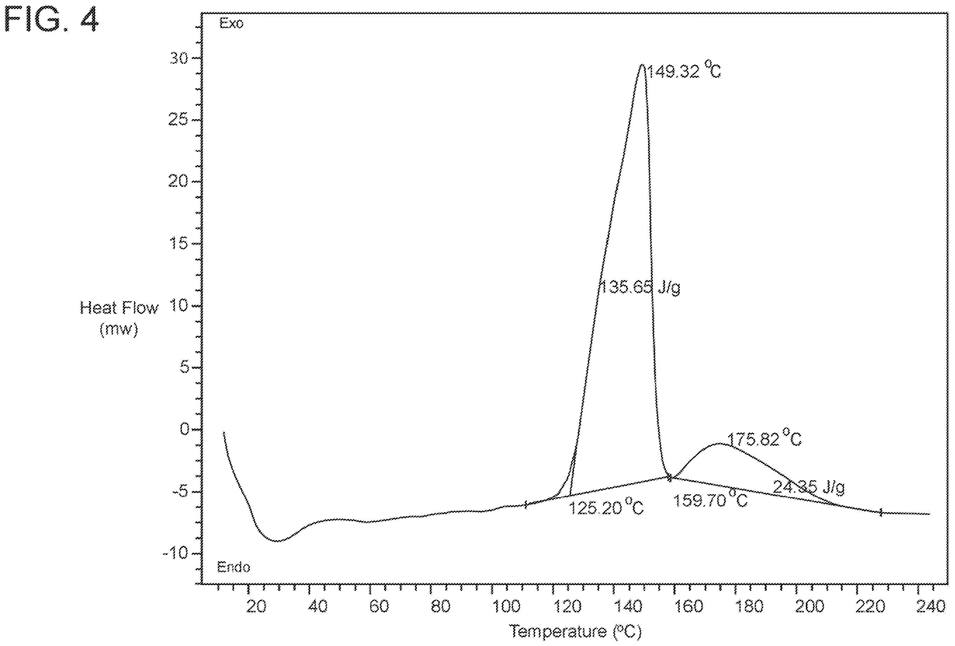

The same experiment was continued with additional epoxy resin added to the BMI-689 to determine the effects of a higher amount of exoxy on cure profile. **FIG. 4** shows the DSC analysis of a mixture of 3 equivalents of BMI-689 and 1 equivalent of EPON-863 epoxy resin with 4-wt% 1-benzyl-2-methylimidazole (composition 3). The addition of more epoxy resin appears to have shifted the cure peak down by about 3-4 °C.

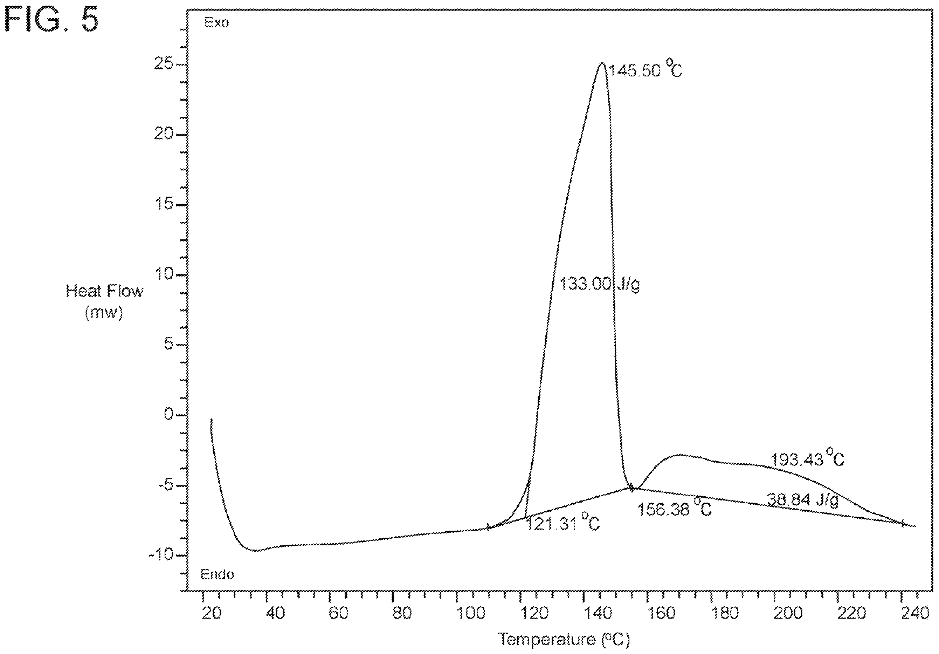

**FIG. 5** shows the DSC analysis for a mixture of 2 equivalents of BMI-689 and 1 equivalent of EPON-863 epoxy resin (composition 4). The addition of more epoxy resin appears to have shifted the cure peak down by an additional 3-4 °C compared to composition 3. The secondary peak appeared to be increasing.

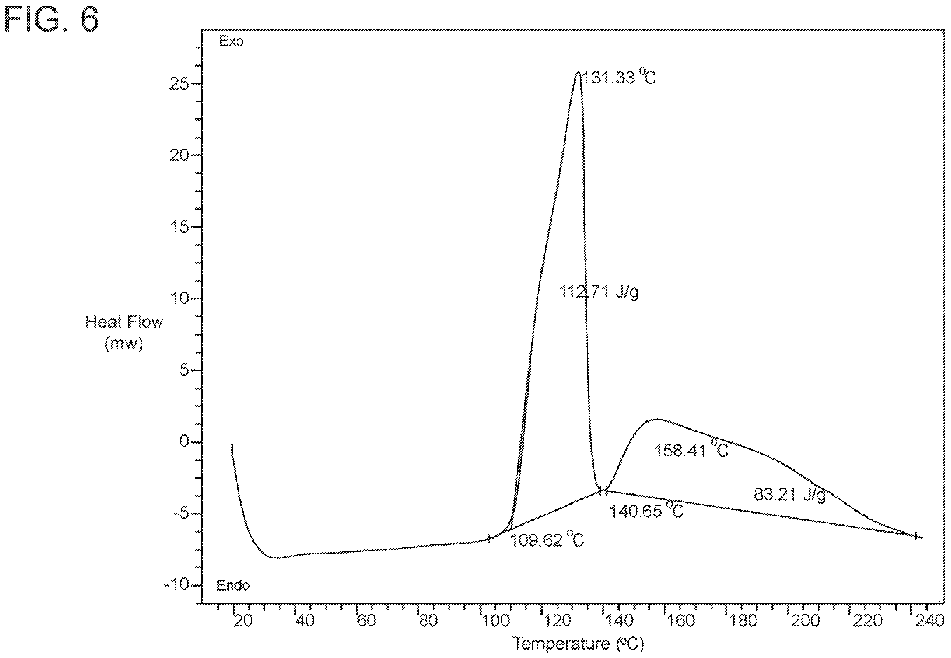

**FIG. 6** shows the DSC analysis for 1:1 equivalent mixture of the BMI/epoxy (composition 5), which further shifted the cure peak shifts down several degrees, while the secondary peak was even larger than that for composition 4.

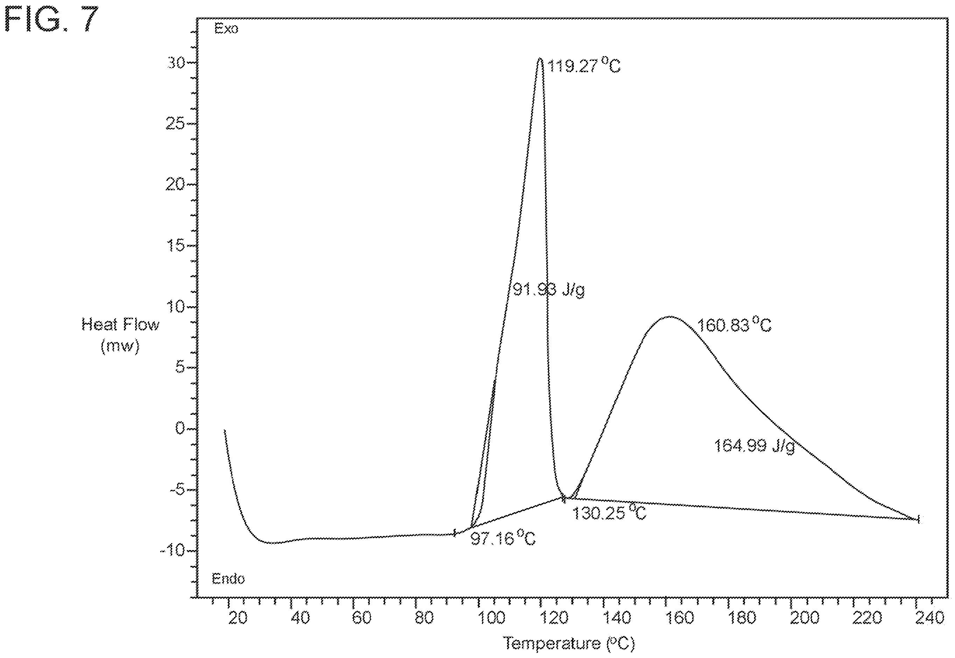

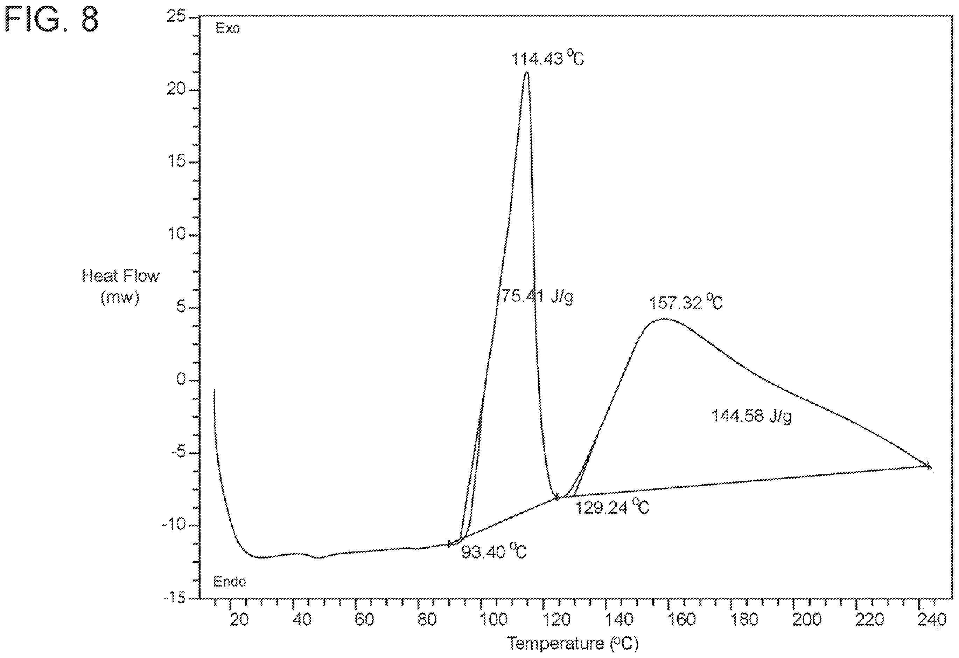

**FIG. 7** shows the DSC analysis of 1 equivalent of BMI with 2 equivalents of epoxy resin (composition 6). **FIG. 8** shows the DSC analysis of 1 equivalent of BMI with 3 equivalents of epoxy resin (composition 6).. The cure peak continued to shift to lower temperature of the more epoxy resin was added, and two clear peaks were observed in these samples which included more epoxy than BMI.

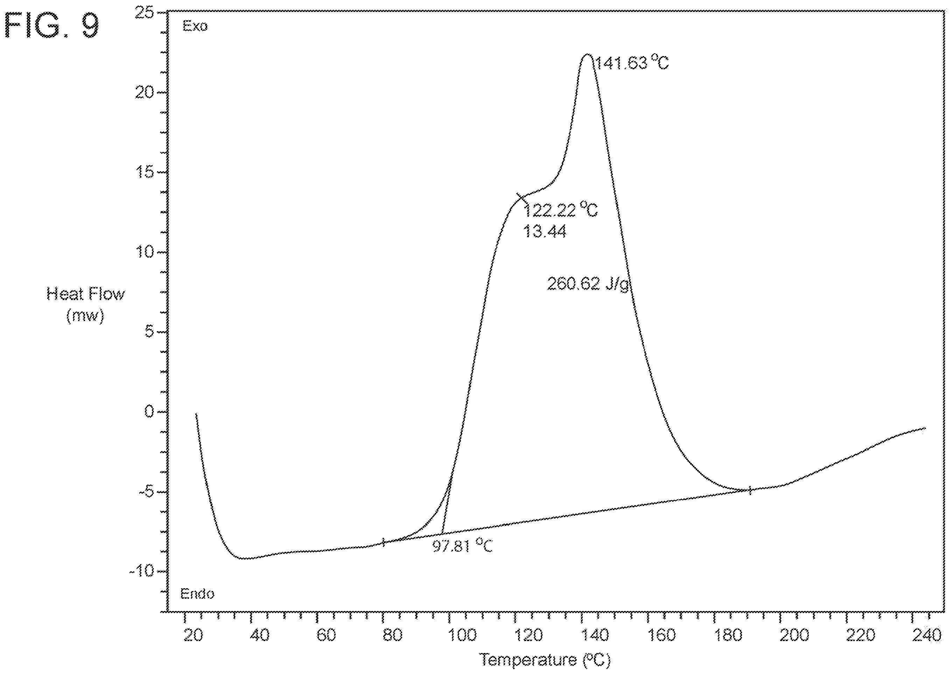

**FIG. 9** shows the DSC analysis of EPON-863 epoxy resin with 4-wt% 1-benzyl-2-methylimidazole (composition 8). The pure epoxy anionic cure shows two apparent overlapping peaks with a peak max at about 141 °C.

Without wishing to by bound by any theory, limited evidence has suggested that an anionic curing initiator, such as an imidazole, may form a complex with a maleimide moiety, which may be a zwitterionic species that can act as a catalyst for the epoxy reaction. This theory is supported by the observation that DSC analysis shows the lowering of the exothermic peak temperature. Curing the BMI alone with an imidazole produces one or two very broad low energy bumps on the DSC. The addition of a small amount of epoxy resin produces a high-energy, sharp exothermic peak on DSC, and the temperature of the cure peak is lower than that of the imidazole with epoxy alone.

Analysis of the cured thermosets shows no signs of phase separation, which indicates that the two materials cure together. Also analysis of the cured thermoset using TGA shows very high temperature stability with virtually no weight loss below 300 °C. If uncured resin were present it would show up as weight loss in the TGA analysis.

### EXAMPLE 4: High Stability BMI-Epoxy Composition

In a cup, 5 g of the bismaleimide of dimer diamine was mixed with 5 g of diglycidyl ether of bisphenol-F. To the solution was added 0.5 g of CUREZOL^{®} 1B2MZ; and the material was thoroughly degassed under nitrogen. The resin was poured into mold and heated in an oven for 1 hour at 175° C. The thermoset produced was analyzed using TGA and TMA. The material was found to be very temperature stable, with the onset of decomposition of over 400° C, and a T_{g} of 70° C.

### EXAMPLE 5: Underfill Type Formulation

To a cup was added 4 g of the bismaleimide of bis(4-amino-3-methylcyclohexyl)methane, 2.5 g of bisphenol-A diglycidyl ether, 2.5 g of tricyclodecane dimethanol diacrylate, 0.5 g of tris(2-hydroxyethyl)isocyanurate triacrylate and 0.5 g of t-butylstyrene. The materials were thoroughly mixed to give a homogeneous solution to which was added 0.4 g of CUREZOL^{®} 1B2MZ. The viscosity of the material was measured at about 1000 cPs. The material was degassed and placed in an oven to cure for 1 hour at 175°C. The cured material was analyzed by TMA and was found to have a T_{g} of about 132°C and a CTE of about 60 ppm below the T_{g}. The TGA analysis of material showed less than 1% weight loss at 200°C and an onset of decomposition of over 350°C. The material was therefore suitable for use as an underfill.

### EXAMPLE 6: Low Modulus Adhesive for BT-Copper Laminates

Maleimide terminated polyimide (BMI-1500), which has the following formula 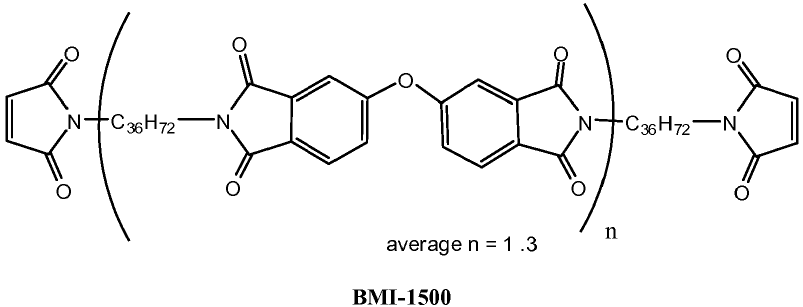 along with 2% dicumyl peroxide, was thoroughly degassed and placed on a bismaleimide-triazine (BT) composite followed by the placement of copper foil. The sandwiched material was laminated and cured up to 200°C. Analysis of the laminate showed that the adhesive layer had delaminated from both surfaces but especially from the BT surface.

The BMI-1500 (80% by weight) and diglycidyl ether of bisphenol-A (20% by weight) were added together and to the mixture was added 5% of CUREZOL-1B2MZ. The compounds were thoroughly mixed and degassed to form a homogeneous solution. The solution was applied to the BT composite and copper foil applied followed by lamination and cure at up to 200°C. The cured laminate was very flexible and showed complete adhesion to both surfaces with no signs of delamination from either surface, demonstrating the advantage of including an epoxy and anionic cure to the laminate adhesive for preparation of copper laminates.

### EXAMPLE 7: Flexible Copper Clad Laminate (FCCL) Type Adhesive

FM30-183 maleimide terminated polyimide based on M-DEA, bisphenol-A dianhydride and pyromellitic dianhydride (80% by weight) having the following formula: 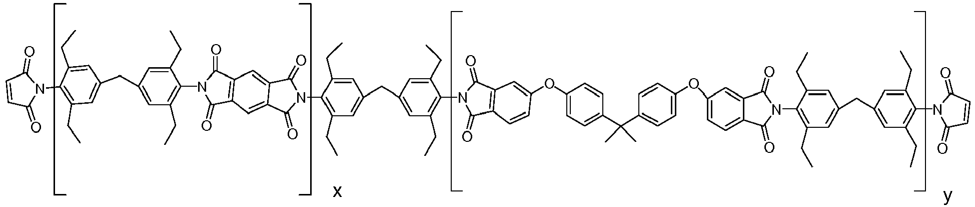 wherein x and y are relative mole percentages between 0-100. For this specific example x is 35% and y is 65%
was mixed with Tactix-556 (20% by weight; Huntsman) along with 4% by weight of CUREZOL^{®}-2MZ-Azine. The solids were dissolved in a mixture of cyclohexanone and tetralin. The materials was degassed, poured in 4°×°4 inch molds, and placed in an oven at 100°C for several hours to evaporate the solvent slowly. This was followed by a gradual increase in temperature over several hours to about 250°C to completely remove the solvents and cure the resin. Analysis of the thin sheets showed that the material had a dielectric constant of 2.58. The T_{g} of the material was measured at about 221°C, with a CTE below the T_{g} of about 58 ppm.

### EXAMPLE 8: Electromagnetic Shielding Coating

BMI-689 (60% by weight) was placed in a cup along with trimethylolpropane triglycidyl ether (40% by weight). To the solution was added 4% by weight of CUREZOL^{®} 1B2MZ, the solution was thoroughly mixed, degassed and placed in a Teflon mold. The material was cured in an oven for 20 minutes at 100°C. The material appeared to be cured thoroughly producing a tough, leathery thermoset with no evidence of surface oxygen inhibition.

In another formulation (60% by weight) of BMI-689 was placed in a cup along with diglycidyl ether of bisphenol-A (25% by weight) and diglycidyl ether of 1,4-butanediol (15% by weight). To the solution was added 4% by weight of CUREZOL^{®} 1-B2MZ. The solution was placed in a mold, degassed, and cured for 20 minutes at 100°C. This material cured up into a very tough thermoset with no surface evidence of surface oxygen inhibition.

These solutions prior to curing have a viscosity of around 500 cPs. To the uncured formulation copper alloy powder and solvent (e.g. ethyl acetate) are added, and the material is sprayed onto the back of a sensitive electronics device (e.g. cell phones) and cured at low temperatures to act as a conformal coating that also provides electromagnetic shielding.

### EXAMPLE 9: Die-attach Adhesive for All Lead Frames

In a cup was added 0.3 g of CUREZOL^{®} 2PZ along with 1.5 g of Ardalite^{®} MY-510. The two materials were thoroughly mixed, and then 6.1 g of BMI-689 was added and stirred, along with 2.0°g of SR833 S (tricyclodecane dimethanol diacrylate; Sartomer). To the solution was added 0.05 g of methacryloxypropyl trimethoxysilane along with 0.05°g of glycidyl propyl trimethoxysilane. This solution was mixed with silver flake (83% by weight), the mixture was stirred and placed on a three roll mill to thoroughly mix. The viscosity of the material was about 9,000 cPs at 5 rpm, with a thixotropic index 0.5 rpm/5 rpm of about 4.5.

The paste was used as an adhesive for 150 × 150 mil die on copper lead frames. The parts were cured in an oven ramped up to 175°C and held for 1 hour. **Table 5** summarizes the data generated for this material.

**Table 5 Anionic Cured BMI/Epoxy Die-Attach Adhesive on Copper Lead Frames**

| **Average Properties of Uncured Material** | |
|---|---|
| Silver Loading | 83% |
| Thixotropic Index (0.5/5 rpm) | 4.5 |
| Viscosity 5 rpm | 9000 cPs |
| Work Life @25°C | > 72 hrs |
| Typical Cure Schedule | ramp to 175°C; hold 1 hr |

| **Average Properties of Cured Material** | |
|---|---|
| Glass Transition Temperature | Approximately 75°C |
| Weight Loss @ 300°C | < 1% |
| Volume Resistivity (ohms-cm) | 0.00008 |

| **Average Performance of Cured Material** | |
|---|---|
| Die Shear Strength | |
| Copper Lead Frames | |
| 150x150 mil Si die | |
| @25°C | 67.3 Kg-force |
| @260°C | 5.2 Kg-force |
| @25 °C after 85/85 | 65.2 Kg-force |
| @25 °C after PCT | 54.3 Kg-force |

he die-attach paste formulation had very high adhesion on copper lead frames that are the toughest to stick to due to antioxidant (benzotriazole) on the surface. Furthermore, the die-attach based on BMI/epoxy anionic cure is the only material known at the time of the invention that has adhesion at 260°C and still passes the PCT test by retaining adhesion with no delamination.

In a cup was added 0.3 g of CUREZOL^{®}-2PZ along with 1.5 g of Araldite MY-510 and 2.6 g of butanediol diglycidyl ether. The mixture was stirred to dissolve the powder. To the solution was added 2.5 g of BMI-1400, SR833S (3.0 g), glycidoxypropyltrimethoxysilane (0.05 g) and methacryloxypropyltrimethoxysilane (0.05 g). This solution was added to silver flake (83 wt%), stirred and placed on a mill to completely blend. The properties of this die attach paste are summarized in **Table 6** below.

**Table 6. Properties of Die Attach Paste 2**

| | |
|---|---|
| viscosity @5 rpm | 7440 cps |
| thixotropic index 0.5/5 rpm | 4.98 |
| die shear strength copper lead frames 150x150 mil die average adhesion @25 °C | 46.6 Kg-force |

### EXAMPLE 11. Die Attach Formulation 3

In a cup was added 0.3 g of Curezol-2PZ along with 1.5 g of Araldite MY-510 and 2.6 g of butanediol diglycidyl ether. The mixture was stirred to dissolve the powder. To the solution was added 2.5 g of BMI-1500, SR833S (3.0 g), glycidoxypropyltrimethoxysilane (0.05 g) and methacryloxypropyltrimethoxysilane (0.05 g). This solution was added to silver flake (83 wt%), stirred and placed on a mill to completely blend. The properties of this die attach paste are summarized in Table 7 below.

**Table 7. Properties of Die Attach Paste 3**

| | |
|---|---|
| viscosity @5 rpm | 10,355 cps |
| thixotropic index 0.5/5 rpm | 4.40 |
| die shear strength copper lead frames 150x150 mil die average adhesion @25 °C | 43.1 Kg-force |

### EXAMPLE 12: Shrinkage

In order to test the theory that addition of epoxy to BMI might result in lower shrinkage than BMI alone, shrinkage was compared in BMI that was free-radically cured and BMI cured anionically with the addition of exoxy. BMI-689 was cured via free-radical reaction (2% by weight of dicumyl peroxide), and BMI-689 in combination with 25 wt% EPON^{™}-863 epoxy resin was cured with 1-benzyl-2-methylimidazole. The BMI-689 free-radical cured thermoset was found to have 7.6% volume shrinkage. The BMI-689 with 20% epoxy resin and cured anionically with 4% catalyst was surprisingly found to have a volume shrinkage of 9.8%. This was a very unexpected result, but this could explain why these materials cure so well together based as evidenced by the DSC results shown in FIGs 2-9. This could also explain why in the die attach formulation **(EXAMPLE 9)** the volume resistivity of the composition was so low at 0.00008 ohm-cm at only 83wt% silver loading. Typically conductive die attach formulations at best have volume resistivities of 0.0002 with 85wt% or greater amount of silver loading.

### EXAMPLE 13: Co-cure Silicone

Functionalized polydimethylsiloxane resins (silicones) are notorious for absorbing oxygen, anytime they are reacted with BMI resins under free-radical conditions. In the oven the material does not cure at all due to oxygen inhibition. Previously, the only way to cure these has been to place them in a vacuum oven or under nitrogen or argon.

BMI-689 was mixed with 20% epoxy functionalized polydimethylsiloxane and cured under anionic conditions, with 4% 1-benzyl-2-methylimidazole catalyst. The composition cured very well in an oven at 175 °C for one hour and produced a flexible thermoset that had a voltage breakdown of about 40 kV/mm. This type of material could be of use as a coil impregnation varnish for transformers and electric motors.

## Claims

1. A curable adhesive composition, comprising:
(a) a maleimide component comprising at least one maleimide which is a maleimide terminated polyimide that is the condensation product of contacting a diamine with a dianhydride;
(b) an epoxy component comprising at least one epoxy; and
(c) at least one anionic curing catalyst,
with the proviso that no free-radical initiator is added to the composition.

2. The curable adhesive composition according to claim 1, further comprising at least one filler, at least one reactive diluent, or a combination thereof.

3. The curable adhesive composition according to claim 1, wherein the maleimide component comprises a bismaleimide of saturated or unsaturated dimer diamine.

4. The curable adhesive composition of claim 1, wherein the maleimide component is a compound having a structure selected from the group consisting of: 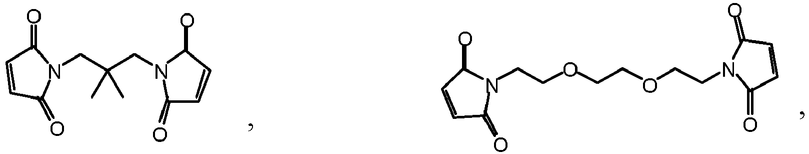 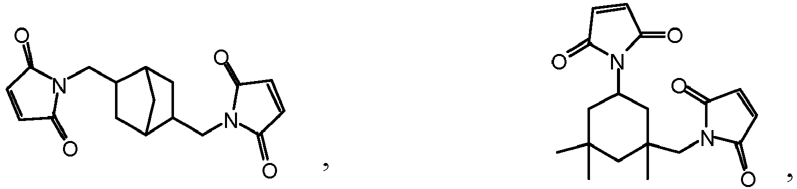 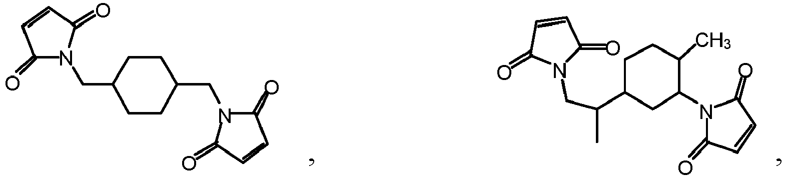 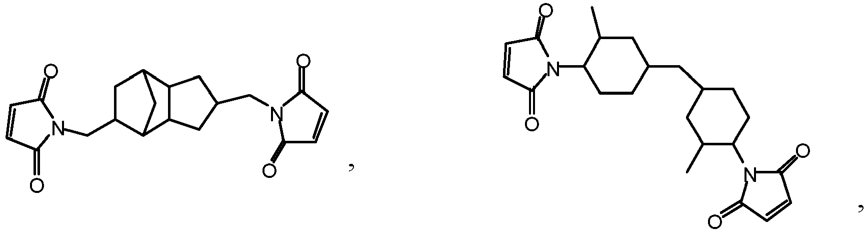 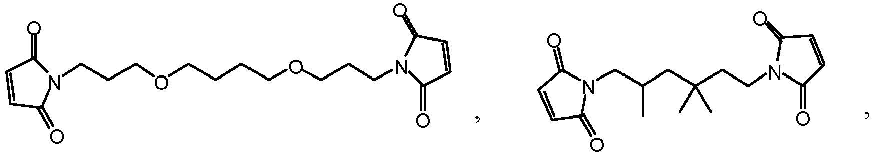 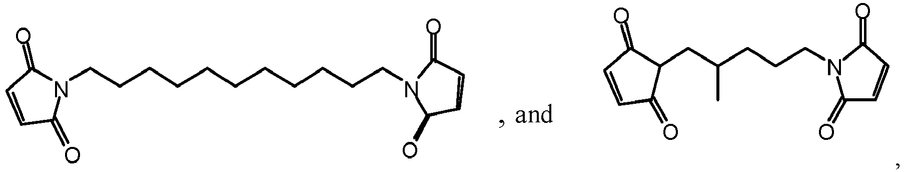 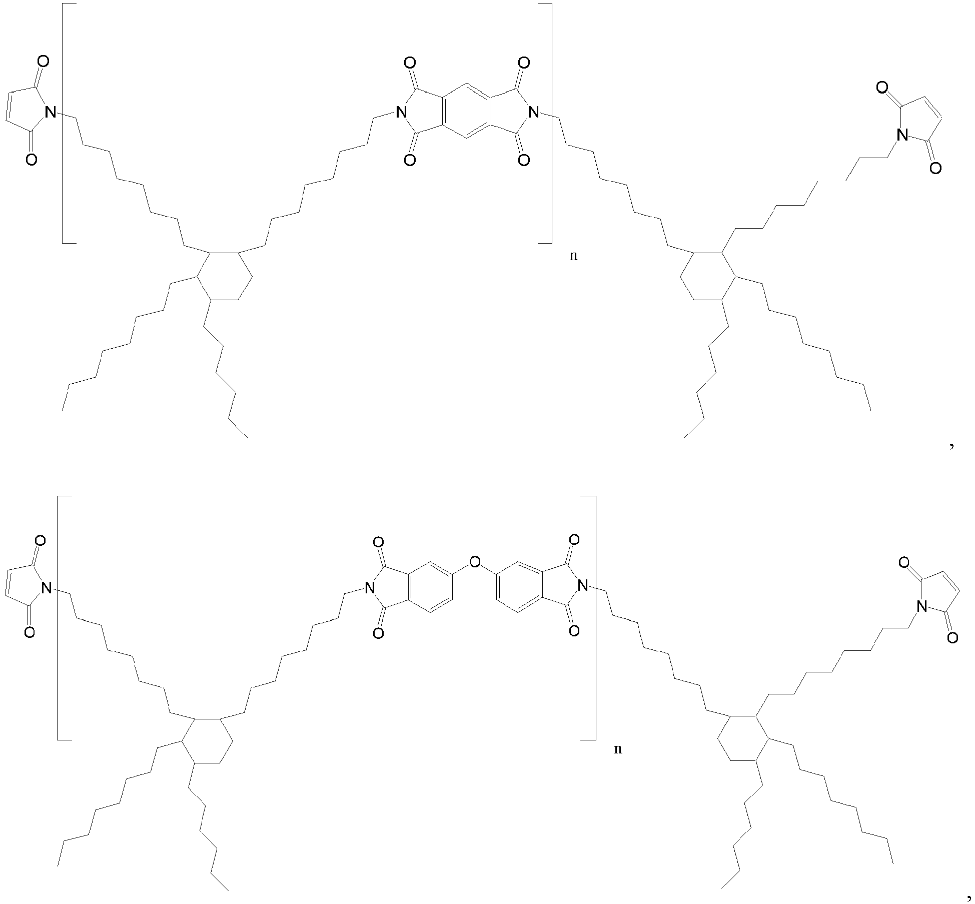 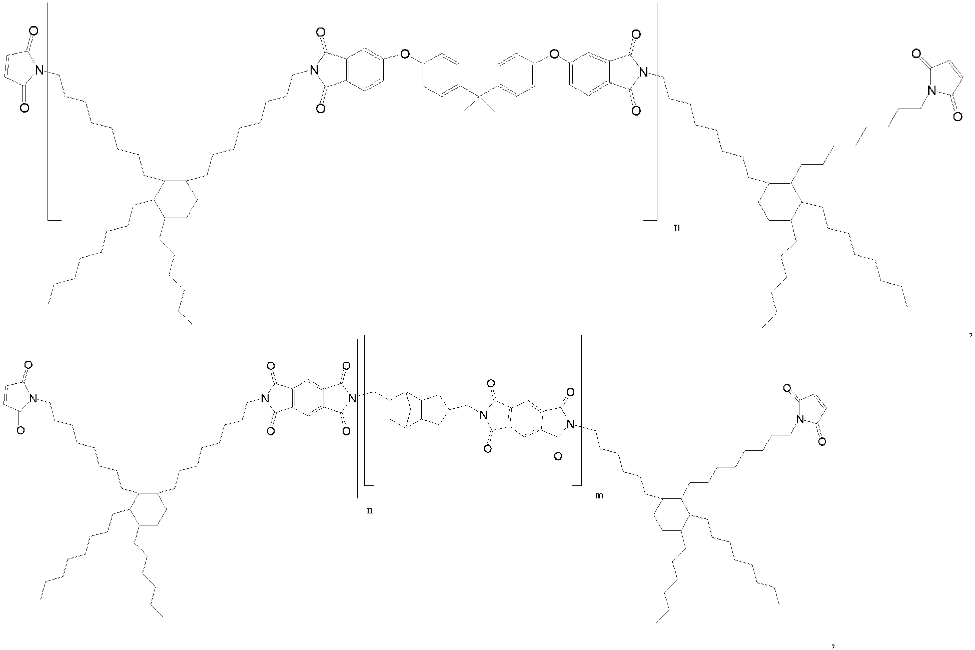 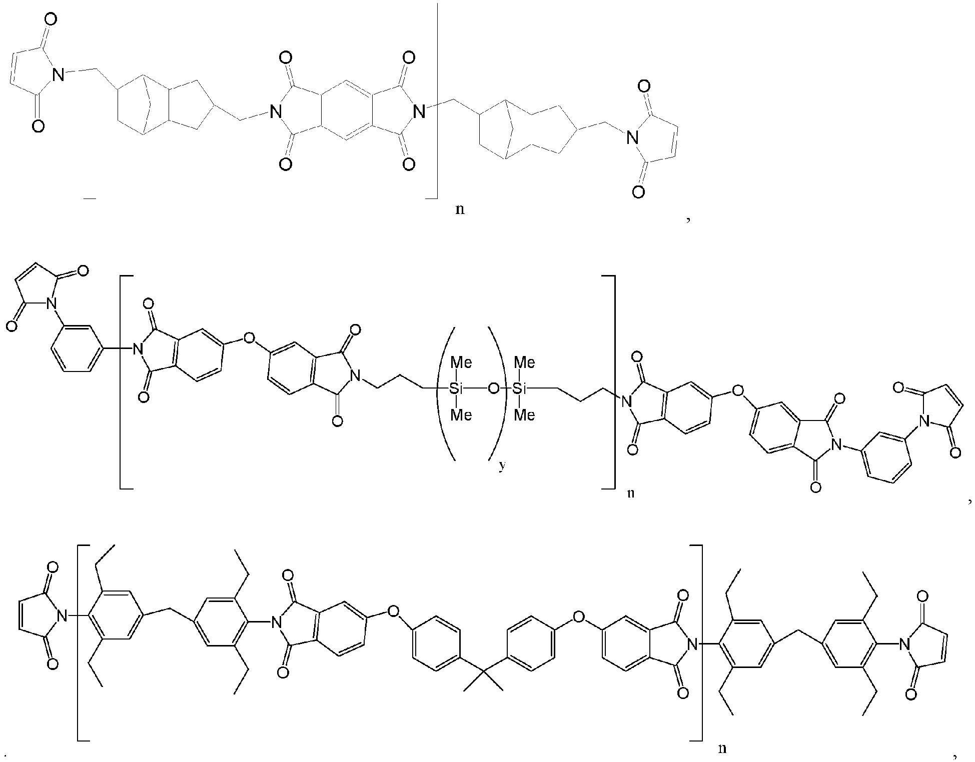 and

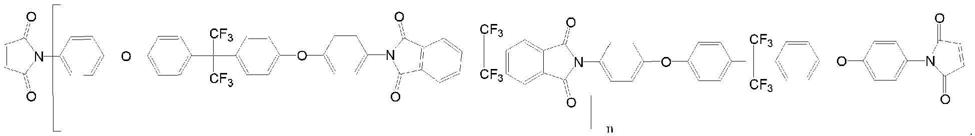

5. The curable adhesive composition according to claim 1, wherein the at least one maleimide is a maleimide-terminated polyimide having a structure according to the formula: 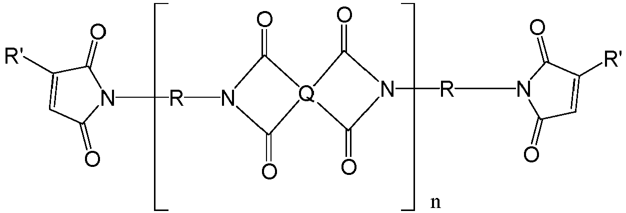 wherein:
R' is H or methyl;
R and Q are each independently substituted or unsubstituted aliphatic, cycloaliphatic, aromatic, heteroaromatic, polyether, or siloxane moieties; and
n is 1 to 10.

6. The curable adhesive composition according to claim 1, wherein the epoxy component is selected from the group consisting of: a phenyl glycidyl ether; a cresyl glycidyl ether; a nonylphenyl glycidyl ether; a p-tert-butylphenyl glycidyl ether; a diglycidyl or polyglycidyl ether of any of:
bisphenol A, bisphenol F, ethylidenebisphenol, dihydroxydiphenyl ether, bis(4-hydroxyphenyl)sulfone, bis(hydroxyphenyl)sulfide, 1,1-bis(hydroxyphenyl)cyclohexane, 9,19-bis(4-hydroxyphenyl)fluorene, 1,1,1-tris(hydroxyphenyl)ethane, tetrakis(4-hydroxyphenyl)ethane, trihydroxytritylmethane, 4,4'-(1-alpha-methylbenzylidene)bisphenol, 4,4'-dihydroxybenzophenone, dihydroxy naphthalene, 2,2'-dihydroxy-6,6'-dinaphthyl disulfide, a 1,8,9-trihydroxyanthracene, resorcinol, catechol and tetrahydroxydiphenyl sulfide;
triglycidyl-p-aminophenol; N,N,N',N'-tetraglycidyl-4,4'-diphenylmethane; triglycidyl isocyanurate; a glycidyl ether of a cresol formaldehyde condensate; a glycidyl ether of a phenol formaldehyde condensate; a glycidyl ether of a cresol dicyclopentadiene addition compound; a glycidyl ether of a phenol dicyclopentadiene addition compound; a diglycidyl ether of 1,4 butanediol; a diglycidyl ether of diethylene glycol; a diglycidyl ether of neopentyl glycol; a diglycidyl ether of cyclohexane dimethanol; a diglycidyl ether of tricyclodecane dimethanol; a trimethyolethane triglycidyl ether; a trimethyol propane triglycidyl ether; a glycidyl ether of a polyglycol; a polyglycidyl ether of castor oil; a polyoxypropylene diglycidyl ether; a glycidyl derivative of an aromatic amine; a N,N-diglycidyl-4-glycidyloxyaniline; an epoxy-terminated polydimethylsiloxane; and an epoxy functionalized cyclosiloxane.

7. The curable adhesive composition according to claim 1, wherein the epoxy component comprises 1 to 90 weight % based on the total weight of the resin composition.

8. The curable adhesive composition according to claim 1, wherein the at least one anionic curing catalyst is selected from the group consisting of: imidazole; 1-benzyl-2-phenylimidazole (1B2PZ); 1-benzyl-2-methylimidazole (1B2MZ); 2-phenyl-4-methylimidazole (2P4MZ); 2-phenylimidazole (2PZ); 2-ethyl-4-methylimidazole (2E4MZ); 1,2-dimethylimidazole (1.2DMZ); 2-heptadecylimidazole (C17Z); 2-undecylimidazole (C11Z); 2-methylimidazole (2MZ); imidazole (SIZ); 1-cyanoethyl-2-methylimidazole (2MZ-CN); 1-cyanoethyl-2-undecylimidazole (C11Z-CN); 1-cyanoethyl-2-ethyl-4-methylimidazole (2E4MZ-CN); 1-cyanoethyl-2-phenylimidazole (2PZ-CN); 1-cyanoethyl-2-phenylimidazolium-trimellitate (2PZCNS-PW); 1-cyanoethyl-2-undecylimidazolium-trimellitate (C11Z-CNS); 2,4-diamino-6-[2'-ethyl-4'-methylimidazolyl-(1')]-ethyl-s-triazine (2E4MZ-A); 2,4-diamino-6-[2'-undecylimidazolyl-(1')]-ethyl-s-triazine (C11Z-A); 2,4-diamino-6-[2'-methylimidazolyl-(1')]-ethyl-s-triazine (2MZA-PW); 2,4-diamino-6-[2'-methylimidazolyl-(1')]-ethyl-s-triazine (2MZ-A); 2-phenylimidazoleisocyanuric acid adduct (2PZ-OK); 2,4-diamino-6-[2'-methylimidazolyl-(1')]-ethyl-s-triazineisocyanuric acid adduct dehydrate (2MA-OK); 2-phenyl-4-methyl-5-hydroxymethylimidazole (2P4MHZ-PW); 2-phenyl-4,5-dihydroxymethylimidazole (2PHZ-PW); 1-dodecyl-2-methyl-3-benzylimidazolium chloride (SFZ); 2,3-dihydro-1H-pyrrolo[1,2-a]benzimidazole (TBZ); 2-phenylimidazoline (2PZL-T); 2,4-diamino-6-methacryloyloxyethyl-1,3,5-triazine (MAVT); 2,4-diamino-6-vinyl-1,3,5-triazineisocyanuric acid adduct (OK); 2,4-diamino-6-vinyl-1,3,5-triazine (VT); Imidazole-4-carboxaldehyde (4FZ); 2-Phenylimidazole-4-carboxaldehyde (2P4FZ); Imidazole-2 carboxaldehyde (2FZ); Imidazole-4-carbonitrile (4CNZ); 2-Phenylimidazole-4-carbonitrile (2P4CNZ); 4-Hydroxymethylimidazolehydrochloride (4HZ-HCL); 2-Hydroxymethylimidazolehydrochloride (2HZ-HCL); Imidazole-4-carboxylic acid (4GZ); Imidazole-4-dithiocarboxylic acid (4SZ); Imidazole-4-thiocarboxamide (4TZ); 2-Bromoimidazole (2BZ); 2-Mercaptoimidazole (2SHZ); 1,2,4-Triazole-1-carboxamidinehydrochloride (TZA); (t-Butoxycarbonylimino-[1,2,4]triazol-1-yl-Methyl)-carbamic acid t-butyl ester (TZA-BOC); Thiazole-2-carboxaldehyde (2FTZ); Thiazole-4-carboxaldehyde (4FTZ); Thiazole-5-carboxaldehyde (5FTZ); Oxazole-2-carboxaldehyde (2FOZ); Oxazole-4-carboxaldehyde (4FOZ); Oxazole-5-carboxaldehyde (5FOZ); Pyrazole-4-carboxaldehyde (4FPZ); Pyrazole-3-carboxaldehyde (3FPZ); 1-azabicyclo[2.2.2]octane (ABCO); 1,4-diazabicyclo[2.2.2]octane (DABCO); 1,5-diazabicyclo[4.3.0]non-5-ene (DBN); 1,8-diazabicyclo[5.4.0]undec-7-ene (DBU); 1,5,7-triazabicyclo[4.4.0]dec-5-ene(TBD); 7-methyl-1,5,7-triazabicyclo[4.4.0]dec-5-ene (MTBD); 1,2,2,6,6-pentamethylpiperidine (PMP); and4-(dimethylamino)-1,2,2,6,6-pentamethylpiperidine.

9. The curable adhesive composition according to claim 1, wherein the at least one anionic curing catalyst comprises 0.1 to 10 weight % based on the total weight of the resin composition.

10. The curable adhesive composition according to claim 2, wherein the at least one reactive diluent is selected from the group consisting of acrylates, methacrylate, styrenics, isopropenylbenzene derivatives, acrylamides, methacrylamides, maleates, cinnamates, vinyl pyridine; aldehydes; episulfides, cyclosiloxanes, oxetanes, lactones, acrylonitrile, cyanoacrylates, vinyl ketones, acrolein, vinyl sulfones, vinyl sulfoxides, vinyl silanes, glycidol, and isocyanates.

11. The curable adhesive composition according to claim 2, wherein the at least one reactive diluent comprises 0 to 30 weight % based on the total weight of the curable adhesive composition.

12. The curable adhesive composition according to claim 2, wherein the at least one filler is selected from the group consisting of silica, perfluorocarbons, mica, carbon, silver, silver alloys, copper alloys, metal alloys, boron nitride, polyhedral oligomeric silsesquioxanes, calcium carbonate, or
a curable adhesive composition of claim 2, wherein the composition is an electrically insulating adhesive comprising an insulating filler selected from the group consisting of polysiloxanes, fumed silica, fumed alumina, fumed titanium dioxide, calcium carbonate, poly perfluorocarbons, silica, graphite, boron nitride, and polytetrafluoroethylene in which the curable adhesive composition is suitable for bonding copper foil together to form a low dielectric flexible copper clad laminate and wherein a cured aliquot of the composition has a dielectric constant below about 3.9, a T_{g} of at least about 150°C, and a CTE less than about 60 ppm/°C.

13. The curable adhesive composition according to claim 2, wherein the at least one filler comprises about 0 to 90 weight% based on the total weight of the composition.

14. A method for increasing the adhesion of a maleimide-containing composition comprising:
(a) adding an epoxy to the maleimide-containing composition of claim 1;
(b) replacing any free-radical initiators in the composition with at least one anionic cure catalyst, thereby increasing the adhesion of a maleimide-containing composition.

15. A curable adhesive composition according to claim 1,
wherein the maleimide component is a bismaleimide component and the at least one maleimide is a bismaleimide, the curable adhesive composition is an electrically conductive die attach adhesive composition
the curable adhesive composition further comprising:
(d) at least one acrylic reactive diluent;
(e) a silver filler; and
(f) at least one silane coupling agent, wherein the curable adhesive composition is an electrically conductive die attach adhesive composition.

16. The curable adhesive composition of claim 15, wherein the acrylic reactive diluent is tricyclodecane dimethanol diacrylate.

17. The curable adhesive composition of claim 15, wherein the silane coupling agents are selected from the group consisting of aminopropyltrimethoxysilane, acryloxypropyltrimethoxysilane, methacryloxypropyltrimethoxysilane, glycidoxypropyltrimethoxysilane, (3,4-epoxycyclohexyl)ethyltrimethoxysilane, and N-phenylaminopropyltrimethoxysilane.

## Patentansprüche

1. Eine härtbare Klebstoffzusammensetzung, die Folgendes beinhaltet:
(a) einen Maleimidbestandteil, der mindestens ein Maleimid beinhaltet, das ein maleimidterminiertes Polyimid ist, das das Kondensationsprodukt des In-Kontakt-Bringens eines Diamins mit einem Dianhydrid ist;
(b) einen Epoxidbestandteil, der mindestens ein Epoxid beinhaltet; und
(c) mindestens einen anionischen härtbaren Katalysator,
mit der Maßgabe, dass der Zusammensetzung kein Radikalinitiator zugegeben wird.

2. Härtbare Klebstoffzusammensetzung gemäß Anspruch 1, die ferner mindestens einen Füllstoff, mindestens einen Reaktivverdünner oder eine Kombination davon beinhaltet.

3. Härtbare Klebstoffzusammensetzung gemäß Anspruch 1, wobei der Maleimidbestandteil ein Bismaleimid von gesättigtem oder ungesättigtem Dimerdiamin beinhaltet.

4. Härtbare Klebstoffzusammensetzung gemäß Anspruch 1, wobei der Maleimidbestandteil eine Verbindung ist, die eine Struktur aufweist, die aus der Gruppe ausgewählt ist, die aus Folgendem besteht: 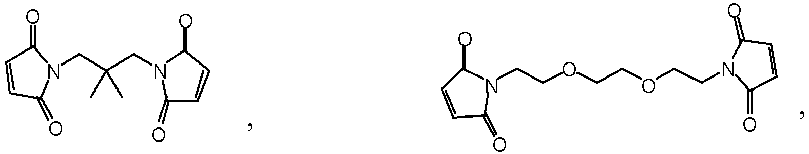 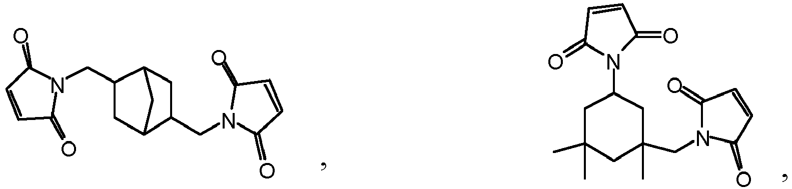 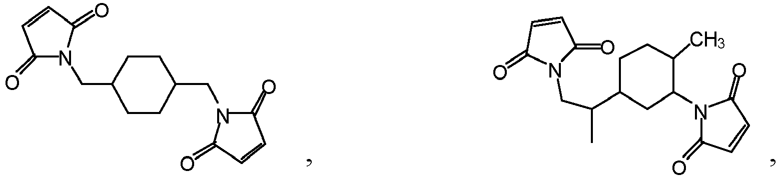 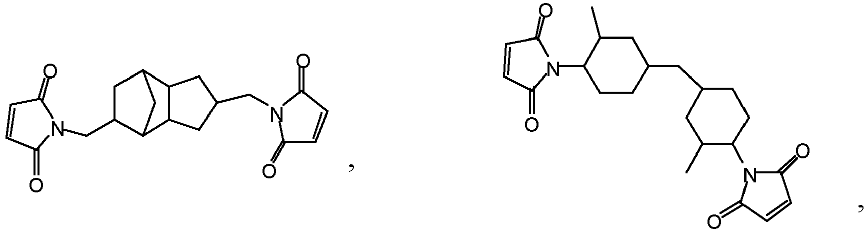 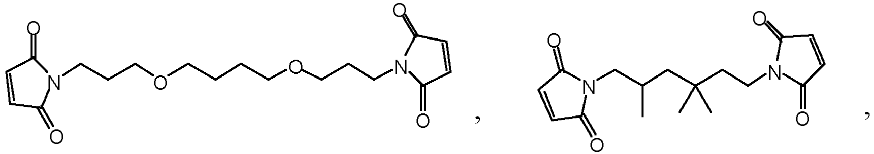 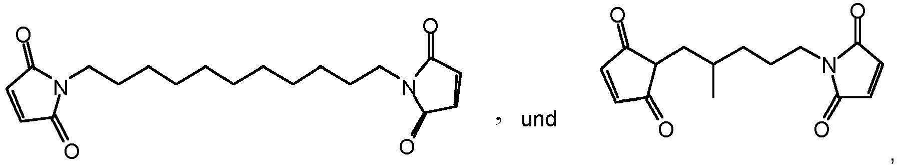 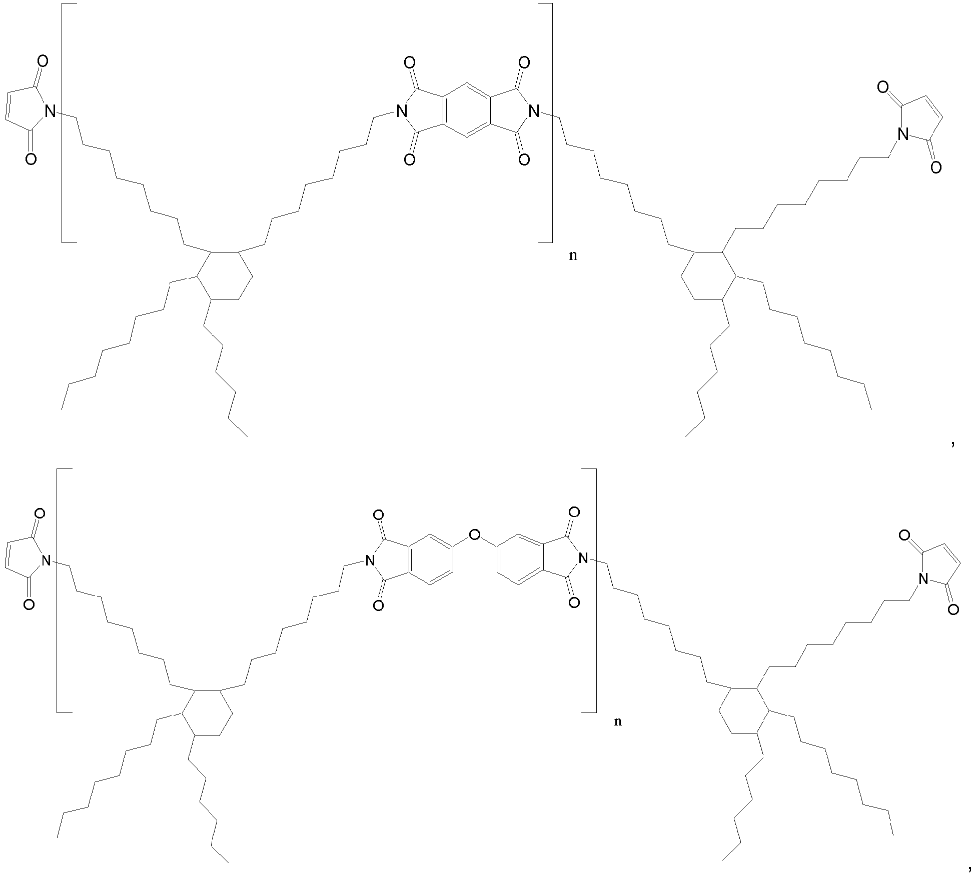 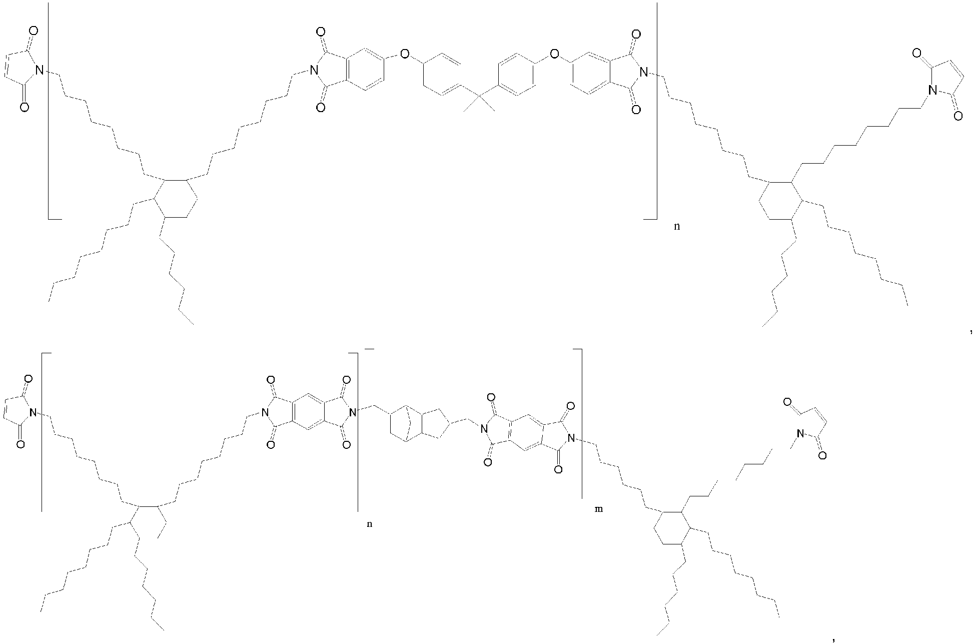 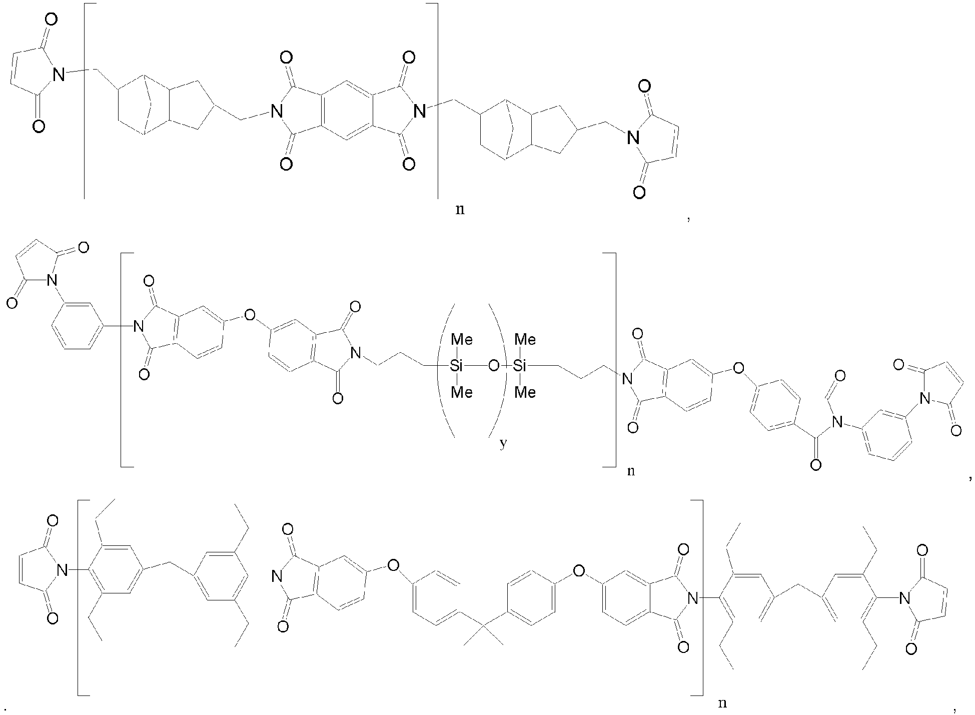 und

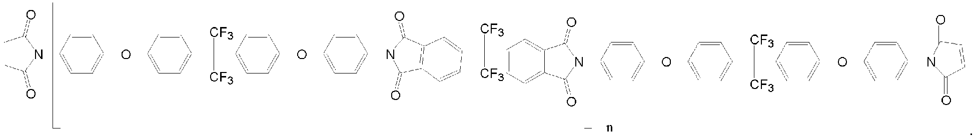

5. Härtbare Klebstoffzusammensetzung gemäß Anspruch 1, wobei das mindestens eine Maleimid ein maleimidterminiertes Polyimid ist, das eine Struktur gemäß der folgenden Formel aufweist: 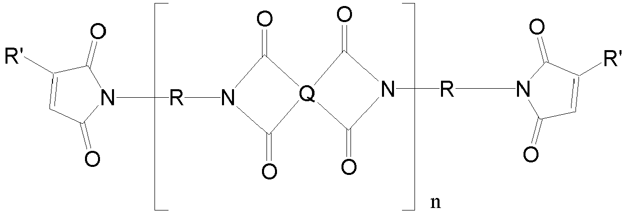 wobei:
R' H oder Methyl ist;
R und Q jeweils unabhängig substituierte oder nichtsubstituierte aliphatische, cycloaliphatische, aromatische, heteroaromatische, Polyether- oder Siloxanmolekülteile sind; und
n 1 bis 10 ist.

6. Härtbare Klebstoffzusammensetzung gemäß Anspruch 1, wobei der Epoxidbestandteil aus der Gruppe ausgewählt ist, die aus Folgendem besteht: einem Phenylglycidylether; einem Cresylglycidylether; einem Nonylphenylglycidylether; einem p-tert-Butylphenylglycidylether; einem Diglycidyl- oder Polyglycidylether von einem von Folgenden:
Bisphenol A, Bisphenol F, Ethylidenbisphenol, Dihydroxydiphenylether, Bis(4-hydroxyphenyl)sulfon, Bis(hydroxyphenyl)sulfid, 1,1-Bis(hydroxyphenyl)cyclohexan, 9,19-Bis(4-hydroxyphenyl)fluoren, 1,1,1-Tris(hydroxyphenyl)ethan, Tetrakis(4-hydroxyphenyl)ethan, Trihydroxytritylmethan, 4,4'-(1-alpha-Methylbenzyliden)bisphenol, 4,4'-Dihydroxybenzophenon, Dihydroxynaphthalen, 2,2'-Dihydroxy-6,6'-dinaphthyldisulfid, einem 1,8,9-Trihydroxyanthracen, Resorcin, Catechin und Tetrahydroxydiphenylsulfid;
Triglycidyl-p-aminophenol; N,N,N',N'-Tetraglycidyl-4,4'-diphenylmethan; Triglycidylisocyanurat; einem Glycidylether von einem Cresolformaldehydkondensat; einem Glycidylether von einem Phenolformaldehydkondensat; einem Glycidylether von einer Cresoldicyclopentadienadditionsverbindung; einem Glycidylether von einer Phenoldicyclopentadienadditionsverbindung; einem Diglycidylether von 1,4-Butandiol; einem Diglycidylether von Diethylenglycol; einem Diglycidylether von Neopentylglycol; einem Diglycidylether von Cyclohexandimethanol; einem Diglycidylether von Tricyclodecandimethanol; einem Trimethyolethantriglycidylether; einem Trimethyolpropantriglycidylether; einem Glycidylether von einem Polyglycol; einem Polyglycidylether von Castoröl; einem Polyoxypropylendiglycidylether; einem Glycidylderivat von einem aromatischen Amin; einem N,N-Diglycidyl-4-glycidyloxyanilin; einem epoxidterminierten Polydimethylsiloxan; und einem epoxidfunktionalisierten Cyclosiloxan.

7. Härtbare Klebstoffzusammensetzung gemäß Anspruch 1, wobei der Epoxidbestandteil 1 bis 90 Gew.-%, bezogen auf das Gesamtgewicht der Harzzusammensetzung, ausmacht.

8. Härtbare Klebstoffzusammensetzung gemäß Anspruch 1, wobei der mindestens eine anionische Härtungskatalysator aus der Gruppe ausgewählt ist, die aus Folgendem besteht: Imidazol; 1-Benzyl-2-phenylimidazol (1B2PZ); 1-Benzyl-2-methylimidazol (1B2MZ); 2-Phenyl-4-methylimidazol (2P4MZ); 2-Phenylimidazol (2PZ); 2-Ethyl-4-methylimidazol (2E4MZ); 1,2-Dimethylimidazol (1.2DMZ); 2-Heptadecylimidazol (C17Z); 2-Undecylimidazol (C11Z); 2-Methylimidazol (2MZ); Imidazol (SIZ); 1-Cyanethyl-2-methylimidazol (2MZ-CN); 1-Cyanethyl-2-undecylimidazol (C11Z-CN); 1-Cyanethyl-2-ethyl-4-methylimidazol (2E4MZ-CN); 1-Cyanethyl-2-phenylimidazol (2PZ-CN); 1-Cyanethyl-2-phenylimidazoliumtrimellitat (2PZCNS-PW); 1-Cyanethyl-2-undecylimidazoliumtrimellitat (C11Z-CNS); 2,4-Diamino-6-[2'-ethyl-4'-methylimidazolyl-(1')]-ethyl-s-triazin (2E4MZ-A); 2,4-Diamino-6-[2'-undecylimidazolyl-(1')]-ethyl-s-triazin (C11Z-A); 2,4-Diamino-6-[2'-methylimidazolyl-(1')]-ethyl-s-triazin (2MZA-PW); 2,4-Diamino-6-[2'-methylimidazolyl-(1')]-ethyl-s-triazin (2MZ-A); 2-Phenylimidazolisocyanursäureaddukt (2PZ-OK); 2,4-Diamino-6-[2'-methylimidazolyl-(1')]-ethyl-s-triazinisocyanursäureadduktdehydrat (2MA-OK); 2-Phenyl-4-methyl-5-hydroxymethylimidazol (2P4MHZ-PW); 2-Phenyl-4,5-dihydroxymethylimidazol (2PHZ-PW); 1-Dodecyl-2-methyl-3-benzylimidazoliumchlorid (SFZ); 2,3-Dihydro-1H-pyrrol[1,2-a]benzimidazol (TBZ); 2-Phenylimidazolin (2PZL-T); 2,4-Diamino-6-methacryloyloxyethyl-1,3,5-triazin (MAVT); 2,4-Diamino-6-vinyl-1,3,5-triazinisocyanursäureaddukt (OK); 2,4-Diamino-6-vinyl-1,3,5-triazin (VT); Imidazol-4-carboxaldehyd (4FZ); 2-Phenylimidazol-4-carboxaldehyd (2P4FZ); Imidazol-2 carboxaldehyd (2FZ); Imidazol-4-carbonitril (4CNZ); 2-Phenylimidazol-4-carbonitril (2P4CNZ); 4-Hydroxymethylimidazolhydrochlorid (4HZ-HCL); 2-Hydroxymethylimidazolhydrochlorid (2HZ-HCL); Imidazol-4-carbonsäure (4GZ); Imidazol-4-dithiocarbonsäure (4SZ); Imidazol-4-thiocarboxamid (4TZ); 2-Bromimidazol (2BZ); 2-Mercaptoimidazol (2SHZ); 1,2,4-Triazol-1-carboxamidinhydrochlorid (TZA); (t-Butoxycarbonylimino-[1,2,4]triazol-1-yl-methyl)-carbamidsäure-t-butylester (TZA-BOC); Thiazol-2-carboxaldehyd (2FTZ); Thiazol-4-carboxaldehyd (4FTZ); Thiazol-5-carboxaldehyd (5FTZ); Oxazol-2-carboxaldehyd (2FOZ); Oxazol-4-carboxaldehyd (4FOZ); Oxazol-5-carboxaldehyd (5FOZ); Pyrazol-4-carboxaldehyd (4FPZ); Pyrazol-3-carboxaldehyd (3FPZ); 1-Azabicyclo[2.2.2]octan (ABCO); 1,4-Diazabicyclo[2.2.2]octan (DABCO); 1,5-Diazabicyclo[4.3.0]non-5-en (DBN); 1,8-Diazabicyclo[5.4.0]undec-7-en (DBU); 1,5,7-Triazabicyclo[4.4.0]dec-5-en (TBD); 7-Methyl-1,5,7-triazabicyclo[4.4.0]dec-5-en (MTBD); 1,2,2,6,6-Pentamethylpiperidin (PMP); und 4-(Dimethylamino)-1,2,2,6,6-pentamethylpiperidin.

9. Härtbare Klebstoffzusammensetzung gemäß Anspruch 1, wobei der mindestens eine anionische Härtungskatalysator 0,1 bis 10 Gew.-%, bezogen auf das Gesamtgewicht der Harzzusammensetzung, ausmacht.

10. Härtbare Klebstoffzusammensetzung gemäß Anspruch 2, wobei der mindestens eine Reaktivverdünner aus der Gruppe ausgewählt ist, die aus Acrylaten, Methacrylaten, Styrenen, Isopropenylbenzenderivaten, Acrylamiden, Methacrylamiden, Maleaten, Cinnamaten, Vinylpyridin; Aldehyden; Episulfiden, Cyclosiloxanen, Oxetanen, Lactonen, Acrylnitril, Cyanacrylaten, Vinylketonen, Acrolein, Vinylsulfonen, Vinylsulfoxiden, Vinylsilanen, Glycidol und Isocyanaten besteht.

11. Härtbare Klebstoffzusammensetzung gemäß Anspruch 2, wobei der mindestens eine Reaktivverdünner 0 bis 30 Gew.-%, bezogen auf das Gesamtgewicht der härtbaren Klebstoffzusammensetzung, ausmacht.

12. Härtbare Klebstoffzusammensetzung gemäß Anspruch 2, wobei der mindestens eine Füllstoff aus der Gruppe ausgewählt ist, die aus Siliciumdioxid, Perfluorkohlenstoffen, Mika, Kohlenstoff, Silber, Silberlegierungen, Kupferlegierungen, Metalllegierungen, Bornitrid, polyedrischen oligomeren Silsesquioxanen, Calciumcarbonat besteht, oder eine härtbare Klebstoffzusammensetzung gemäß Anspruch 2, wobei die Zusammensetzung ein elektrisch isolierender Klebstoff ist, der einen Isolierfüllstoff beinhaltet, der aus der Gruppe ausgewählt ist, die aus Polysiloxanen, pyrogenem Siliciumdioxid, pyrogenem Aluminiumoxid, pyrogenem Titandioxid, Calciumcarbonat, Polyperfluorkohlenstoffen, Siliciumdioxid, Graphit, Bornitrid und Polytetrafluorethylen besteht, wobei die härtbare Klebstoffzusammensetzung zum Aneinanderbinden von Kupferfolie geeignet ist, um ein flexibles kupferplattiertes Laminat mit niedriger Dielektrizitätszahl zu bilden, und wobei eine gehärtete Aliquote der Zusammensetzung eine Dielektrizitätskonstante von unter etwa 3,9, eine T_{g} von mindestens etwa 150 °C und einen WAK von weniger als etwa 60 ppm/°C aufweist.

13. Härtbare Klebstoffzusammensetzung gemäß Anspruch 2, wobei der mindestens eine Füllstoff etwa 0 bis 90 Gew.-%, bezogen auf das Gesamtgewicht der Zusammensetzung, ausmacht.

14. Ein Verfahren zum Erhöhen der Klebkraft einer maleimidhaltigen Zusammensetzung, das Folgendes beinhaltet:
(a) Zugeben eines Epoxids zu der maleimidhaltigen Zusammensetzung gemäß Anspruch 1;
(b) Ersetzen von Radikalinitiatoren in der Zusammensetzung durch mindestens einen anionischen Härtungskatalysator, wodurch die Klebkraft einer maleimidhaltigen Zusammensetzung erhöht wird.

15. Härtbare Klebstoffzusammensetzung gemäß Anspruch 1,
wobei der Maleimidbestandteil ein Bismaleimidbestandteil ist und das mindestens eine Maleimid ein Bismaleimid ist, die härtbare Klebstoffzusammensetzung eine elektrisch leitfähige Chipmontageklebstoffzusammensetzung ist
wobei die härtbare Klebstoffzusammensetzung ferner Folgendes beinhaltet:
(d) mindestens einen Acrylatreaktivverdünner;
(e) einen Silberfüllstoff; und
(f) mindestens einen Silanhaftvermittler, wobei die härtbare Klebstoffzusammensetzung eine elektrisch leitfähige Chipmontageklebstoffzusammensetzung ist.

16. Härtbare Klebstoffzusammensetzung gemäß Anspruch 15, wobei der Acrylatreaktivverdünner Tricyclodecandimethanoldiacrylat ist.

17. Härtbare Klebstoffzusammensetzung gemäß Anspruch 15, wobei die Silanhaftvermittler aus der Gruppe ausgewählt sind, die aus Aminopropyltrimethoxysilan, Acryloxypropyltrimethoxysilan, Methacryloxypropyltrimethoxysilan, Glycidoxypropyltrimethoxysilan, (3,4-Epoxycyclohexyl)ethyltrimethoxysilan und N-Phenylaminpropyltrimethoxysilan besteht.

## Revendications

1. Une composition adhésive durcissable, comprenant :
(a) un composant maléimide comprenant au moins un maléimide qui est un polyimide à terminaisons maléimide qui est le produit de condensation de la mise en contact d'une diamine avec un dianhydride ;
(b) un composant époxy comprenant au moins une époxy ; et
(c) au moins un catalyseur de durcissement anionique,
à la condition qu'aucun initiateur de radicaux libres ne soit ajouté à la composition.

2. La composition adhésive durcissable selon la revendication 1, comprenant en outre au moins une charge, au moins un diluant réactif, ou une combinaison de ceux-ci.

3. La composition adhésive durcissable selon la revendication 1, dans laquelle le composant maléimide comprend un bismaléimide de dimère diamine saturée ou insaturée.

4. La composition adhésive durcissable de la revendication 1, dans laquelle le composant maléimide est un composé ayant une structure sélectionnée dans le groupe constitué de : 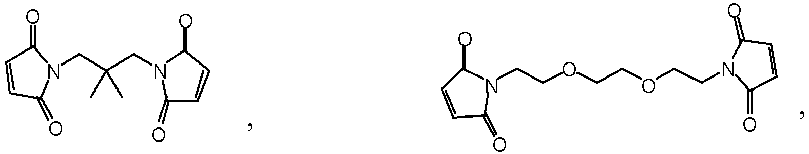 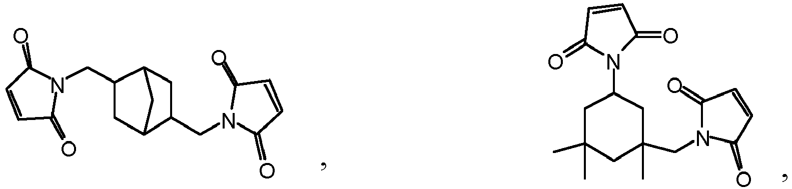 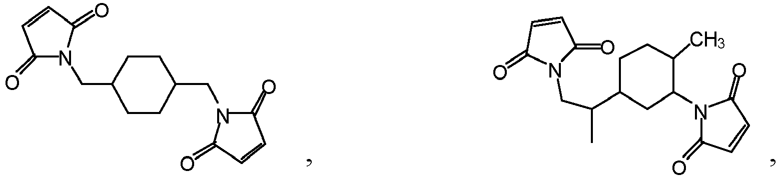 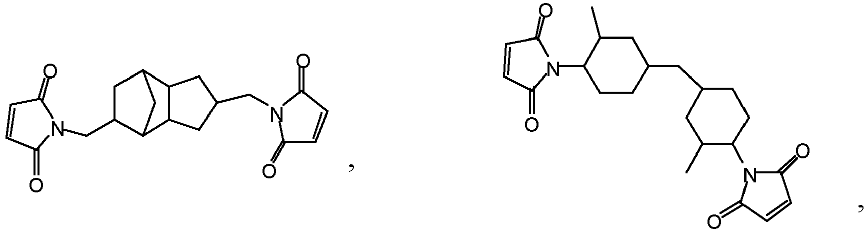 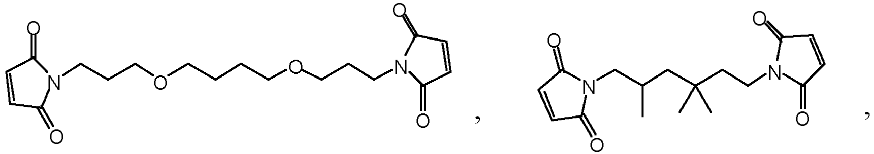 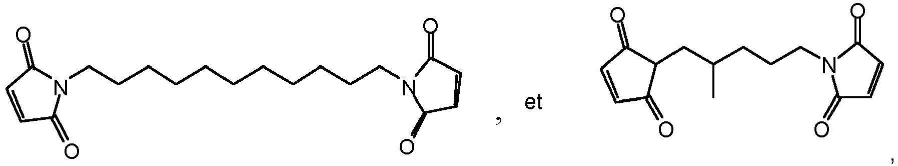 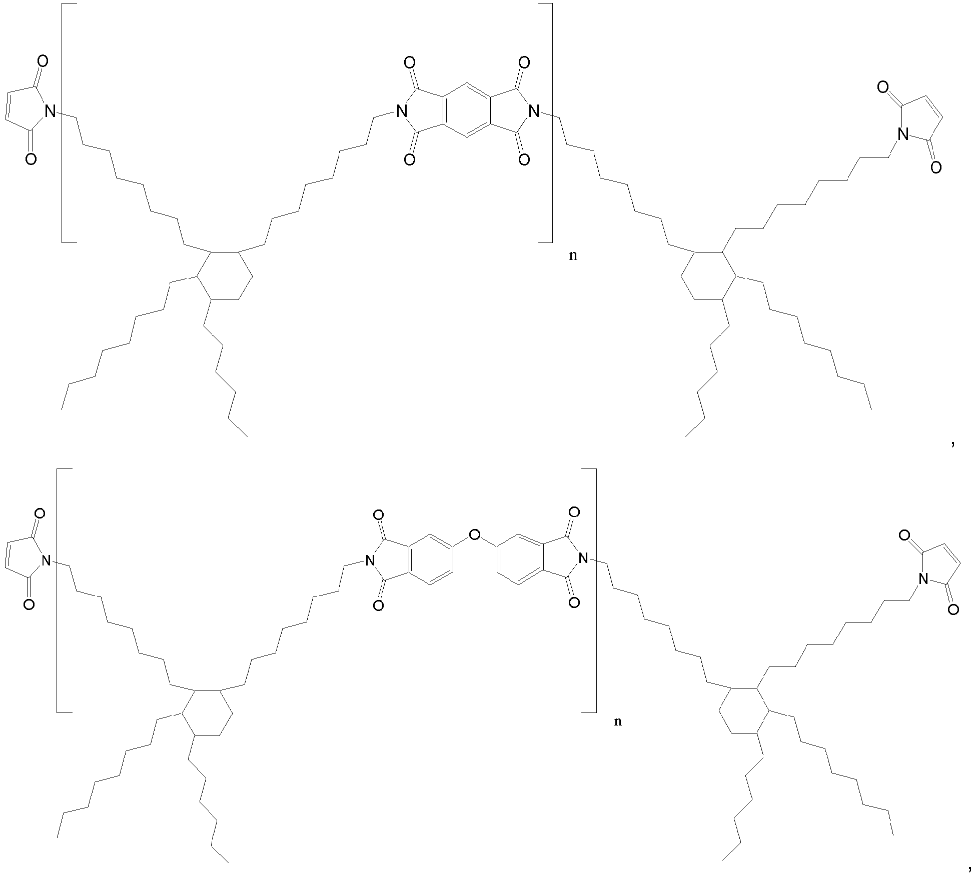 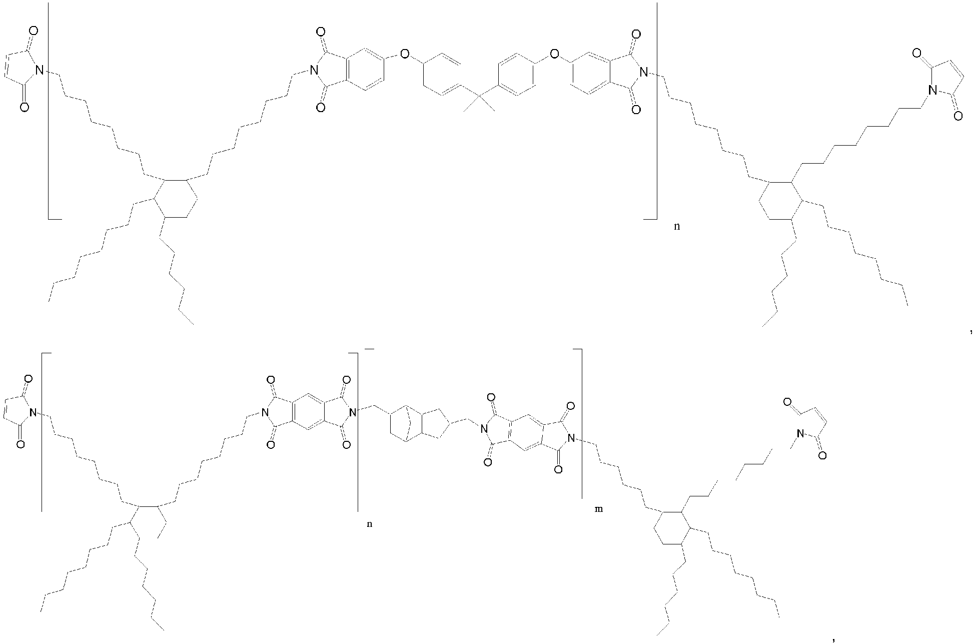 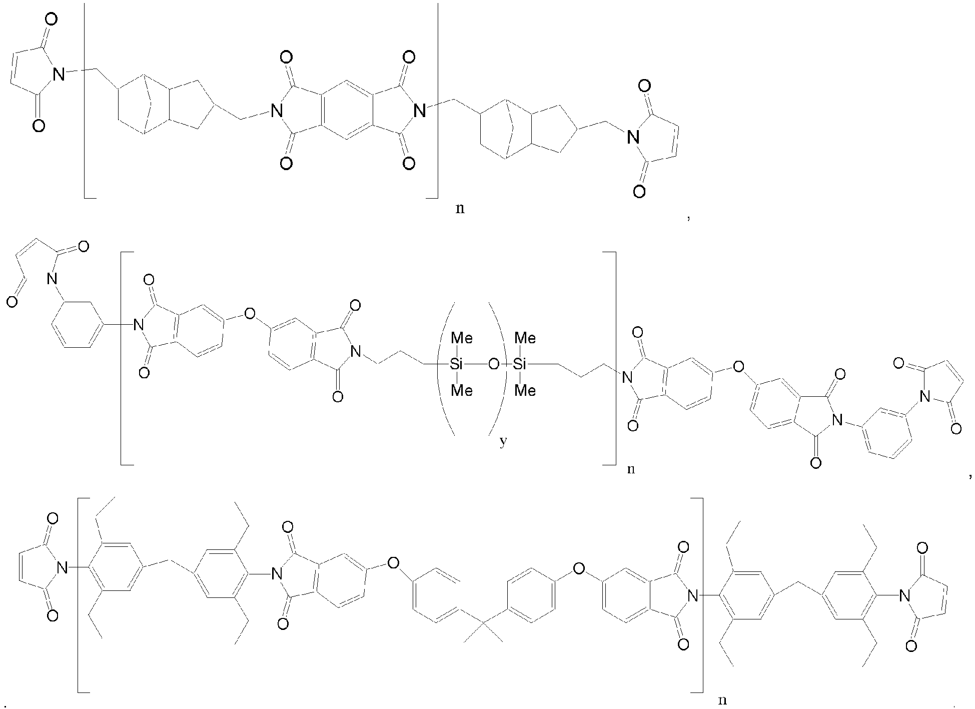 , et

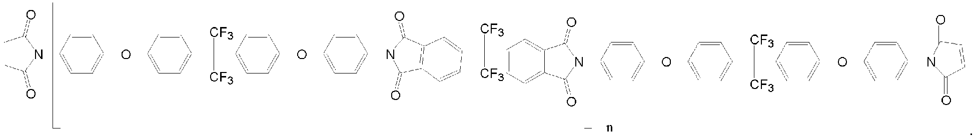

5. La composition adhésive durcissable selon la revendication 1, dans laquelle l'au moins un maléimide est un polyimide à terminaisons maléimide ayant une structure selon la formule : 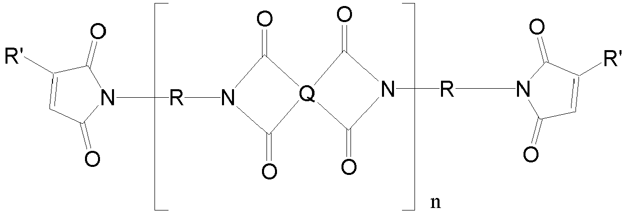 dans laquelle :
R' est H ou le méthyle ;
R et Q sont chacun indépendamment des groupements aliphatiques, cycloaliphatiques, aromatiques, hétéroaromatiques, polyéther, ou siloxane substitués ou non substitués ; et
n vaut de 1 à 10.

6. La composition adhésive durcissable selon la revendication 1, dans laquelle le composant époxy est sélectionné dans le groupe constitué : d'un éther phényl glycidylique ; d'un éther crésyl glycidylique ; d'un éther nonylphényl glycidylique ; d'un éther p-tert-butylphényl glycidylique ; d'un éther diglycidylique ou polyglycidylique de n'importe quels éléments parmi :
le bisphénol A, le bisphénol F, l'éthylidènebisphénol, l'éther de dihydroxydiphényle, le bis(4-hydroxyphényl)sulfone, le bis(hydroxyphényl)sulfure, le 1,1-bis(hydroxyphényl)cyclohexane, le 9,19-bis(4-hydroxyphényl)fluorène, le 1,1,1-tris(hydroxyphényl)éthane, le tétrakis(4-hydroxyphényl)éthane, le trihydroxytritylméthane, le 4,4'-(1-alpha-méthylbenzylidène)bisphénol, le 4,4' dihydroxybenzophénone, le dihydroxy naphtalène, le 2,2'-dihydroxy-6,6'-dinaphthyl disulfure, un 1,8,9-trihydroxyanthracène, le résorcinol, le catéchol et le sulfure de tétrahydroxydiphényle ;
le triglycidyl-p-aminophénol ; le N,N,N',N'-tétraglycidyl-4,4'-diphénylméthane ; l'isocyanurate triglycidylique ; un éther glycidylique d'un condensat de crésol formaldéhyde ; un éther glycidylique d'un condensat de phénol formaldéhyde ; un éther glycidylique d'un composé d'ajout de crésol dicyclopentadiène ; un éther glycidylique d'un composé d'ajout de phénol dicyclopentadiène ; un éther diglycidylique de 1,4 butanediol ; un éther diglycidylique de diéthylène glycol ; un éther diglycidylique de néopentyl glycol ; un éther diglycidylique de cyclohexane diméthanol ; un éther diglycidylique de tricyclodécane diméthanol ; un éther triméthyoléthane triglycidylique ; un éther triméthyol propane triglycidylique ; un éther glycidylique d'un polyglycol ; un éther polyglycidylique d'huile de ricin ; un éther polyoxypropylène diglycidylique ; un dérivé glycidylique d'une amine aromatique ; un N,N-diglycidyl-4-glycidyloxyaniline ; un polydiméthylsiloxane à terminaisons époxy ; et un cyclosiloxane époxy fonctionnalisé.

7. La composition adhésive durcissable selon la revendication 1, dans laquelle le composant époxy constitue 1 à 90 % en poids rapporté au poids total de la composition de résine.

8. La composition adhésive durcissable selon la revendication 1, dans laquelle l'au moins un catalyseur de durcissement anionique est sélectionné dans le groupe constitué : d'imidazole ; de 1-benzyl-2-phénylimidazole (1B2PZ) ; de 1-benzyl-2-méthylimidazole (1B2MZ) ; de 2-phényl-4-méthylimidazole (2P4MZ) ; de 2-phénylimidazole (2PZ) ; de 2-éthyl-4-méthylimidazole (2E4MZ) ; de 1,2-diméthylimidazole (1.2DMZ) ; de 2-heptadécylimidazole (C17Z) ; de 2-undécylimidazole (C11Z) ; de 2-méthylimidazole (2MZ) ; d'imidazole (SIZ) ; de 1-cyanoéthyl-2-méthylimidazole (2MZ-CN) ; de 1-cyanoéthyl-2-undécylimidazole (C11Z-CN) ; de 1-cyanoéthyl-2-éthyl-4-méthylimidazole (2E4MZ-CN) ; de 1-cyanoéthyl-2-phénylimidazole (2PZ-CN) ; de 1-cyanoéthyl-2-phénylimidazolium-triméllitate (2PZCNS-PW) ; de 1-cyanoéthyl-2-undécylimidazolium-triméllitate (C11Z-CNS) ; de 2,4-diamino-6-[2'-éthyl-4'-méthylimidazolyl-(1')]-éthyl-s-triazine (2E4MZ-A) ; de 2,4-diamino-6-[2'-undécylimidazolyl-(1')]-éthyl-s-triazine (C11Z-A) ; de 2,4-diamino-6-[2'-méthylimidazolyl-(1')]-éthyl-s-triazine (2MZA-PW) ; de 2,4-diamino-6-[2'-méthylimidazolyl-(1')]-éthyl-s-triazine (2MZ-A) ; d'adduit d'acide 2-phénylimidazoleisocyanurique (2PZ-OK) ; de déhydrate d'adduit d'acide 2,4-diamino-6-[2'-méthylimidazolyl-(1')]-éthyl-s-triazineisocyanurique (2MA-OK) ; de 2-phényl-4-méthyl-5-hydroxyméthylimidazole (2P4MHZ-PW) ; de 2-phényl-4,5-dihydroxyméthylimidazole (2PHZ-PW) ; de chlorure de 1-dodécyl-2-méthyl-3-benzylimidazolium (SFZ) ; de 2,3-dihydro-1H-pyrrolo[1,2-a]benzimidazole (TBZ) ; de 2-phénylimidazoline (2PZL-T) ; de 2,4-diamino-6-méthacryloyloxyéthyl-1,3,5-triazine (MAVT) ; d'adduit d'acide 2,4-diamino-6-vinyl-1,3,5-triazineisocyanurique (OK) ; de 2,4-diamino-6-vinyl-1,3,5-triazine (VT) ; d'lmidazole-4-carboxaldéhyde (4FZ) ; de 2-Phénylimidazole-4-carboxaldéhyde (2P4FZ) ; d'lmidazole-2 carboxaldéhyde (2FZ) ; d'lmidazole-4-carbonitrile (4CNZ) ; de 2-Phénylimidazole-4-carbonitrile (2P4CNZ) ; d'hydrochlorure de 4-Hydroxyméthylimidazole (4HZ-HCL) ; d'hydrochlorure de 2-Hydroxyméthylimidazole (2HZ-HCL) ; d'acide Imidazole-4-carboxylique (4GZ) ; d'acide Imidazole-4-dithiocarboxylique (4SZ) ; d'Imidazole-4-thiocarboxamide (4TZ) ; de 2-Bromoimidazole (2BZ) ; de 2-Mercaptoimidazole (2SHZ) ; d'hydrochlorure de 1,2,4-Triazole-1-carboxamidine (TZA) ; d'ester t-butyle d'acide (t-Butoxycarbonylimino-[1,2,4]triazol-1-yl-Méthyl)-carbamique (TZA-BOC) ; de Thiazole-2-carboxaldéhyde (2FTZ) ; de Thiazole-4-carboxaldéhyde (4FTZ) ; de Thiazole-5-carboxaldéhyde (5FTZ) ; d'Oxazole-2-carboxaldéhyde (2FOZ) ; d'Oxazole-4-carboxaldéhyde (4FOZ) ; d'Oxazole-5-carboxaldéhyde (5FOZ) ; de Pyrazole-4-carboxaldéhyde (4FPZ) ; de Pyrazole-3-carboxaldéhyde (3FPZ) ; de 1-azabicyclo[2.2.2]octane (ABCO) ; de 1,4-diazabicyclo[2.2.2]octane (DABCO) ; de 1,5-diazabicyclo[4.3.0]non-5-ène (DBN) ; de 1,8-diazabicyclo[5.4.0]undec-7-ène (DBU) ; de 1,5,7 triazabicyclo[4.4.0]dec-5-ène (TBD) ; de 7 méthyl-1,5,7-triazabicyclo[4.4.0]dec-5-ène (MTBD) ; de 1,2,2,6,6-pentaméthylpipéridine (PMP) ; et de 4-(diméthylamino)-1,2,2,6,6-pentaméthylpipéridine.

9. La composition adhésive durcissable selon la revendication 1, dans laquelle l'au moins un catalyseur de durcissement anionique constitue 0,1 à 10 % en poids rapporté au poids total de la composition de résine.

10. La composition adhésive durcissable selon la revendication 2, dans laquelle l'au moins un diluant réactif est sélectionné dans le groupe constitué d'acrylates, de méthacrylate, de styréniques, de dérivés d'isopropénylbenzène, d'acrylamides, de méthacrylamides, de maléates, de cinnamates, de pyridine vinylique ; d'aldéhydes ; d'épisulfures, de cyclosiloxanes, d'oxétanes, lactones, d'acrylonitrile, de cyanoacrylates, de cétones vinyliques, d'acroléine, de sulfones vinyliques, de sulfoxydes vinyliques, de silanes vinyliques, de glycidol, et d'isocyanates.

11. La composition adhésive durcissable selon la revendication 2, dans laquelle l'au moins un diluant réactif constitue 0 à 30 % en poids rapporté au poids total de la composition adhésive durcissable.

12. La composition adhésive durcissable selon la revendication 2, dans laquelle l'au moins une charge est sélectionnée dans le groupe constitué de silice, de perfluorocarbones, de mica, de carbone, d'argent, d'alliages d'argent, d'alliages de cuivre, d'alliages métalliques, de nitrure de bore, de silsesquioxanes oligomériques polyédriques, de carbonate de calcium, ou
une composition adhésive durcissable de la revendication 2, la composition étant un adhésif électriquement isolant comprenant une charge isolante sélectionnée dans le groupe constitué de polysiloxanes, de silice pyrogénée, d'alumine pyrogénée, de dioxyde de titane pyrogéné, de carbonate de calcium, de poly perfluorocarbones, de silice, de graphite, de nitrure de bore, et de polytétrafluoroéthylène où la composition adhésive durcissable convient pour lier une feuille de cuivre ensemble afin de former un stratifié recouvert de cuivre souple diélectrique bas et dans laquelle une aliquote durcie de la composition a une constante diélectrique en dessous d'environ 3,9, une T_{g} d'au moins environ 150 °C, et un CTE inférieur à environ 60 ppm/°C.

13. La composition adhésive durcissable selon la revendication 2, dans laquelle l'au moins une charge constitue environ 0 à 90 % en poids rapporté au poids total de la composition.

14. Un procédé pour augmenter l'adhérence d'une composition contenant du maléimide comprenant :
(a) l'ajout d'un époxy à la composition contenant du maléimide de la revendication 1 ;
(b) le remplacement de n'importe quels initiateurs de radicaux libres dans la composition par au moins un catalyseur de durcissement anionique, augmentant de ce fait l'adhérence d'une composition contenant du maléimide.

15. Une composition adhésive durcissable selon la revendication 1,
dans laquelle le composant maléimide est un composant bismaléimide et l'au moins un maléimide est un bismaléimide, la composition adhésive durcissable est une composition adhésive de fixation de puce électroconductrice
la composition adhésive durcissable comprenant en outre :
(d) au moins un diluant réactif acrylique ;
(e) une charge d'argent ; et
(f) au moins un agent de couplage silane, dans laquelle la composition adhésive durcissable est une composition adhésive de fixation de puce électroconductrice.

16. La composition adhésive durcissable de la revendication 15, dans laquelle le diluant réactif acrylique est le tricyclododécane diméthanol diacrylate.

17. La composition adhésive durcissable de la revendication 15, dans laquelle les agents de couplage silane sont sélectionnés dans le groupe constitué d'aminopropyltriméthoxysilane, d'acryloxypropyltriméthoxysilane, de méthacryloxypropyltriméthoxysilane, de glycidoxypropyltriméthoxysilane, de (3,4-époxycyclohéxyl)éthyltriméthoxysilane, et de N-phénylaminopropyltriméthoxysilane.
